(19) Europäisches Patentamt
European Patent Office
Office européen des brevets

(11) EP 3 846 239 B1

(12) # EUROPEAN PATENT SPECIFICATION

(45) Date of publication and mention of the grant of the patent:
**25.09.2024 Bulletin 2024/39**

(21) Application number: **20217423.1**

(22) Date of filing: **28.12.2020**

(51) International Patent Classification (IPC):
***H10K 85/60*** *(2023.01)*

(52) Cooperative Patent Classification (CPC):
**H10K 85/615; H10K 85/631; H10K 85/633; H10K 85/6572;** H10K 50/17; H10K 50/19; H10K 59/12

(54) **ORGANIC ELECTRIC ELEMENT, DISPLAY PANEL COMPRISING THE SAME AND DISPLAY DEVICE COMPRISING THE SAME**

ORGANISCHES ELEKTRISCHES ELEMENT, ANZEIGETAFEL DAMIT UND ANZEIGEVORRICHTUNG DAMIT

ÉLÉMENT ÉLECTRIQUE ORGANIQUE, PANNEAU D'AFFICHAGE LE COMPRENANT ET DISPOSITIF D'AFFICHAGE LE COMPRENANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.12.2019 KR 20190180005**

(43) Date of publication of application:
**07.07.2021 Bulletin 2021/27**

(73) Proprietors:
- **LG Display Co., Ltd.
SEOUL, 07336 (KR)**
- **LG CHEM, LTD.
Yeongdeungpo-gu,
Seoul 07336 (KR)**

(72) Inventors:
- **Shin, Jicheol
10845 Gyeonggi-do (KR)**
- **Yoo, Seonkeun
10845 Gyeonggi-do (KR)**
- **Seo, Jeongdae
10845 Gyeonggi-do (KR)**
- **Kim, Shinhan
10845 Gyeonggi-do (KR)**
- **Yoon, JooYong
10845 Gyeonggi-do (KR)**
- **Yun, Jun
10845 Gyeonggi-do (KR)**
- **Kim, DongHeon
10845 Gyeonggi-do (KR)**
- **Lee, YongHan
10845 Gyeonggi-do (KR)**
- **Lee, SungJae
10845 Gyeonggi-do (KR)**

(74) Representative: **Ter Meer Steinmeister & Partner
Patentanwälte mbB
Nymphenburger Straße 4
80335 München (DE)**

(56) References cited:
**EP-A1- 3 176 844** **EP-A1- 3 333 921**
**WO-A1-2018/221871** **US-A1- 2019 207 123**
**US-A1- 2020 144 552**

EP 3 846 239 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### CROSS REFERENCE TO RELATED APPLICATION

This application claims priority from Korean Patent Application No. 10-2019-0180005, filed on December 31, 2019.

### BACKGROUND

### Technical Field

Embodiments of the present invention relate to an organic electric element, a display panel and a display device including the organic electric element.

### Discussion of Related Art

In general, an organic light emitting phenomenon refers to the phenomenon of converting electrical energy into light energy by means of an organic material. An organic electric element refers to an electric element using the organic light emitting phenomenon.

An organic electric element using the organic light emitting phenomenon may be applied to a display device. Since the portable display device is driven by a battery, which is a limited power source, an organic electric element used in the portable display device requires excellent light emission efficiency. In addition, since the image should be displayed normally during use of the electronic device, a long lifetime of the organic electric element (also referred to as lifespan hereinafter) may be also required.

In order to improve efficiency, lifespan and driving voltage in the organic electric element, research has been conducted on the organic material included in the organic electric element.

Conventional organic electric elements including known combinations of organic materials are described in US 2019/207123 A1, WO 2018/221871 A1, EP 3 176 844 A1 and EP 3 333 921 A1.

US 2019/207123 A1 discloses an organic light emitting diode comprising at least two light emitting stacks interposed between a cathode and an anode and a charge generation layer (CGL) interposed between the stacks. The CGL comprises an n-type CGL and a p-type CGL. The n-type CGL comprises a compound having a 1,10-phenanthroline group. The p-type CGL comprises an indacene compound.

WO 2018/221871 A1 discloses an organic light emitting device of a two-stack type with a first n-type CGL and a first p-type CGL. The p-type CGL may comprise more than one compound, in particular an indacene compound and one or more tertiary amine compounds.

EP 3 176 844 A1 is directed to an organic light emitting display device which comprises at least one light emitting part between an anode and a cathode. The at least one light emitting part has at least one organic layer and a light emitting layer, wherein the at least one organic layer comprises an indacene compound. In one example, an organic light emitting display device with two light emitting parts and a CGL is prepared. In this exemplary device, the p-type CGL is formed of NPD which is doped with 10% of an indacene compound.

EP 3 333 921 A1 relates to a 1,10-phenanthroline compound. Additionally, it relates to a light emitting diode comprising the 1,10-phenanthroline compound in the n-type CGL.

### SUMMARY

Accordingly, the object of the present invention is to provide an organic electric element, a display panel, and a display device comprising the same that substantially obviates one or more of the problems due to limitations and disadvantages of the related art.

More specifically, a first object of the present invention is to provide an organic electric element having a high efficiency or a long lifetime.

A second object of the present invention is to provide a display panel comprising an organic electric element, wherein the display panel has a high efficiency or a long lifetime.

A third object of the present invention is to provide a display device comprising a display panel, wherein the device has a high efficiency or a long lifetime.

Additional features and aspects will be set forth in the description that follows, and in part will be apparent from the description, or may be learned by practice of the inventive concepts provided herein. Other features and aspects of the inventive concepts may be realized and attained by the structure particularly pointed out in the written description, or derivable therefrom, and the claims hereof as well as the appended drawings.

One or more of these objects are solved by the subject-matter of independent claim 1 and claims 12 and 13. For example, the present invention provides an organic electric element comprising a first electrode, a second electrode and an organic layer.

The organic layer is positioned between the first electrode and the second electrode.

The organic layer comprises a first stack comprising a first emitting layer, a second stack comprising a second emitting layer, and a charge generating layer positioned between the first stack and the second stack.

The charge generating layer comprises a first layer and a second layer.

The first layer comprises a first compound and a second compound.

The first compound is selected from one or more of chemical formula 1, one or more of chemical formula 2 or combinations of compounds represented by chemical formula 1 and compounds represented by chemical formula 2.

[chemical formula 1]

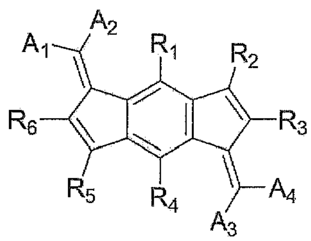

[chemical formula 2]

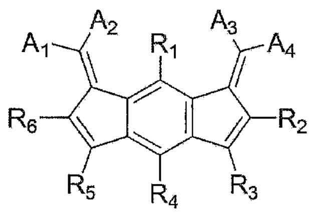

The second compound is represented by one or more of the chemical formula 9 and formula 10 (as described later). Chemical formula 9 and formula 10 are falling under the following generic chemical formula 3.

[chemical formula 3]

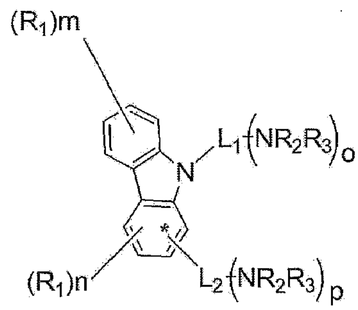

The second layer comprises a third compound which is one or more of the chemical compounds E01-E40. Chemical compounds E01-E40 are falling under the following generic chemical formula 4.

[chemical formula 4]

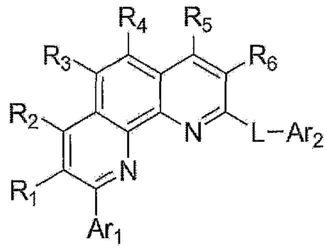

In chemical formula 1 and chemical formula 2, $R_1$ to $R_6$, which are same or different, are each independently one selected from the group consisting of a hydrogen; a deuterium; a tritium; a halogen; a cyano group; a nitro group; a $C_6$-$C_{60}$ aryl group; a fluorenyl group; a $C_2$-$C_{60}$ hetero ring group containing at least one hetero atom from O, N, S, Si and P; a fused ring group of a $C_3$-$C_{60}$ aliphatic ring and a $C_6$-$C_{60}$ aromatic ring; a $C_1$-$C_{50}$ alkyl group; a $C_2$-$C_{20}$ alkenyl group; a $C_2$-$C_{20}$ alkynyl group; a $C_1$-$C_{30}$ alkoxy group; a $C_6$-$C_{30}$ aryloxy group; a $C_3$-$C_{60}$ alkylsilyl group; a $C_{18}$-$C_{60}$ arylsilyl group; and a $C_8$-$C_{60}$ alkylarylsilyl group, and one or more of $R_1$ to $R_6$ is the cyano group, $A_1$ to $A_4$, which may be the same or different, are each independently one selected from the group consisting of a hydrogen; a deuterium; a tritium; a halogen; a cyano group; a nitro group; a $C_6$-$C_{60}$ aryl group; a fluorenyl group; a $C_2$-$C_{60}$ hetero ring group containing at least one hetero atom from O, N, S, Si and P; a fused ring group of a $C_3$-$C_{60}$ aliphatic ring and a $C_6$-$C_{60}$ aromatic ring; a $C_1$-$C_{50}$ alkyl group; a $C_2$-$C_{20}$ alkenyl group; a $C_2$-$C_{20}$ alkynyl group; a $C_1$-$C_{30}$ alkoxy group; a $C_6$-$C_{30}$ aryloxy group; a $C_3$-$C_{60}$ alkylsilyl group; a $C_{18}$-$C_{60}$ arylsilyl group; and a $C_8$-$C_{60}$ alkylarylsilyl group.

Moreover, in $R_1$ to $R_6$ and $A_1$ to $A_4$ of chemical formula 1 and chemical formula 2, the aryl group, the fluorenyl group, the hetero ring group, the fused ring group, the alkyl group, the alkenyl group, the alkynyl group, the alkoxy group, the aryloxy group, the alkylsilyl group, the arylsilyl group and the alkylarylsilyl group may each be further substituted with at least one substituent selected from the group consisting of a deuterium; a nitro group; a cyano group; a halogen; an amino group; a $C_1$-$C_{20}$ alkoxyl group; a $C_1$-$C_{20}$ alkyl group; a $C_2$ - $C_{20}$ alkenyl group; a $C_2$-$C_{20}$ alkynyl group; a $C_6$-$C_{20}$ aryl group; a $C_6$-$C_{20}$ aryl group substituted with the deuterium; a fluorenyl group; a $C_2$-$C_{20}$ hetero ring group; a $C_3$-$C_{60}$ alkylsilyl group; a $C_{18}$-$C_{60}$ arylsilyl group; and a $C_8$-$C_{60}$ alkylarylsilyl group.

In chemical formula 3, m is an integer from 0 to 4, n is an integer from 0 to 3, and o and p are each independently 0 or 1, wherein o + p is 1 or more, $R_1$ is each independently one selected from the group consisting of a deuterium; a tritium; a halogen; a cyano group; a nitro group; a $C_6$-$C_{60}$ aryl group; a fluorenyl group; a $C_2$-$C_{60}$ hetero ring group containing at least one hetero atom from O, N, S, Si and P; a fused ring group of a $C_3$-$C_{60}$ aliphatic ring and a $C_6$-$C_{60}$ aromatic ring; a $C_1$-$C_{50}$ alkyl group; a $C_2$-$C_{20}$ alkenyl group; a $C_2$-$C_{20}$ alkynyl group; a $C_1$-$C_{30}$ alkoxy group; a $C_6$-$C_{30}$ aryloxy group; a $C_3$-$C_{60}$ alkylsilyl group; a $C_{18}$-$C_{60}$ arylsilyl group; and a $C_8$-$C_{60}$ alkylarylsilyl group.

Furthermore, $R_2$ and $R_3$ in chemical formula 3 may be the same or different, are each independently one selected from the group consisting of a $C_6$-$C_{60}$ aryl group; a fluorenyl group; a $C_2$-$C_{60}$ hetero ring group containing at least one hetero atom from O, N, S, Si and P; a fused ring group of a $C_3$-$C_{60}$ aliphatic ring and a $C_6$-$C_{60}$ aromatic ring; a $C_1$-$C_{50}$ alkyl group.

$L_1$ in chemical formula 3 is, i) one selected from the group consisting of a $C_6$-$C_{60}$ arylene group; a fluorylene group; a $C_2$-$C_{60}$ divalent hetero ring group containing at least one heteroatom from O, N, S, Si and P; a divalent fused ring group of a $C_3$-$C_{60}$ aliphatic ring and a $C_6$-$C_{60}$ aromatic ring; a $C_1$-$C_{50}$ alkylene group; a $C_2$-$C_{20}$ alkenylene group; and a $C_2$-$C_{20}$ alkynylene group, when p is 1; ii) one selected from the group consisting of a $C_6$-$C_{60}$ aryl group; a fluorenyl group; a $C_2$-$C_{60}$ hetero ring group containing at least one hetero atom from O, N, S, Si and P; a fused ring group of a $C_3$-$C_{60}$ aliphatic ring and a $C_6$-$C_{60}$ aromatic ring, when p is 0.

$L_2$ in chemical formula 3 is i) one selected from the group consisting of a $C_6$-$C_{60}$ arylene group; a fluorylene group; a $C_2$-$C_{60}$ divalent hetero ring group containing at least one heteroatom from O, N, S, Si and P; a divalent fused ring group of a $C_3$-$C_{60}$ aliphatic ring and a $C_6$-$C_{60}$ aromatic ring; a $C_1$-$C_{50}$ alkylene group; a $C_2$-$C_{20}$ alkenylene group; and a $C_2$-$C_{20}$ alkynylene group, when p is 1; and ii) one selected from the group consisting of a hydrogen; a deuterium; a tritium; a halogen; a cyano group; a nitro group; a $C_6$-$C_{60}$ aryl group; a fluorenyl group; a $C_2$-$C_{60}$ hetero ring group containing at least one hetero atom from O, N, S, Si and P; a fused ring group of a $C_3$-$C_{60}$ aliphatic ring and a $C_6$-$C_{60}$ aromatic ring; a $C_1$-$C_{50}$ alkyl group; a $C_2$-$C_{20}$ alkenyl group; a $C_2$-$C_{20}$ alkynyl group; a $C_1$-$C_{30}$ alkoxy group; a $C_6$-$C_{30}$ aryloxy group; a $C_3$-$C_{60}$ alkylsilyl group; a $C_{18}$-$C_{60}$ arylsilyl group; and a $C_8$-$C_{60}$ alkylarylsilyl group, when p is 0.

In $R_1$ to $R_3$, $L_1$ and $L_2$ of chemical formula 3, the aryl group, the fluorenyl group, the hetero ring group, the fused ring group, the alkyl group, the alkenyl group, the alkynyl group, the alkoxy group, the aryloxy group, the alkylsilyl group, the arylsilyl group, the alkylarylsilyl group, the arylene group, the fluorylene group, the alkylene group, the alkenylene group and the alkynylene group may each be further substituted with at least one substituent selected from the group consisting of a deuterium; a nitro group; a cyano group; a halogen; an amino group; a $C_1$-$C_{20}$ alkoxyl group; a $C_1$-$C_{20}$

alkyl group; a $C_2$ - $C_{20}$ alkenyl group; a $C_2$-$C_{20}$ alkynyl group; a $C_6$-$C_{20}$ aryl group; a $C_6$-$C_{20}$ aryl group substituted with the deuterium; a fluorenyl group; a $C_2$-$C_{20}$ hetero ring group; a $C_3$-$C_{60}$ alkylsilyl group; a $C_{18}$-$C_{60}$ arylsilyl group; and a $C_8$-$C_{60}$ alkylarylsilyl group.

In chemical formula 4, $R_1$ to $R_6$ , which are same or different, are each independently one selected from the group consisting of a hydrogen; a deuterium; a tritium; a halogen; a cyano group; a nitro group; a $C_6$-$C_{60}$ aryl group; a fluorenyl group; a $C_2$-$C_{60}$ hetero ring group containing at least one hetero atom from O, N, S, Si and P; a fused ring group of a $C_3$-$C_{60}$ aliphatic ring and a $C_6$-$C_{60}$ aromatic ring; a $C_1$-$C_{50}$ alkyl group; a $C_2$-$C_{20}$ alkenyl group; a $C_2$-$C_{20}$ alkynyl group; a $C_1$-$C_{30}$ alkoxy group; a $C_6$-$C_{30}$ aryloxy group; a $C_3$-$C_{60}$ alkylsilyl group; a $C_{18}$-$C_{60}$ arylsilyl group; and a $C_8$-$C_{60}$ alkylarylsilyl group, and one or more of $R_1$ to $R_6$ is the cyano group.

$Ar_1$ and $Ar_2$ in chemical formula 4, which are same or different, are each independently one selected from the group consisting of a hydrogen; a deuterium; a tritium; a halogen; a cyano group; a nitro group; a $C_6$-$C_{60}$ aryl group; a fluorenyl group; a $C_2$-$C_{60}$ hetero ring group containing at least one hetero atom from O, N, S, Si and P; a fused ring group of a $C_3$-$C_{60}$ aliphatic ring and a $C_6$-$C_{60}$ aromatic ring; a $C_1$-$C_{50}$ alkyl group; a $C_2$-$C_{20}$ alkenyl group; a $C_2$-$C_{20}$ alkynyl group; a $C_1$-$C_{30}$ alkoxy group; a $C_6$-$C_{30}$ aryloxy group; a $C_3$-$C_{60}$ alkylsilyl group; a $C_{18}$-$C_{60}$ arylsilyl group; and a $C_8$-$C_{60}$ alkylarylsilyl group, and one or more of $R_1$ to $R_6$ is the cyano group.

L in chemical formula 4 is one selected from the group consisting of a $C_6$-$C_{60}$ arylene group; a fluorylene group; a $C_2$-$C_{60}$ divalent hetero ring group containing at least one heteroatom from O, N, S, Si and P; a divalent fused ring group of a $C_3$-$C_{60}$ aliphatic ring and a $C_6$-$C_{60}$ aromatic ring.

In $R_1$ to $R_6$, $Ar_1$, $Ar_2$ and L of chemical formula 4, the aryl group, the fluorenyl group, the hetero ring group, the fused ring group, the alkyl group, the alkenyl group, the alkynyl group, the alkoxy group, the aryloxy group, the alkylsilyl group, the arylsilyl group, the alkylarylsilyl group, the arylene group, the fluorylene group, and the divalent fused ring group may each be further substituted with at least one substituent selected from the group consisting of a deuterium; a nitro group; a cyano group; a halogen; an amino group; a $C_1$-$C_{20}$ alkoxyl group; a $C_1$-$C_{20}$ alkyl group; a $C_2$ - $C_{20}$ alkenyl group; a $C_2$-$C_{20}$ alkynyl group; a $C_6$-$C_{20}$ aryl group; a $C_6$-$C_{20}$ aryl group substituted with the deuterium; a fluorenyl group; a $C_2$-$C_{20}$ hetero ring group; a $C_3$-$C_{60}$ alkylsilyl group; a $C_{18}$-$C_{60}$ arylsilyl group; and a $C_8$-$C_{60}$ alkylarylsilyl group.

In a preferred embodiment, the first chemical compound is represented by one or more of the following chemical formula 5 and chemical formula 6:

[chemical formula 5]

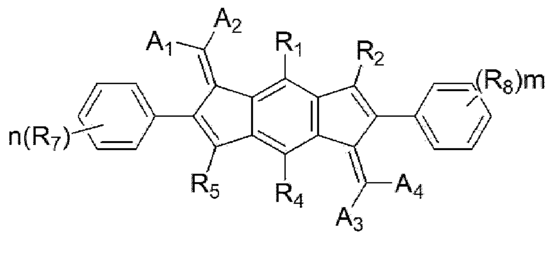

[chemical formula 6]

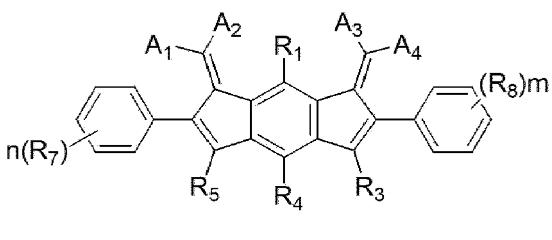

In chemical formula 5 and chemical formula 6, n and m are each independently an integer from 0 to 5, $R_7$ to $R_8$, which may be the same or different, are each independently one selected from the group consisting of a deuterium; a tritium; a halogen; a cyano group; a $C_1$-$C_{50}$ alkyl group; and a $C_1$-$C_{30}$ alkoxy group.

In $R_7$ and $R_8$ of chemical formula 5 and chemical formula 6, the alkyl group and the alkoxy group may each be further substituted with at least one substituent selected from the group consisting of a deuterium and a halogen.

In a further preferred embodiment, the first chemical compound is represented by one or more of the following chemical formula 7 and formula 8:

[chemical formula 7]

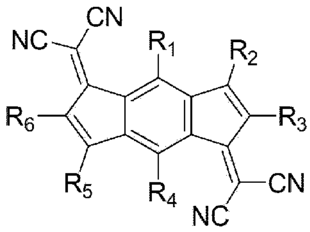

[chemical formula 8]

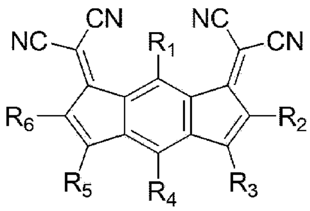

In chemical formula 7 and chemical formula 8, $R_1$ to $R_6$ are the same as $R_1$ to $R_6$ in chemical formulas 1 and 2.

In another embodiment, the first chemical compound is one or more of the following chemical compounds:

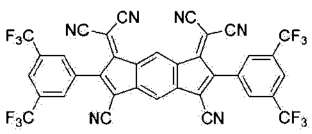

**A01**

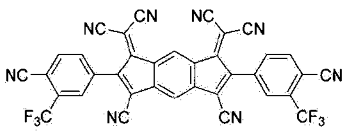

**A02**

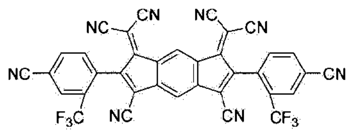

**A03**

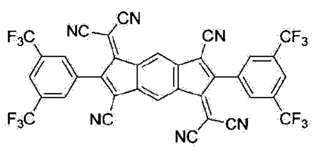

**A04**

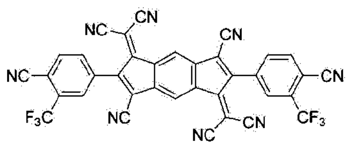

**A05**

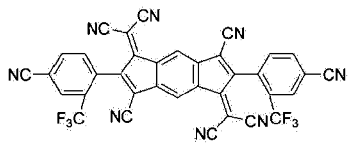

**A06**

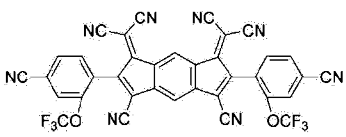

**A07**

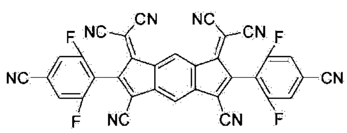

**A08**

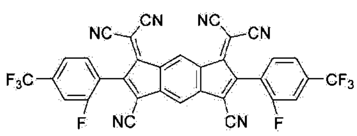

**A09**

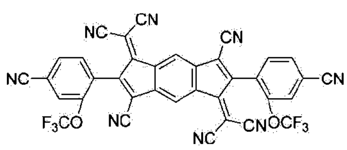

**A10**

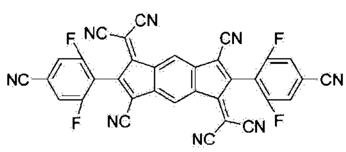

**A11**

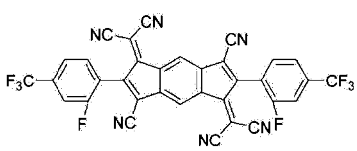

**A12**

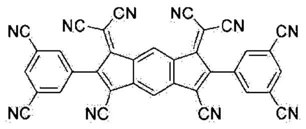

A13

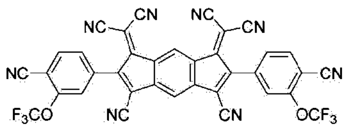

A14

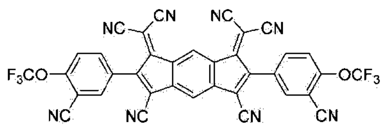

A15

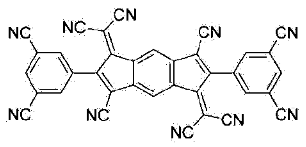

A16

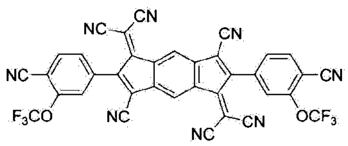

A17

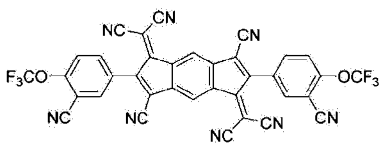

A18

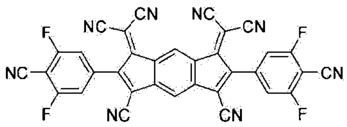

A19

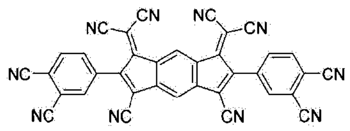

A20

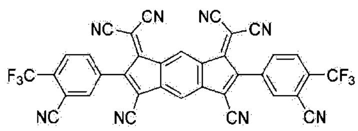

A21

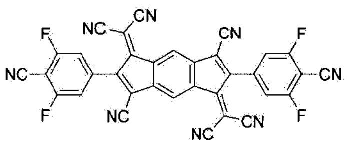

A22

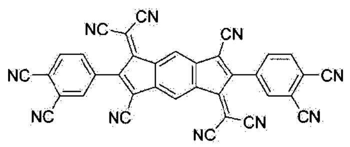

A23

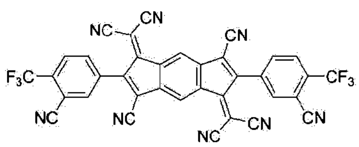

A24

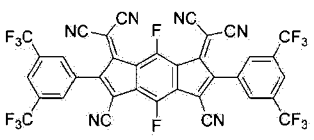

A25

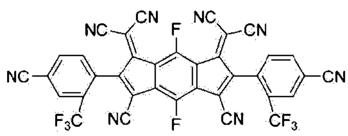

A26

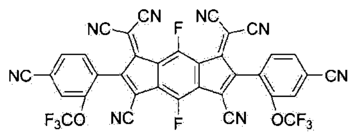

A27

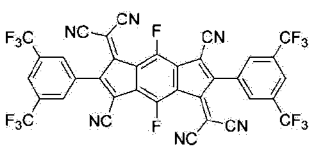

A28

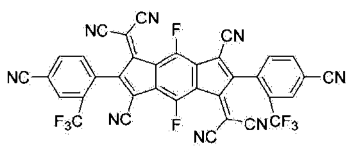

A29

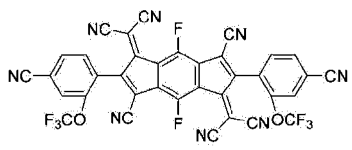

A30

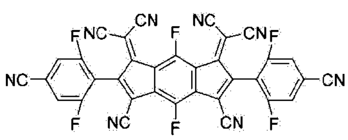

A31

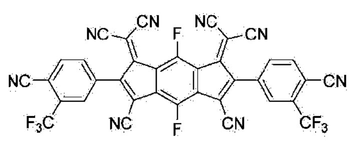

A32

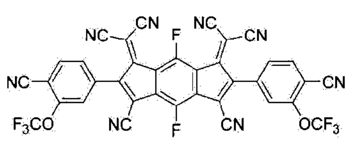

A33

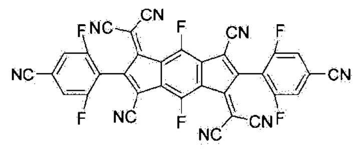

A34

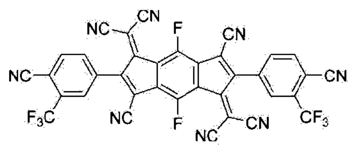

A35

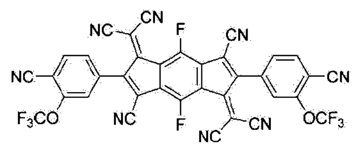

A36

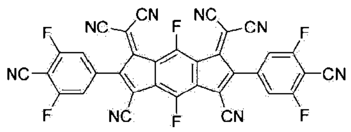

A37

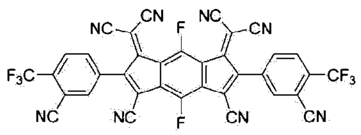

A38

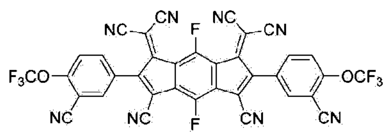

A39

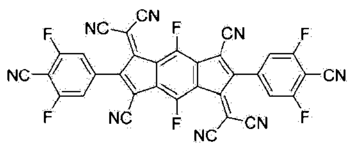

A40

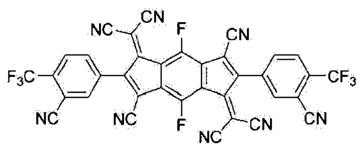

A41

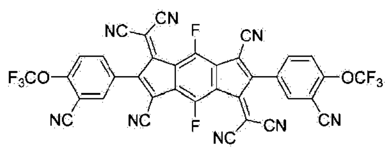

A42

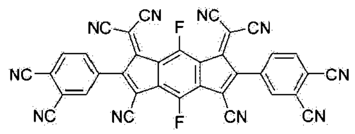

A43

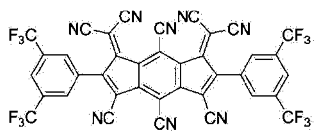

A44

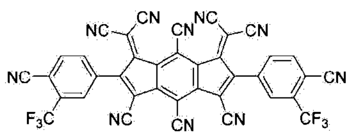

A45

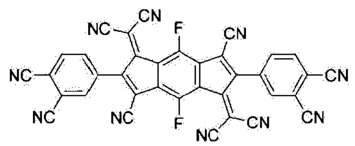

A46

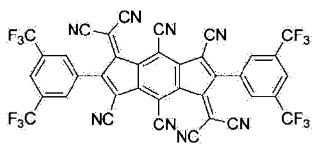

A47

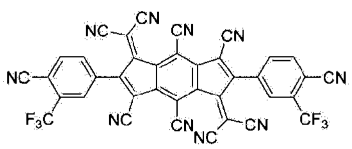

A48

The second chemical compound is represented by one or more of the following chemical formula 9 and formula 10:

[chemical formula 9]

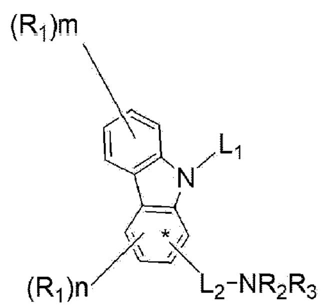

[chemical formula 10]

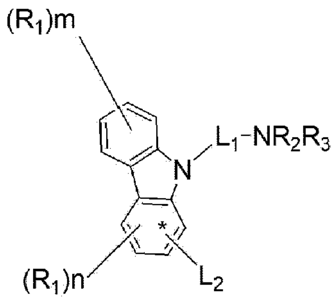

In chemical formula 9 and chemical formula 10, m, n and $R_1$ to $R_3$ are the same as m, n and $R_1$ in chemical formula 3.

$L_1$ in chemical formula 9 and chemical formula 10 is one selected from the group consisting of a $C_6$-$C_{60}$ aryl group; a fluorenyl group; a $C_2$-$C_{60}$ hetero ring group containing at least one hetero atom from O, N, S, Si and P; a fused ring group of a $C_3$-$C_{60}$ aliphatic ring and a $C_6$-$C_{60}$ aromatic ring.

$L_2$ chemical formula 9 and chemical formula 10 is one selected from the group consisting of a $C_6$-$C_{60}$ arylene group; a fluorylene group; a $C_2$-$C_{60}$ divalent hetero ring group containing at least one heteroatom from O, N, S, Si and P; a divalent fused ring group of a $C_3$-$C_{60}$ aliphatic ring and a $C_6$-$C_{60}$ aromatic ring; a $C_1$-$C_{50}$ alkylene group; a $C_2$-$C_{20}$ alkenylene group; and a $C_2$-$C_{20}$ alkynylene group.

Furthermore, in chemical formula 10, m, n and $R_1$ to $R_3$ are the same as m, n and $R_1$ in chemical formula 3, $L_1$ is one selected from the group consisting of a $C_6$-$C_{60}$ arylene group; a fluorylene group; a $C_2$-$C_{60}$ divalent hetero ring group containing at least one heteroatom from O, N, S, Si and P; a divalent fused ring group of a $C_3$-$C_{60}$ aliphatic ring and a $C_6$-$C_{60}$ aromatic ring; a $C_1$-$C_{50}$ alkylene group; a $C_2$-$C_{20}$ alkenylene group; and a $C_2$-$C_{20}$ alkynylene group, and $L_2$ is one selected from the group consisting of a $C_6$-$C_{60}$ aryl group; a fluorenyl group; a $C_2$-$C_{60}$ hetero ring group containing at least one hetero atom from O, N, S, Si and P; a fused ring group of a $C_3$-$C_{60}$ aliphatic ring and a $C_6$-$C_{60}$ aromatic ring.

In $R_1$ to $R_3$, $L_1$ and $L_2$ of chemical formula 9 and chemical formula 10, the aryl group, the fluorenyl group, the hetero ring group, the fused ring group, the alkyl group, the alkenyl group, the alkynyl group, the alkoxy group, the aryloxy group, the alkylsilyl group, the arylsilyl group, the alkylarylsilyl group, the arylene group, the fluorylene group and the divalent fused ring group may each be further substituted with at least one substituent selected from the group consisting of a deuterium; a nitro group; a cyano group; a halogen; an amino group; a $C_1$-$C_{20}$ alkoxyl group; a $C_1$-$C_{20}$ alkyl group; a $C_2$ - $C_{20}$ alkenyl group; a $C_2$-$C_{20}$ alkynyl group; a $C_6$-$C_{20}$ aryl group; a $C_6$-$C_{20}$ aryl group substituted with the deuterium; a fluorenyl group; a $C_2$-$C_{20}$ hetero ring group; a $C_3$-$C_{60}$ alkylsilyl group; a $C_{18}$-$C_{60}$ arylsilyl group; and a $C_8$-$C_{60}$ alkylarylsilyl group.

The second chemical compound may also be one or more of the following chemical compounds:

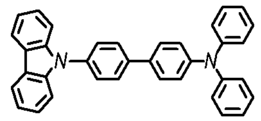

4-1

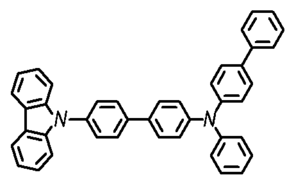

4-2

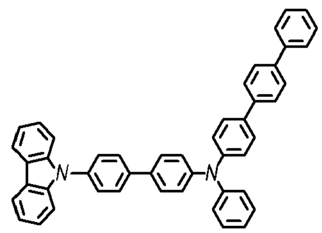

4-3

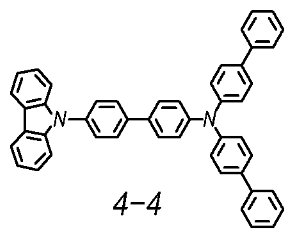

4-4

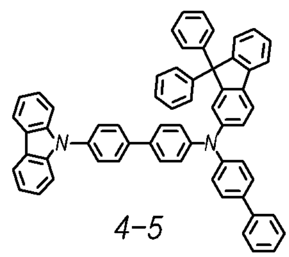

4-5

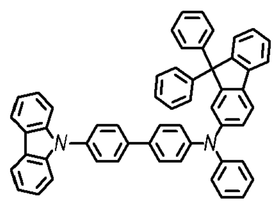

4-6

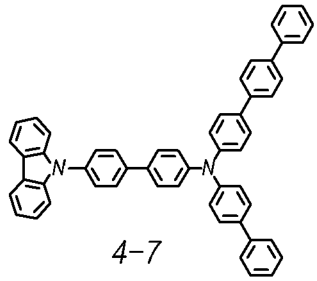

4-7

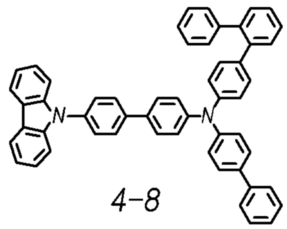

4-8

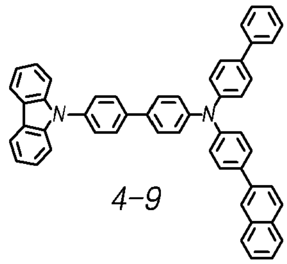

4-9

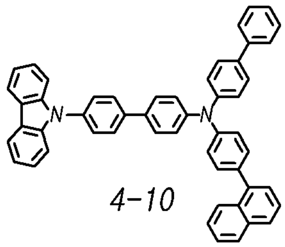

4-10

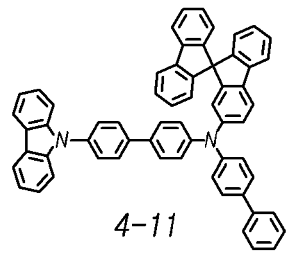

4-11

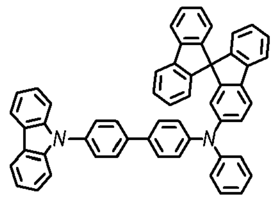

4-12

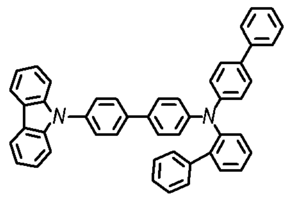

4-13

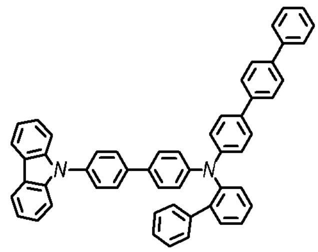

4-14

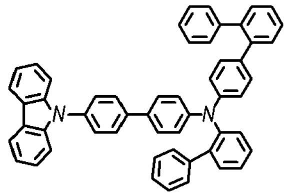

4-15

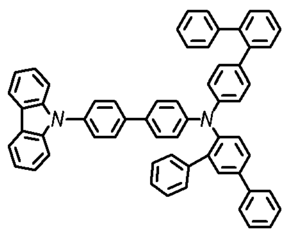

4-16

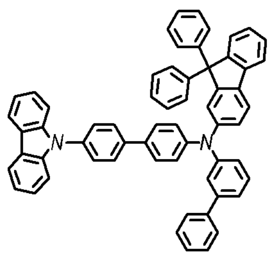

4-17

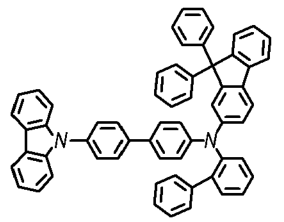

4-18

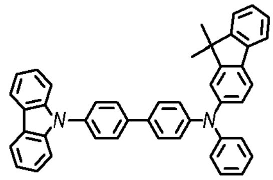

4-19

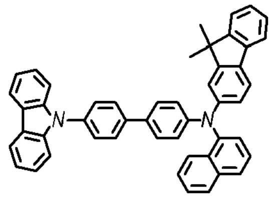

4-20

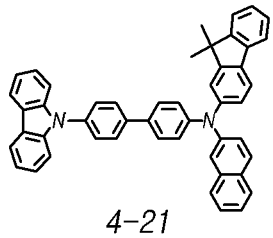

4-21

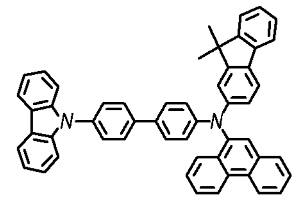

4-22

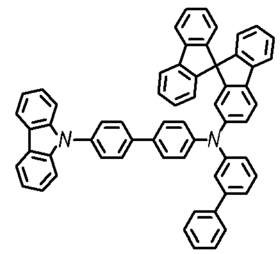

4-23

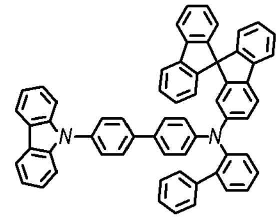

4-24

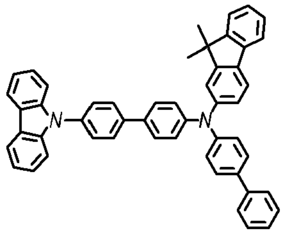

4-25

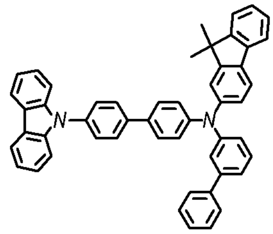

4-26

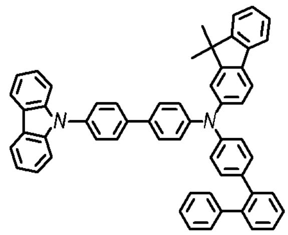

4-27

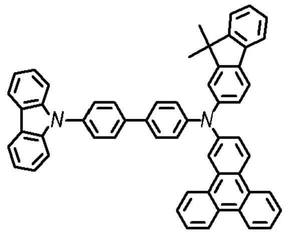

4-28

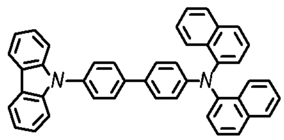

4-29

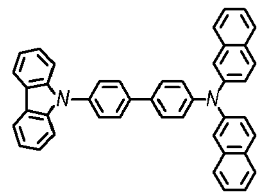

4-30

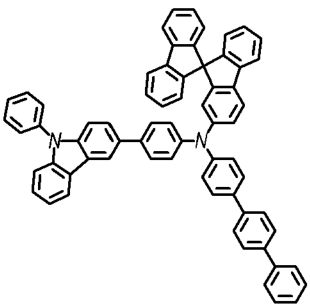

5-1

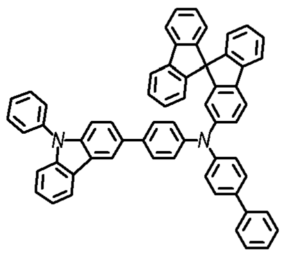

5-2

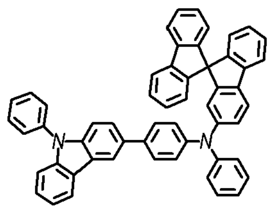

5-3

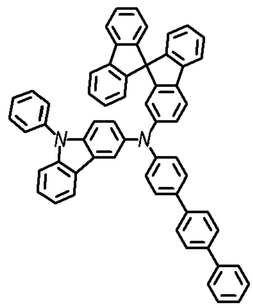

5-4

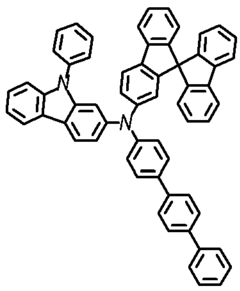

5-5

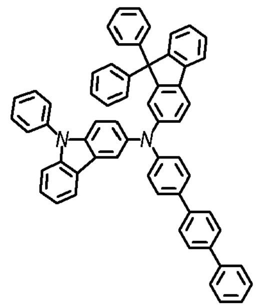

5-6

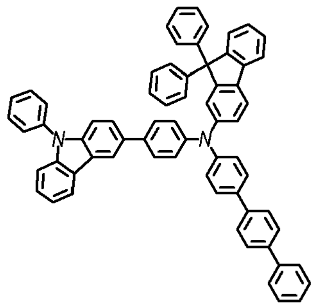

5-7

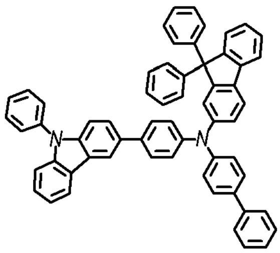

5-8

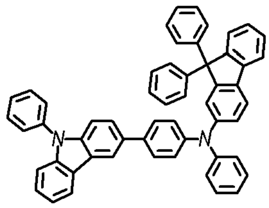

5-9

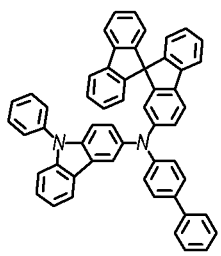

5-10

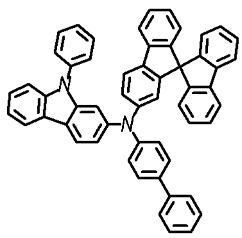

5-11

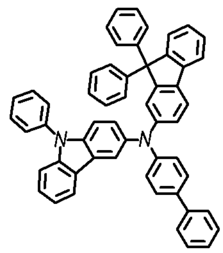

5-12

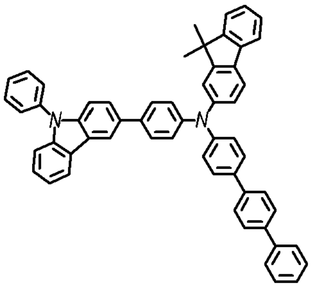

5-13

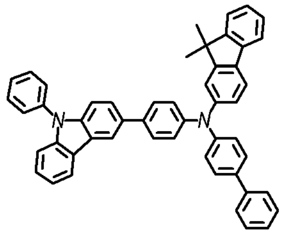

5-14

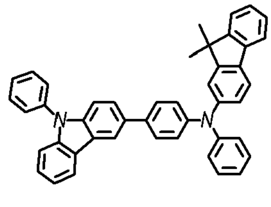

5-15

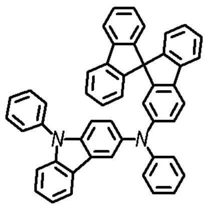

5-16

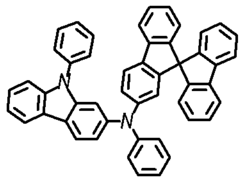

5-17

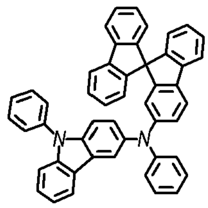

5-18

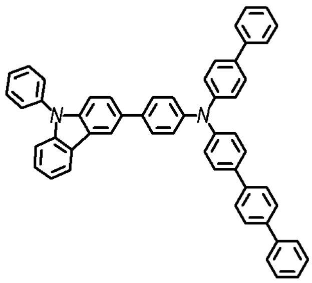

5-19

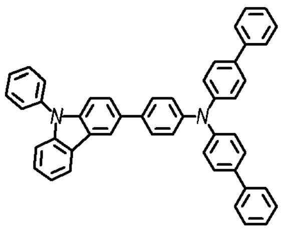

5-20

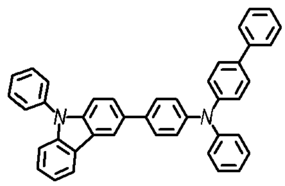

5-21

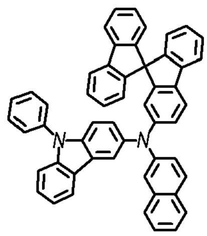

5-22

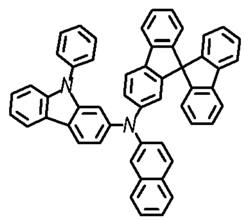

5-23

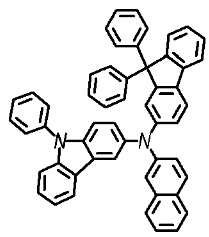

5-24

The third chemical compound is one or more of the following chemical compounds:

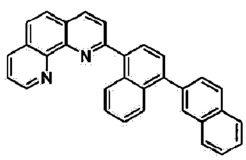

E01

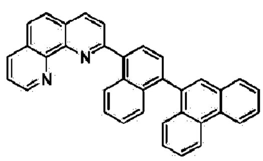

E02

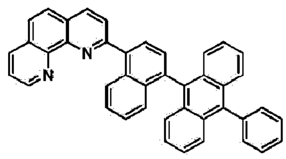

E03

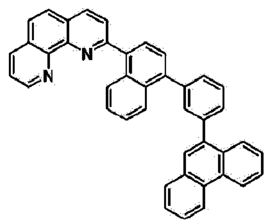

E04

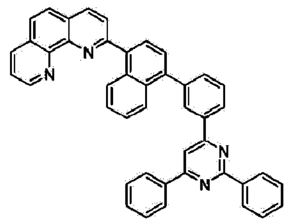

E05

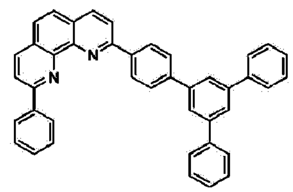

E06

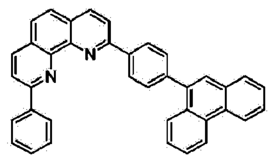

E07

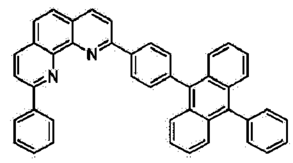

E08

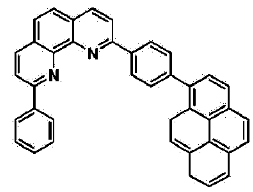

E09

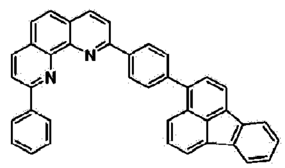

E10

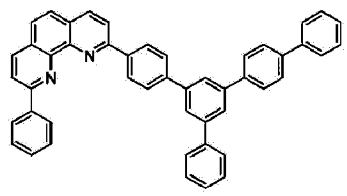

E11

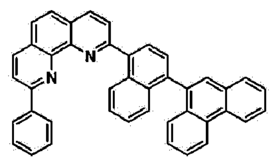

E12

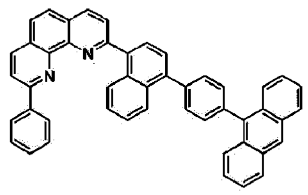

E13

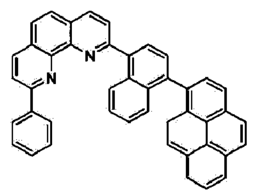

E14

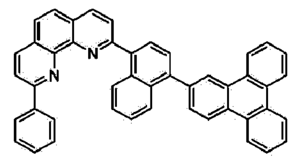

E15

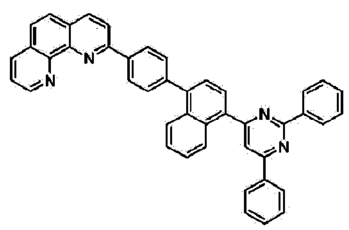

E16

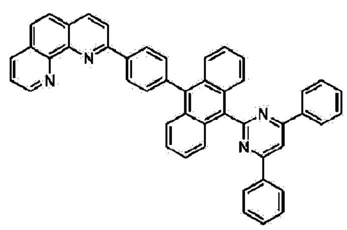

E17

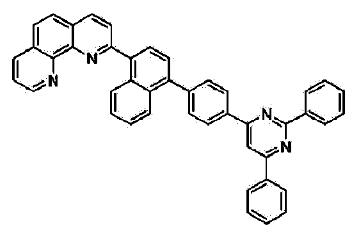

E18

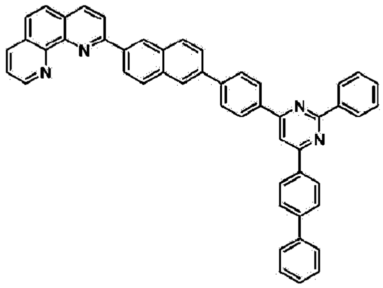

E19

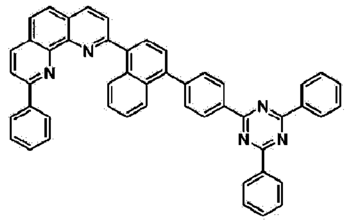

E20

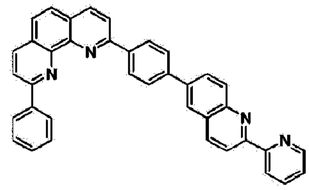

E21

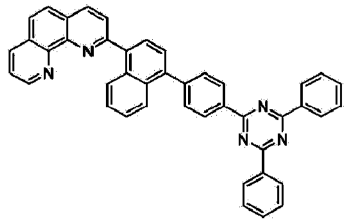

E22

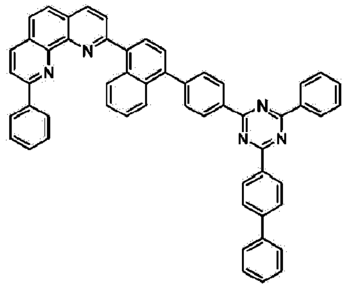

E23

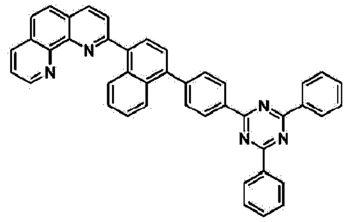

E24

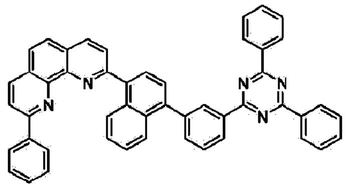

E25

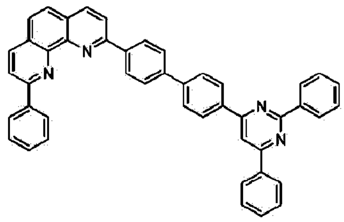

E26

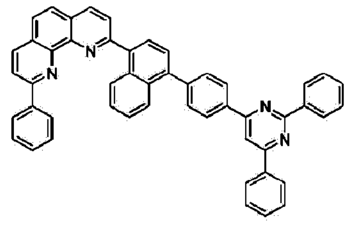

E27

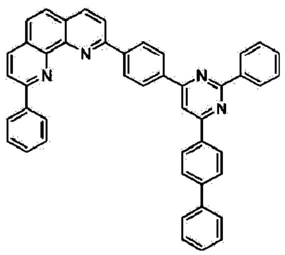

E28

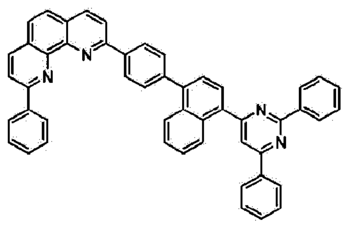

E29

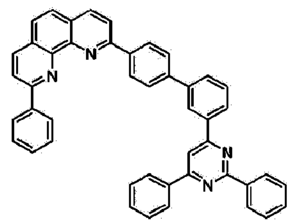

E30

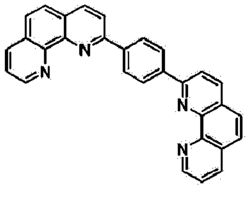

E31

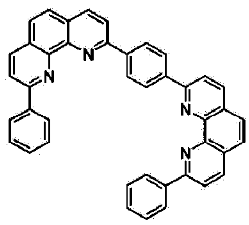

E32

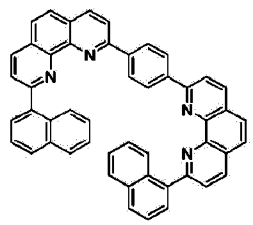

E33

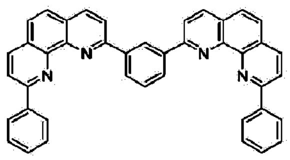

E34

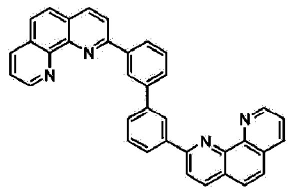

E35

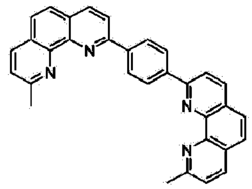

E36

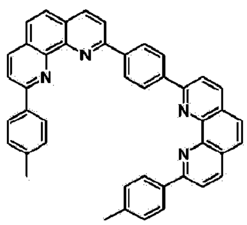

E37

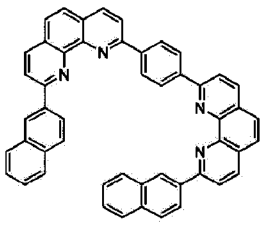

E38

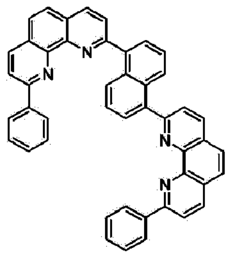

E39

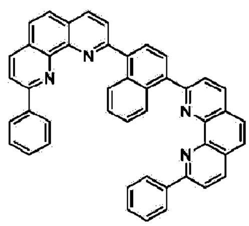

E40

In a preferred embodiment, the first electrode is an anode electrode, the second electrode is a cathode electrode, and the first layer is positioned between the second layer and the second electrode.

In another preferred embodiment, the electric element further comprises a hole injection layer located between the first electrode and the first light emitting layer, wherein the hole injection layer preferably comprises a fourth compound represented by one or more of chemical formula 1 and chemical formula 2 and a fifth compound represented by chemical formula 3.

The fourth compound may also be the same compound as the first compound, and the fifth compound may be the same organic compound as the second compound.

It is further preferred if the following general formula 1 is satisfied:

[general formula 1] $L_3\text{-}L_1 \leq 2.1$ eV

In general formula 1, $L_3$ is the LUMO (Lowest Unoccupied Molecular Orbital) energy level of the third compound, and $L_1$ is the LUMO energy level of the first compound.

Another preferred embodiment requires that the following general formula 2 is satisfied:

[general formula 2] $L_3\text{-}H_2 \leq 2.8$ eV

In general formula 2, $L_3$ is the LUMO (Lowest Unoccupied Molecular Orbital) energy level of the third compound, and Hz is the HOMO (Highest Occupied Molecular Orbital) energy level of the second compound.

Last but not least, another preferred organic electric element is characterized in that the following general formula 3 is satisfied:

[general formula 3] $0.32\text{eV} \leq L_1\text{-}H_2 \leq 0.8$ eV

In general formula 3, $L_1$ is the LUMO (Lowest Unoccupied Molecular Orbital) energy level of the first compound,

and Hz is the HOMO (Highest Occupied Molecular Orbital) energy level of the second compound.

According to the second aspect, the invention provides a display panel comprising a subpixel comprising the organic electric element.

According to the third aspect, the invention provides a display device comprising the display panel and a driving circuit for driving the display panel.

In this way, it is possible to provide an organic electric element having a high luminous efficiency and a long lifetime.

Summarizing, it is possible to provide a display panel including the organic electric element having a high luminous efficiency and a long lifetime and a display device comprising the same.

It is to be understood that both the foregoing general description and the following detailed description are exemplary and explanatory and are intended to provide further explanation of the inventive concepts as claimed.

## DESCRIPTION OF DRAWINGS

The accompanying drawings, which are included to provide a further understanding of the invention and are incorporated in and constitute a part of this application, illustrate embodiments of the invention and together with the description serve to explain various principles. In the drawings:

FIG. 1 is a system configuration diagram of a display device according to the present invention;
FIG. 2 is a view illustrating a subpixel circuit of a display panel according to the present invention; and
FIG. 3 is a schematic cross-sectional view of an organic electric element according to the present invention.

## DETAILED DESCRIPTION

In the following description of examples or embodiments of the present invention, reference will be made to the accompanying drawings in which it is shown by way of illustration specific examples or embodiments that can be implemented, and in which the same reference numerals and signs can be used to designate the same or like components even when they are shown in different accompanying drawings from one another. Further, in the following description of examples or embodiments of the present invention, detailed descriptions of well-known functions and components incorporated herein will be omitted when it is determined that the description may make the subject matter in some embodiments of the present invention rather unclear. The terms such as "including", "having", "containing", "constituting" "make up of", and "formed of" used herein are generally intended to allow other components to be added unless the terms are used with the term "only". As used herein, singular forms are intended to include plural forms unless the context clearly indicates otherwise.

Terms, such as "first", "second", "A", "B", "(A)", or "(B)" may be used herein to describe elements of the present invention. Each of these terms is not used to define essence, order, sequence, or number of elements etc., but is used merely to distinguish the corresponding element from other elements.

When it is mentioned that a first element "is connected or coupled to", "contacts or overlaps" etc. a second element, it should be interpreted that, not only can the first element "be directly connected or coupled to" or "directly contact or overlap" the second element, but a third element can also be "interposed" between the first and second elements, or the first and second elements can "be connected or coupled to", "contact or overlap", etc. each other via a fourth element. Here, the second element may be included in at least one of two or more elements that "are connected or coupled to", "contact or overlap", etc. each other.

When time relative terms, such as "after," "subsequent to," "next," "before," and the like, are used to describe processes or operations of elements or configurations, or flows or steps in operating, processing, manufacturing methods, these terms may be used to describe non-consecutive or non-sequential processes or operations unless the term "directly" or "immediately" is used together.

In addition, when any dimensions, relative sizes etc. are mentioned, it should be considered that numerical values for an elements or features, or corresponding information (e.g., level, range, etc.) include a tolerance or error range that may be caused by various factors (e.g., process factors, internal or external impact, noise, etc.) even when a relevant description is not specified. Further, the term "may" fully encompasses all the meanings of the term "can".

The term "halo" or "halogen" as used herein refers to fluorine (F), bromine (Br), chlorine (Cl), or iodine (I) unless otherwise indicated.

As used herein, the term "alkyl" or "alkyl group" refers to a saturated aliphatic functional radical of 1 to 60 carbon atoms with a single bond therein, including a straight chain alkyl group, a branched chain alkyl group, a cycloalkyl (alicyclic) group, an alkyl-substituted cycloalkyl group, and a cycloalkyl-substituted alkyl group, unless otherwise indicated.

The term "haloalkyl group" or "halogenalkyl group", as used herein, means a halogen-substituted alkyl group

unless otherwise specified.

The term "heteroalkyl group", as used herein, means that at least one of the carbon atoms constituting the alkyl group has been replaced with a heteroatom.

As used herein, the terms "alkenyl group" and "alkynyl group", refer to a straight or branched chain of 2 to 60 carbon atoms with a double and a triple bond therein, respectively, unless stated otherwise, but are not limited thereto.

Unless otherwise stated, the term "cycloalkyl" as used herein refers to an alkyl forming a ring having 3 to 60 carbon atoms, without being limited thereto.

Unless otherwise stated, the term "alkoxyl group", "alkoxy group", or "alkyloxy group" as used herein means an alkyl group of 1 to 60 carbon atoms having an oxygen radical attached thereto, but is not limited thereto.

As used herein, the term "alkenoxyl group", "alkenoxy group", "alkenyloxyl group", or "alkenyloxy group" means an alkenyl group of 2 to 60 carbon atoms having an oxygen radical attached thereto, unless otherwise stated, but is not limited thereto.

As used herein, the term "aryloxyl group" or "aryloxy group" means an aryl group of 6 to 60 carbon atoms having an oxygen radical attached thereto unless otherwise specified, but is not limited thereto.

As used herein, the terms "aryl group" and "arylene group" each refer to having 6 to 60 carbon atoms unless otherwise stated, but are not limited thereto. In the present invention, an aryl group or an arylene group means a single or multiple aromatic ring, including an aromatic ring which is formed as neighboring substituents participate in a bond or a reaction. For example, the aryl group may be a phenyl group, a biphenyl group, a terphenyl group, a naphthyl group, an anthracenyl group, a fluorene group, a spirofluorene group, or a spirobifluorene group.

The prefix "aryl" or "ar" means a radical substituted with an aryl group. For example, an arylalkyl group is an alkyl group substituted with an aryl group and an arylalkenyl group is an alkenyl group substituted with an aryl group. In this regard, the radical substituted with an aryl group has the number of carbon atoms described herein.

Also, when prefixes are named consecutively, it means that the substituents are listed in the order described first. By way of example, an arylalkoxy group means an alkoxy group substituted with an aryl group, an alkoxylcarbonyl group means a carbonyl group substituted with an alkoxyl group, and an arylcarbonylalkenyl group means an alkenyl group substituted with an arylcarbonyl group wherein the arylcarbonyl group is a carbonyl group substituted with an aryl group.

As used herein, the term "heteroalkyl" means an alkyl bearing one or more heteroatoms unless otherwise indicated. As used herein, the terms "heteroaryl group" and "heteroarylene group" refer respectively to an aryl group and an arylene group of 2 to 60 carbon atoms bearing one or more heteroatoms therein, unless otherwise specified, without being limited thereto. It may include at least one of a single ring and multiple rings, and may be formed by combining adjacent functional groups.

Unless otherwise indicated, the term "heterocyclic group" as used herein, refers to at least one of heteroaliphatic rings and heteroaromatic rings of 2 to 60 carbon atoms bearing one or more heteroatoms as a ring member thereof, which may be mono- or multi-cyclic and may be formed as neighboring functional groups combine with each other.

The term "heteroatom" as used herein refers to N, O, S, P, or Si unless otherwise stated.

"Heterocyclic groups" may also include rings comprising $SO_2$, in place of carbon atoms, as a ring member. For example, a "heterocyclic group" includes the following compounds.

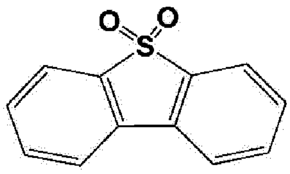

Unless otherwise stated, the term "aliphatic" as used herein means an aliphatic hydrocarbon of 1 to 60 carbon atoms, and the "aliphatic ring" means an aliphatic hydrocarbon ring of 3 to 60 carbon atoms.

Unless otherwise stated, the term "ring" as used herein refers to an aliphatic ring of 3 to 60 carbon atoms, an aromatic ring of 6 to 60 carbon atoms, a hetero ring of 2 to 60 carbon atoms, or a fused ring consisting of a combination thereof whether or not it is saturated or unsaturated.

Other hetero-compounds or hetero-radicals other than the aforementioned hetero-compounds include, but are not limited to, one or more heteroatoms.

Unless otherwise stated, the term "carbonyl" as used herein is represented by -COR', wherein R' is hydrogen, an alkyl group of 1 to 20 carbon atoms, an aryl group of 6 to 30 carbon atoms, a cycloalkyl group of 3 to 30 carbon atoms, an alkenyl group of 2 to 20 carbon atoms, an alkynyl group of 2 to 20 carbon atoms, or a combination thereof.

Unless otherwise specified, the term "ether" as used herein is represented by -R-O-R', wherein R and R' are each independently hydrogen, an alkyl group of 1 to 20 carbon atoms, an aryl group of 6 to 30 carbon atoms, a cycloalkyl

group of 3 to 30 carbon atoms, an alkenyl group of 2 to 20 carbon atoms, an alkynyl group of 2 to 20 carbon atoms, or a combination thereof.

Also, unless explicitly stated otherwise, the term "substituted" in the expression "substituted or unsubstituted" means having at least one substituent selected from the group consisting of, but not limited to, deuterium, halogen, an amino group, a nitrile group, a nitro group, a $C_1$-$C_{20}$ alkyl group, a $C_1$-$C_{20}$ alkoxyl group, a $C_1$-$C_{20}$ alkylamine group, a $C_1$-$C_{20}$ alkylthiophene group, a $C_6$-$C_{20}$ arylthiophene group, a $C_2$-$C_{20}$ alkenyl group, a $C_2$-$C_{20}$ alkynyl, a $C_3$-$C_{20}$ cycloalkyl group, a $C_6$-$C_{20}$ aryl group, a deuterium-substituted $C_6$-$C_{20}$ aryl group, a Cs-$C_{20}$ aryl alkenyl group, a silane group, a boron group, a germanium group, and a $C_2$-$C_{20}$ hetero-ring.

Also, unless otherwise stated, the chemical formulas used in the present invention are as defined for the exponent parts of the substituent in the following chemical formula:

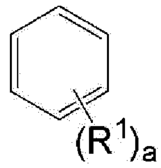

wherein,

when a is an integer of 0, the substituent $R^1$ being null,
when a is an integer of 1, one substituent $R^1$ is bonded to any one of the constituent carbon atoms of the benzene ring,
when a is an integer of 2 or 3, the substituents $R^1$'s, which may be the same or different, are each bonded as represented below, and
when a is an integer of 4 to 6, the substituents $R^1$'s are bonded to the constituents carbon atoms of the benzene ring in the same manner
while the hydrogens bonded to the constituent carbon atoms of the benzene ring are not indicated:

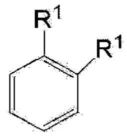

(a=2)

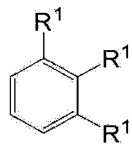

(a=3)

In the present specification, the formation of a ring by combining substituents with each other means that adjacent groups combine with each other to form a monocycle or single ring, a ring aggregated or a conjugated multicycle, and the monocycle, the ring aggregated and the formed conjugated multicycle may include the heterocycle including at least one heteroatom, and may include aromatic and non-aromatic rings.

In the present specification, the organic electric element may mean a component(s) between an anode and a cathode, or an organic light emitting diode including the anode, the cathode and the component(s) positioned therebetween.

In the present specification, the organic electric element may mean one of an organic electric device, the organic light emitting diode and the panel including the same, and an electronic device including the panel and a circuit. For example, the electronic device includes a display device, a lighting device, a solar cell, a portable or mobile terminal (eg, a smart phone, a tablet, a PDA, an electronic dictionary, a PMP, etc.), a navigation terminal, a game machine, various TVs, and various computers monitor and the like, but is not limited thereto, and may be any type of device as long as the component(s) are included.

Hereinafter, exemplary embodiments of the present invention will be described in detail with reference to the accompanying drawings.

FIG. 1 is a system configuration diagram of a display device according to the present invention.

Referring to FIG. 1, the display device 100 includes a display panel 110 in which a plurality of data lines DL and a plurality of gate lines GL are arranged and a plurality of subpixels 111 defined by the plurality of data lines DL and the plurality of gate lines GL is arranged, a data driving circuit DDC (or a data driver) for driving the plurality of data lines DL, a gate driving circuit GDC (or a gate driver) for driving the plurality of gate lines GL, a controller D-CTR controlling the data driving circuit DDC and the gate driving circuit GDC, and the like.

The controller D-CTR controls operations of the data driving circuit DDC and the gate driving circuit GDC by

supplying respective control signals (DCS, GCS) to the data driving circuit DDC and the gate driving circuit GDC.

The controller D-CTR starts the scan of pixels according to timings processed in each frame, converts image data inputted from other devices or other image providing sources to be adapted to a data signal form used in the data driving circuit DDC and then outputs image data DATA resulted from the converting, and causes the data to be loaded into the pixels at a preconfigured time according to the scan.

The controller D-CTR may be implemented as a separate component from the data driving circuit DDC or may be integrated with data driving circuit DDC so the controller D-CTR can be implemented as an integrated circuit.

The data driving circuit DDC drives the plurality of data lines DL by providing data voltages corresponding to image data DATA received from the controller D-CTR to the data lines DL. Here, the data driving circuit DDC is sometimes referred to as a source driving circuit or a source driver.

The data driving circuit DDC may include at least one source driver integrated circuit SDIC to be implemented.

Each source driver integrated circuit SDIC may include a shift register, a latch circuit, a digital to analog converter DAC, an output buffer, and/or the like.

In some instances, each source driver integrated circuit SDIC may further include one or more analog to digital converters ADC.

The gate driving circuit GDC sequentially drives a plurality of gate lines GL by sequentially providing scan signals to the plurality of gate lines GL. Here, the gate driving circuit GDC is sometimes referred to as a scan driving circuit or a scan driver.

The gate driving circuit GDC may include at least one gate driver integrated circuit GDIC to be implemented.

Each gate driver integrated circuit GDIC may include a shift register, a level shifter, and/or the like.

Each gate driver integrated circuit GDIC may be connected to a bonding pad of the display panel 110 in a tape automated bonding (TAB) type or a chip on glass (COG) type, or be directly disposed on the display panel 110 as being implemented in a gate in panel (GIP) type. In some instances, the gate driver integrated circuit GDIC may be disposed to be integrated with the display panel 110. Further, each gate driver integrated circuit GDIC may be implemented in a chip on film (COF) type in which the gate driver integrated circuit GDIC is mounted on a film connected with the display panel 110.

According to the controlling of the controller D-CTR, the gate driving circuit GDC sequentially provides scan signals of an on-voltage or an off-voltage to the plurality of gate lines GL.

When a specific gate line is asserted by a scan signal from the gate driving circuit GDC, the data driving circuit DDC converts image data DATA received from the controller D-CTR into analog data voltages and provides the obtained analog data voltages to the plurality of data lines DL.

The data driving circuit DDC may be located on, but not limited to, only one side (e.g., an upper side or a lower side) of the display panel 110, or in some instances, be located on, but not limited to, two sides (e.g., the upper side and the lower side) of the display panel 110 according to driving schemes, panel design schemes, or the like.

The gate driving circuit GDC may be located on, but not limited to, only one side (e.g., a left side or a right side) of the panel 110, or in some instances, be located on, but not limited to, two sides (e.g., the left side and the right side) of the display panel 110 according to driving schemes, panel design schemes, or the like.

The display device 100 according to the present invention may be one of various types of display devices, such as, a liquid crystal display device, an organic light emitting display device, a plasma display device, or the like.

In case the display device 100 according to the present invention is an organic light emitting display device, each sub-pixel 111 arranged in the display panel 110 may include circuit components, such as an organic light emitting diode (OLED), which is a self-emissive element, a driving transistor for driving the organic light emitting diode OLED, and the like.

Types of circuit elements and the number of the circuit elements included in each subpixel 111 may be different depending on types of the panel (e.g., an LCD panel, an OLED panel, etc.), provided functions, design schemes/features, or the like.

FIG. 2 is a view illustrating a subpixel circuit of a display panel according to the present invention.

Referring to FIG. 2, each subpixel 111 may include an organic light emitting diode OLED and a driving transistor DRT for driving the organic light emitting diode OLED as basic circuit components.

Referring to FIG. 2, each sub-pixel 111 may further include a first transistor T1 allowing a data voltage VDATA to be applied to a first node N1 corresponding to a gate node of the driving transistor DRT, and a storage capacitor C1 for remaining a data voltage VDATA corresponding to an image signal voltage or a voltage corresponding to this during one frame time.

The organic light emitting diode OLED may be an organic electric element 220 which may include a first electrode 221 (an anode electrode or a cathode electrode), a light emitting layer 222, a second electrode 223 (the cathode electrode or the anode electrode), and the like.

In one embodiment, a low-level voltage EVSS may be applied to the second electrode 223 of the organic light emitting diode OLED.

The driving transistor DRT causes the organic light emitting diode OLED to be driven by providing a driving current to the organic light emitting diode OLED.

The driving transistor DRT includes a first node N1, a second node N2 and a third node N3.

The first node N1 of the driving transistor DRT may be a node corresponding to the gate node thereof, and may be electrically connected to a source node or a drain node of the first transistor T1.

The second node N2 of the driving transistor DRT may be electrically connected to the first electrode 221 of the organic light emitting diode OLED and may be a source node or a drain node.

The third node N3 of the driving transistor DRT may be the drain node or the source node as a node to which a driving voltage EVDD is applied, and may be electrically connected to a driving voltage line DVL used to supply a driving voltage EVDD.

The first transistor T1 may be electrically connected between a data line DL and the first node N1 of the driving transistor DRT and may be controlled by a scan signal SCAN that is provided through a gate line and applied to the gate node of the first transistor T1.

The storage capacitor C1 may be electrically connected between the first node N1 and the second node N2 of the driving transistor DRT.

The storage capacitor C1 is an external capacitor intentionally designed to be located outside of the driving transistor DRT, not an internal storage, such as a parasitic capacitor (e.g., a Cgs, a Cgd) that presents between the first node N1 and the second node N2 of the driving transistor DRT.

FIG. 3 is a cross-sectional view of an organic electric element according to the present invention.

Referring to FIG.3, the organic electric element 320 includes a first electrode 321 and a second electrode 323, an organic layer 322 positioned therebetween.

The first electrode 321 may be an anode and the second electrode 323 may be a cathode. In the case of an inverted type, the first electrode 321 may be a cathode and the second electrode 323 may be an anode.

For example, the first electrode 321 may be a transparent electrode, and the second electrode 323 may be a reflective electrode. In another example, the first electrode 321 may be a reflective electrode, and the second electrode 323 may be a transparent electrode.

The organic layer 322 may include a plurality of layers which is located between the first electrode 321 and the second electrode 323 and includes an organic material.

The organic layer 322 includes a first stack 324, a second stack 325, and a charge generating layer 326 positioned between the first stack 324 and the second stack 325.

The organic electric element 320 may be a tandem organic electric element including a plurality of stacks each including a light emitting layer. The plurality of light emitting layers may be made of the same material or may be made of different materials from each other.

The first stack 324 includes a first emitting layer 324a. The first emitting layer 324a may include, for example, a host material and a dopant.

The first stack 324 may further include a first hole transport layer 324b and a first electron transport layer 324c.

The first hole transport layer 324b may be positioned between the first light emitting layer 324a and one of the first electrode 321 and the second electrode 323 which serves as an anode electrode. The first electron transport layer 324c may be positioned between the first light emitting layer 324a and one of the first electrode 321 and the second electrode 323 which serves as a cathode electrode. For example, when the first electrode 321 is the anode electrode and the second electrode 323 is the cathode electrode, the first hole transport layer 324b may be positioned on the first electrode 321, the first light emitting layer 324a may be positioned on the first hole transport layer 324b, and the first electron transport layer 324c may be positioned on the first light emitting layer 324a.

The second stack 325 includes a second emitting layer 325a. The second emitting layer 325a may include, for example, a host material and a dopant.

The second stack 325 may further include a second hole transport layer 325b and a second electron transport layer 325c.

The second hole transport layer 325b may be positioned between the second light emitting layer 325a and one of the first electrode 321 and the second electrode 323 which serves as an anode electrode. The second electron transport layer 325c may be positioned between the second light emitting layer 324a and one of the first electrode 321 and the second electrode 323 which serves as a cathode electrode. For example, when the first electrode 321 is the anode electrode and the second electrode 323 is the cathode electrode, the second hole transport layer 325b may be positioned on the second electrode 321, the second light emitting layer 325a may be positioned on the second hole transport layer 325b, and the second electron transport layer 325c may be positioned on the second light emitting layer 325a.

Since the first stack 324 and the second stack 325 are configured as described above, holes and electrons transmitted from the first electrode 321 and the second electrode 323 are recombined with each other in the first and second light emitting layers 324a and 232 so that tight may be emitted from by recombination the first and second light

emitting layers 324a and 232.

The charge generating layer 326 is formed between a plurality of light emitting layers to smoothly distribute charges so that it may increase the current efficiency of the light emitting layer. Accordingly, the charge generating layer 326 is positioned between the first stack 324 including the first light emitting layer 324a and the second stack 325 including the second light emitting layer 325a.

The charge generating layer 326 may include a p-type charge generating layer and an n-type charge generating layer in order to smoothly distribute charges. For example, the first layer 326a may be a p-type charge generating layer and the second layer 326b may be an n-type charge generating layer. When the first electrode 321 is the anode electrode and the second electrode 323 is the cathode electrode, the p-type charge generating layer may be located on the cathode electrode side and the n-type charge generating layer may be located on the anode side. For example, the first layer 326a may be positioned between the second layer 326b and the second electrode 323 which is a cathode electrode.

Although FIG. 3 shows a tandem organic electric element including two stacks, the embodiment is not limited to a tandem organic electric element including two stacks. Instead, the invention also comprises organic electric elements including more than two stacks. When the organic electrical element 320 includes an additional stack, an additional charge generating layer may be positioned between the additional stack and one of the adjacent first stack 324 and the second stack 325.

The organic electric element 320 may include a hole injection layer 327. The hole injection layer 327 may be positioned between the first electrode 321 which serves as an anode electrode and the first light emitting layer 324a. For example, the hole injection layer 327 may be positioned between the first electrode 321 which serves as an anode electrode and the first hole transport layer 324b.

Although not illustrated in FIG. 3, the organic electric element 320 may further include an electron injection layer. For example, the electron injection layer may be positioned between the second electrode 323 which serves as a cathode electrode, and the second electron transport layer 325c.

In another example, each of the first stack 324 and the second stack 325 may further include one or more of a hole injection layer and an electron injection layer. Within each stack, the hole injection layer may be located between the light emitting layer and the anode electrode, and an electron injection layer may be located between the light emitting layer and the cathode electrode.

The first layer 326a includes the first compound. The first hole transport layer 324b may include the first compound, and the second hole transport layer 325b may also include the first compound. Further, the hole injection layer may also include the first compound. The first compound included in each layer may be the same or may be different as long as the requirements for the first compound described later are met.

The first compound is represented by one or more of the following chemical formula 1 and chemical formula 2.

[chemical formula 1]

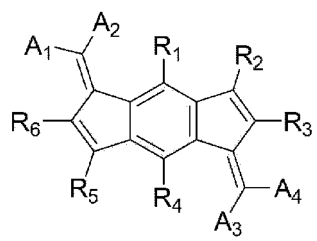

[chemical formula 2]

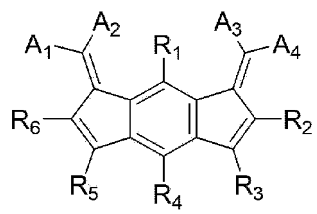

Hereinafter, chemical formula 1 and chemical formula 2 will be described.

$R_1$ to $R_6$, which are same or different, are each independently one selected from the group consisting of a hydrogen; a deuterium; a tritium; a halogen; a cyano group; a nitro group; a $C_6$-$C_{60}$ aryl group; a fluorenyl group; a $C_2$-$C_{60}$ hetero ring group containing at least one hetero atom from O, N, S, Si and P; a fused ring group of a $C_3$-$C_{60}$

aliphatic ring and a $C_6$-$C_{60}$ aromatic ring; a $C_1$-$C_{50}$ alkyl group; a $C_2$-$C_{20}$ alkenyl group; a $C_2$-$C_{20}$ alkynyl group; a $C_1$-$C_{30}$ alkoxy group; a $C_6$-$C_{30}$ aryloxy group; a $C_3$-$C_{60}$ alkylsilyl group; a $C_{18}$-$C_{60}$ arylsilyl group; and a $C_8$-$C_{60}$ alkylarylsilyl group, and one or more of $R_1$ to $R_6$ is the cyano group.

When $R_1$ to $R_6$ are the aryl groups, they may be each independently a $C_6$-$C_{60}$ aryl group, a $C_6$-$C_{30}$ aryl group or a $C_6$-$C_{12}$ aryl group.

$A_1$ to $A_4$, which may be the same or different, are each independently one selected from the group consisting of a hydrogen; a deuterium; a tritium; a halogen; a cyano group; a nitro group; a $C_6$-$C_{60}$ aryl group; a fluorenyl group; a $C_2$-$C_{60}$ hetero ring group containing at least one hetero atom from O, N, S, Si and P; a fused ring group of a $C_3$-$C_{60}$ aliphatic ring and a $C_6$-$C_{60}$ aromatic ring; a $C_1$-$C_{50}$ alkyl group; a $C_2$-$C_{20}$ alkenyl group; a $C_2$-$C_{20}$ alkynyl group; a $C_1$-$C_{30}$ alkoxy group; a $C_6$-$C_{30}$ aryloxy group; a $C_3$-$C_{60}$ alkylsilyl group; a $C_{18}$-$C_{60}$ arylsilyl group; and a $C_8$-$C_{60}$ alkylarylsilyl group.

In $R_1$ to $R_6$ and $A_1$ to $A_4$ of chemical formula 1 and chemical formula 2, the aryl group, the fluorenyl group, the hetero ring group, the fused ring group, the alkyl group, the alkenyl group, the alkynyl group, the alkoxy group, the aryloxy group, the alkylsilyl group, the arylsilyl group and the alkylarylsilyl group may each be further substituted with at least one substituent selected from the group consisting of a deuterium; a nitro group; a cyano group; a halogen; an amino group; a $C_1$-$C_{20}$ alkoxyl group; a $C_1$-$C_{20}$ alkyl group; a $C_2$ - $C_{20}$ alkenyl group; a $C_2$-$C_{20}$ alkynyl group; a $C_6$-$C_{20}$ aryl group; a $C_6$-$C_{20}$ aryl group substituted with the deuterium; a fluorenyl group; a $C_2$-$C_{20}$ hetero ring group; a $C_3$-$C_{60}$ alkylsilyl group; a $C_{18}$-$C_{60}$ arylsilyl group; and a $C_8$-$C_{60}$ alkylarylsilyl group.

When the first compound is represented by one or more of chemical formula 1 and chemical formula 2, for example, the first layer includes one compound (A) represented by chemical formula 1 and one compound (B) represented by chemical formula 2, it means that all the two compounds (A, B) are included in the first compound.

The first layer 326a further includes a second compound.

Since the organic electric element 320 includes the first layer 326a including the first compound and the second compound and the second layer 326b including the third compound, it can have high efficiency or a long lifetime.

In one embodiment of the present invention, the first chemical compound may be represented by one or more of the following chemical formula 5 and chemical formula 6.

[chemical formula 5]

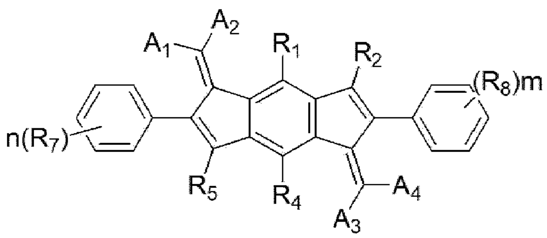

[chemical formula 6]

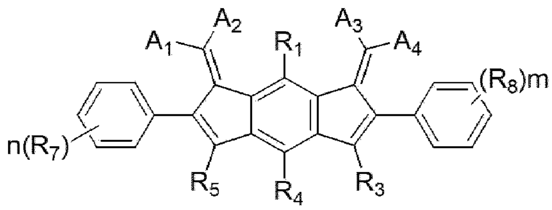

Hereafter, chemical formula 5 and chemical formula 6 will be described.

n and m are each independently an integer from 0 to 5.

$R_7$ to $R_8$, which may be the same or different, are each independently one selected from the group consisting of a deuterium; a tritium; a halogen; a cyano group; a $C_1$-$C_{50}$ alkyl group; and a $C_1$-$C_{30}$ alkoxy group.

When $R_7$ and $R_8$ are alkoxy groups, they may be, for example, a $C_1$-$C_{30}$ alkoxy group, a $C_1$-$C_{20}$ alkoxy group or a $C_1$-$C_{10}$ alkoxy group.

In $R_7$ and $R_8$ of chemical formula 5 and chemical formula 6, the alkyl group and the alkoxy group may each be further substituted with at least one substituent selected from the group consisting of a deuterium and a halogen.

When the first compound is represented by one or more of chemical formula 5 and chemical formula 6, for example, the first layer includes one compound (C) represented by chemical formula 5 and one compound (D) represented by chemical formula 6, it means that all the two compounds (C, D) are included in the first compound.

When the first layer 326a includes the first compound represented by one or more of the above chemical formulas 5 and 6, the organic electric element 320 may have high efficiency or a long lifetime.

In another embodiment of the present invention, the first chemical compound may be represented by one or more of the following chemical formula 7 and formula 8.

[chemical formula 7]

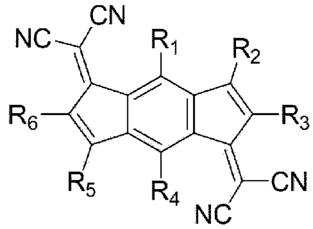

[chemical formula 8]

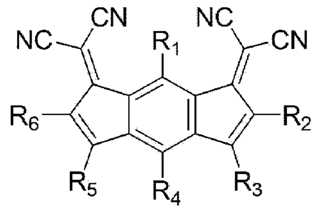

Chemical formula 7 and chemical formula 8 will be described in the following.

$R_1$ to $R_6$, which are same or different, are each independently one selected from the group consisting of a hydrogen; a deuterium; a tritium; a halogen; a cyano group; a nitro group; a $C_6$-$C_{60}$ aryl group; a fluorenyl group; a $C_2$-$C_{60}$ hetero ring group containing at least one hetero atom from O, N, S, Si and P; a fused ring group of a $C_3$-$C_{60}$ aliphatic ring and a $C_6$-$C_{60}$ aromatic ring; a $C_1$-$C_{50}$ alkyl group; a $C_2$-$C_{20}$ alkenyl group; a $C_2$-$C_{20}$ alkynyl group; a $C_1$-$C_{30}$ alkoxy group; a $C_6$-$C_{30}$ aryloxy group; a $C_3$-$C_{60}$ alkylsilyl group; a $C_{18}$-$C_{60}$ arylsilyl group; and a $C_8$-$C_{60}$ alkylarylsilyl group, and one or more of $R_1$ to $R_6$ is the cyano group.

When $R_1$ to $R_6$ are the aryl groups, they may be each independently a $C_6$-$C_{60}$ aryl group, a $C_6$-$C_{30}$ aryl group or a $C_6$-$C_{12}$ aryl group.

In $R_1$ to $R_6$ of chemical formula 7 and chemical formula 8, the aryl group, the fluorenyl group, the hetero ring group, the fused ring group, the alkyl group, the alkenyl group, the alkynyl group, the alkoxy group, the aryloxy group, the alkylsilyl group, the arylsilyl group and the alkylarylsilyl group may each be further substituted with at least one substituent selected from the group consisting of a deuterium; a nitro group; a cyano group; a halogen; an amino group; a $C_1$-$C_{20}$ alkoxyl group; a $C_1$-$C_{20}$ alkyl group; a $C_2$ - $C_{20}$ alkenyl group; a $C_2$-$C_{20}$ alkynyl group; a $C_6$-$C_{20}$ aryl group; a $C_6$-$C_{20}$ aryl group substituted with the deuterium; a fluorenyl group; a $C_2$-$C_{20}$ hetero ring group; a $C_3$-$C_{60}$ alkylsilyl group; a $C_{18}$-$C_{60}$ arylsilyl group; and a Cs-$C_{60}$ alkylarylsilyl group.

When the first compound is represented by one or more of chemical formula 7 and chemical formula 8, for example, the first layer includes one compound (E) represented by chemical formula 7 and one compound (F) represented by chemical formula 8, it means that all the two compounds (E, F) are included in the first compound.

When the first layer 326a includes the first compound represented by one or more of the above chemical formulas 7 and 8, the organic electric element 320 may have a high efficiency or a long lifetime.

The first chemical compound may be one or more of the following chemical compounds.

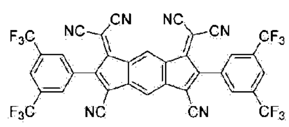

A01

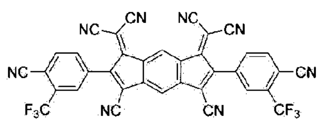

A02

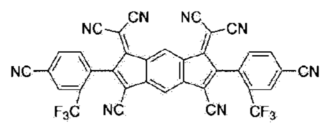

A03

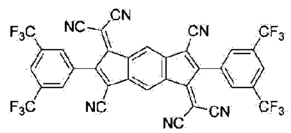

A04

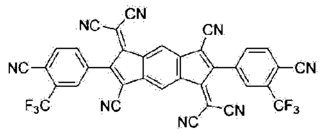

A05

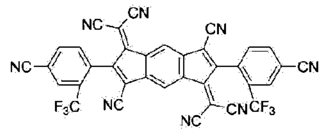

A06

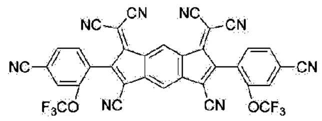

A07

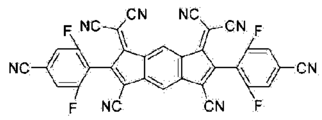

A08

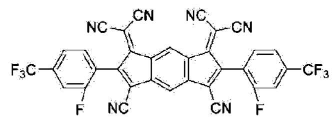

A09

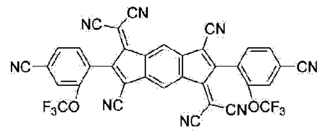

A10

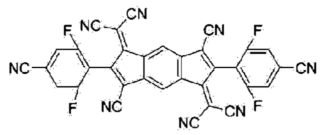

A11

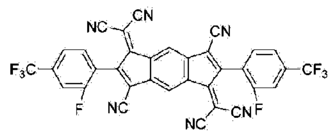

A12

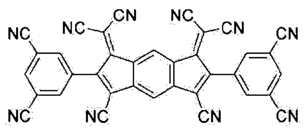

A13

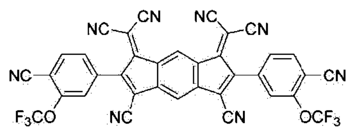

A14

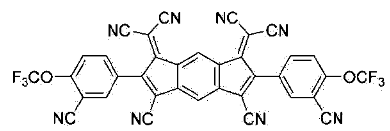

A15

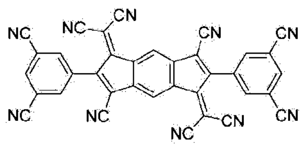

A16

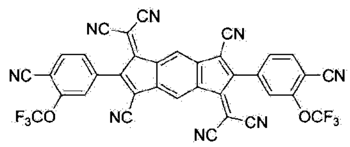

A17

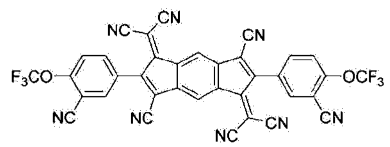

A18

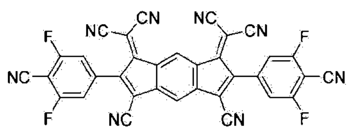

A19

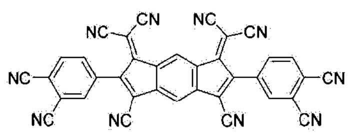

A20

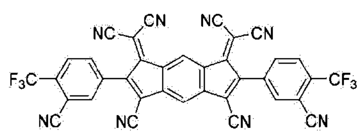

A21

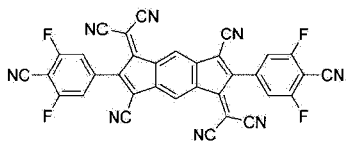

A22

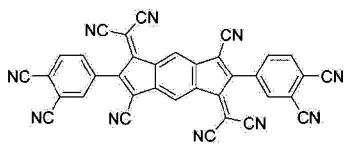

A23

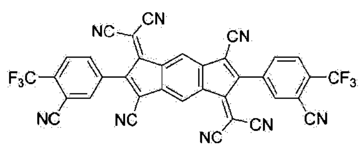

A24

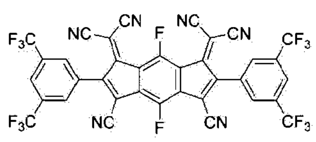

A25

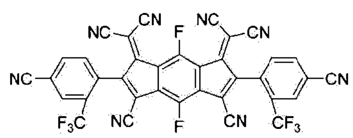

A26

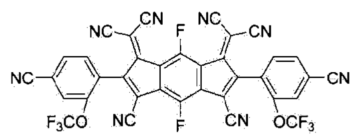

A27

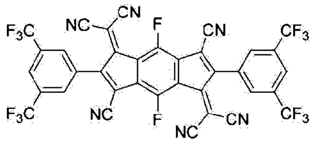 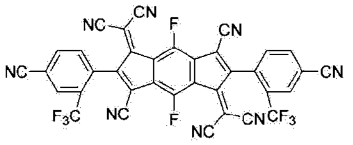 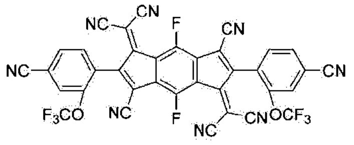

A28 A29 A30

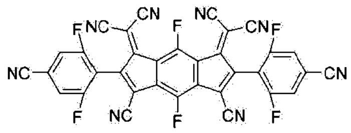 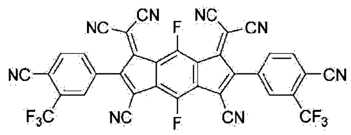 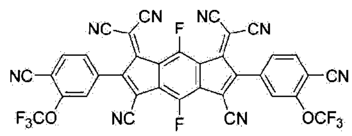

A31 A32 A33

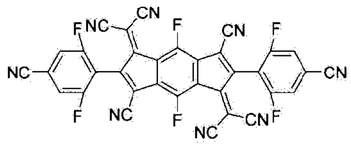 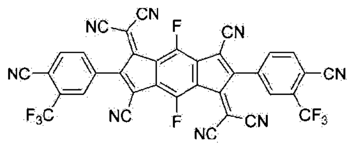 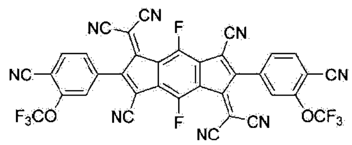

A34 A35 A36

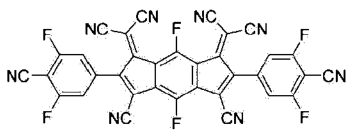 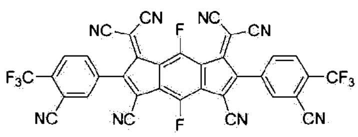 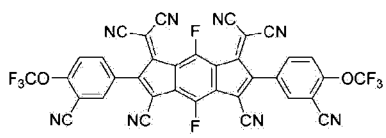

A37 A38 A39

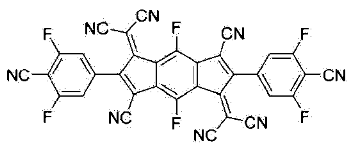 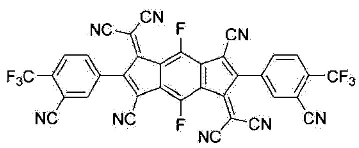 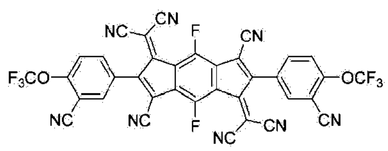

A40 A41 A42

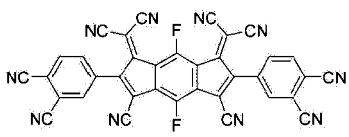 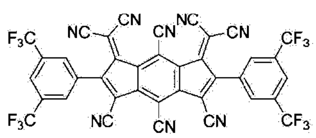 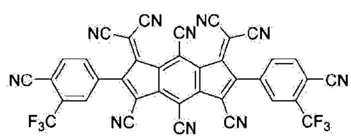

A43 A44 A45

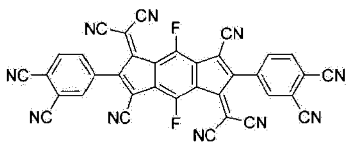 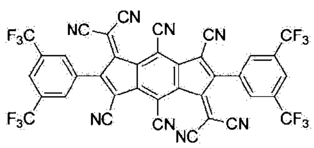 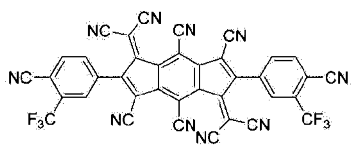

A46 A47 A48

When the first layer 326a includes the first compound represented by one or more of the above chemical compounds, the organic electric element 320 may have a high efficiency or long lifetime.

The second chemical compound is represented by one or more of the following chemical formula 9 and formula 10.

[chemical formula 9]

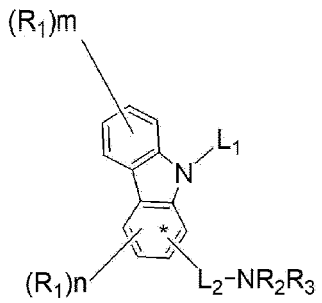

[chemical formula 10]

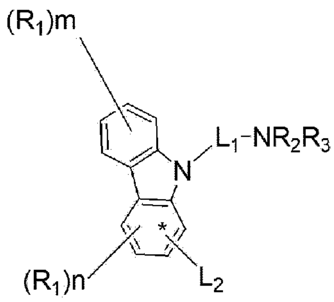

Hereafter chemical formula 9 and chemical formula 10 will be described.

m is an integer from 0 to 4.

n is an integer from 0 to 3.

$R_1$ is each independently one selected from the group consisting of a deuterium; a tritium; a halogen; a cyano group; a nitro group; a $C_6$-$C_{60}$ aryl group; a fluorenyl group; a $C_2$-$C_{60}$ hetero ring group containing at least one hetero atom from O, N, S, Si and P; a fused ring group of a $C_3$-$C_{60}$ aliphatic ring and a $C_6$-$C_{60}$ aromatic ring; a $C_1$-$C_{50}$ alkyl group; a $C_2$-$C_{20}$ alkenyl group; a $C_2$-$C_{20}$ alkynyl group; a $C_1$-$C_{30}$ alkoxy group; a $C_6$-$C_{30}$ aryloxy group; a $C_3$-$C_{60}$ alkylsilyl group; a $C_{18}$-$C_{60}$ arylsilyl group; and a $C_8$-$C_{60}$ alkylarylsilyl group.

When $R_1$ is the aryl group, it may be each independently the $C_6$-$C_{60}$ aryl group, the $C_6$-$C_{30}$ aryl group or the $C_6$-$C_{12}$ aryl group.

$R_2$ and $R_3$, which may be the same or different, are each independently one selected from the group consisting of a $C_6$-$C_{60}$ aryl group; a fluorenyl group; a $C_2$-$C_{60}$ hetero ring group containing at least one hetero atom from O, N, S, Si and P; a fused ring group of a $C_3$-$C_{60}$ aliphatic ring and a $C_6$-$C_{60}$ aromatic ring; a $C_1$-$C_{50}$ alkyl group.

When $R_2$ and $R_3$ are the aryl groups, they may be each independently the $C_6$-$C_{60}$ aryl group, the $C_6$-$C_{30}$ aryl group or the $C_6$-$C_{30}$ aryl group.

In chemical formula 9, $L_1$ is one selected from the group consisting of a $C_6$-$C_{60}$ aryl group; a fluorenyl group; a $C_2$-$C_{60}$ hetero ring group containing at least one hetero atom from O, N, S, Si and P; a fused ring group of a $C_3$-$C_{60}$ aliphatic ring and a $C_6$-$C_{60}$ aromatic ring.

When $L_1$ is the aryl group, it may be each independently the $C_6$-$C_{60}$ aryl group, the $C_6$-$C_{30}$ aryl group or the $C_6$-$C_{12}$ aryl group.

In chemical formula 9, $L_2$ is one selected from the group consisting of a $C_6$-$C_{60}$ arylene group; a fluorylene group; a $C_2$-$C_{60}$ divalent hetero ring group containing at least one heteroatom from O, N, S, Si and P; a divalent fused ring group of a $C_3$-$C_{60}$ aliphatic ring and a $C_6$-$C_{60}$ aromatic ring; a $C_1$-$C_{50}$ alkylene group; a $C_2$-$C_{20}$ alkenylene group; and a $C_2$-$C_{20}$ alkynylene group.

When $L_2$ is the arylene group, it may be each independently the $C_6$-$C_{60}$ arylene group, the $C_6$-$C_{30}$ arylene group or the $C_6$-$C_{12}$ arylene group.

In chemical formula 10, $L_1$ is one selected from the group consisting of a $C_6$-$C_{60}$ arylene group; a fluorylene group; a $C_2$-$C_{60}$ divalent hetero ring group containing at least one heteroatom from O, N, S, Si and P; a divalent fused ring group of a $C_3$-$C_{60}$ aliphatic ring and a $C_6$-$C_{60}$ aromatic ring; a $C_1$-$C_{50}$ alkylene group; a $C_2$-$C_{20}$ alkenylene group; and a $C_2$-$C_{20}$ alkynylene group.

When $L_1$ is the aryl group, it may be each independently the $C_6$-$C_{60}$ aryl group, the $C_6$-$C_{30}$ aryl group or the

$C_6$-$C_{12}$ aryl group.

In chemical formula 10, $L_2$ is one selected from the group consisting of a $C_6$-$C_{60}$ aryl group; a fluorenyl group; a $C_2$-$C_{60}$ hetero ring group containing at least one hetero atom from O, N, S, Si and P; a fused ring group of a $C_3$-$C_{60}$ aliphatic ring and a $C_6$-$C_{60}$ aromatic ring.

When $L_2$ is the aryl group, it may be each independently the $C_6$-$C_{60}$ aryl group, the $C_6$-$C_{30}$ aryl group or the $C_6$-$C_{12}$ aryl group.

In $R_1$ to $R_3$, $L_1$ and $L_2$ of chemical formula 9 and chemical formula 10, the aryl group, the fluorenyl group, the hetero ring group, the fused ring group, the alkyl group, the alkenyl group, the alkynyl group, the alkoxy group, the aryloxy group, the alkylsilyl group, the arylsilyl group, the alkylarylsilyl group, the arylene group, the fluorylene group and the divalent fused ring group may each be further substituted with at least one substituent selected from the group consisting of a deuterium; a nitro group; a cyano group; a halogen; an amino group; a $C_1$-$C_{20}$ alkoxyl group; a $C_1$-$C_{20}$ alkyl group; a $C_2$ - $C_{20}$ alkenyl group; a $C_2$-$C_{20}$ alkynyl group; a $C_6$-$C_{20}$ aryl group; a $C_6$-$C_{20}$ aryl group substituted with the deuterium; a fluorenyl group; a $C_2$-$C_{20}$ hetero ring group; a $C_3$-$C_{60}$ alkylsilyl group; a $C_{18}$-$C_{60}$ arylsilyl group; and a $C_8$-$C_{60}$ alkylarylsilyl group.

When the second compound is represented by one or more of chemical formula 9 and chemical formula 10, for example, the first layer includes one compound (G) represented by chemical formula 9 and one compound (H) represented by chemical formula 10, it means that all the two compounds (G, H) are included in the first compound.

When the first layer 326a includes the first compound and the second compound represented by one or more of the above chemical formulas 9 and 10, the organic electric element 320 may have a high efficiency or a long lifetime.

The second chemical compound may be one or more of the following chemical compounds.

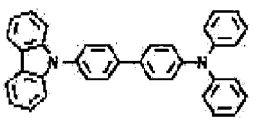

4-1

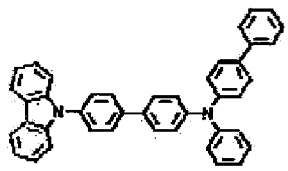

4-2

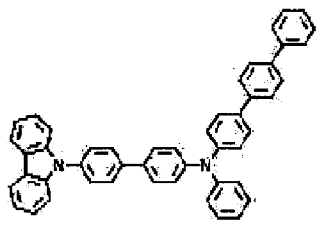

4-3

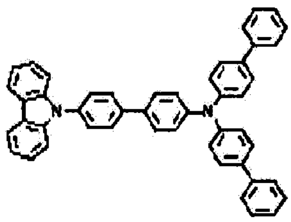

4-4

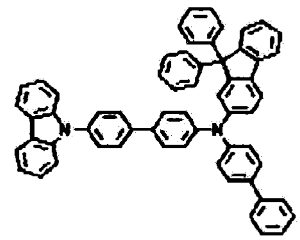

4-5

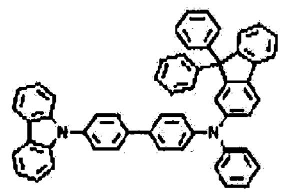

4-6

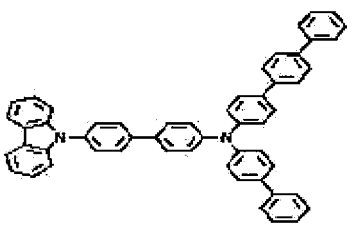

4-7

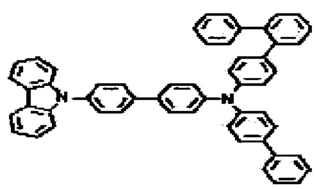

4-8

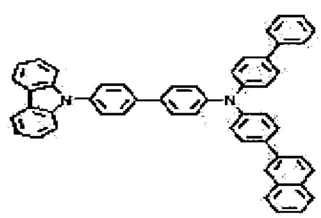

4-9

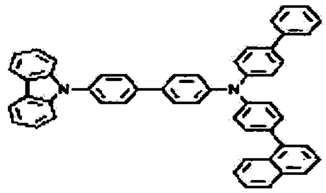

4-10

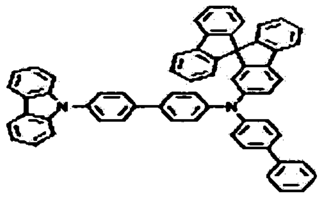

4-11

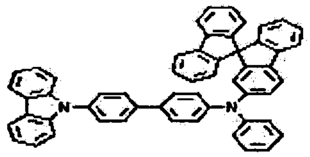

4-12

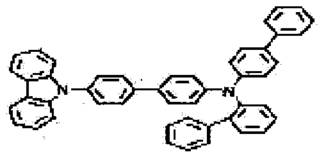

4-13

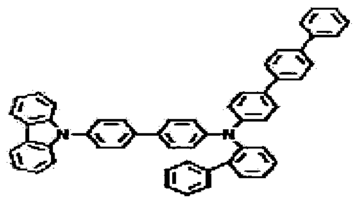

4-14

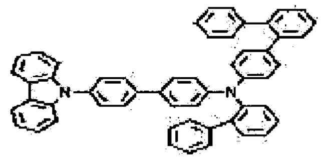

4-15

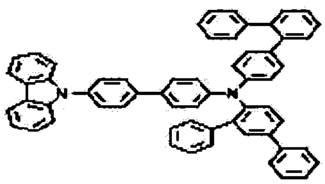

4-16

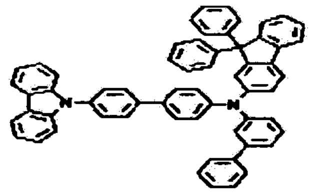

4-17

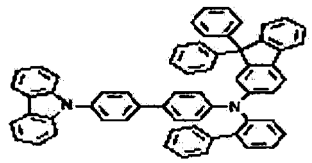

4-18

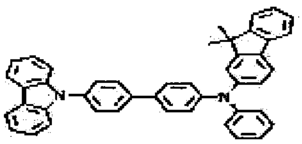

4-19

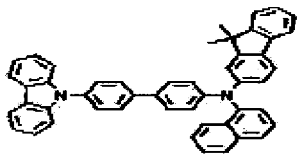

4-20

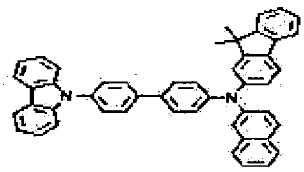

4-21

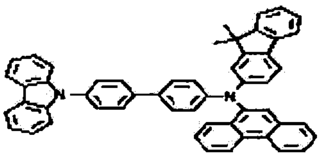

4-22

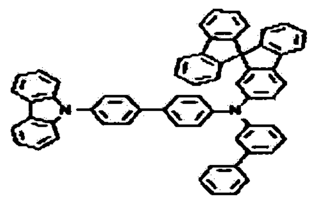

4-23

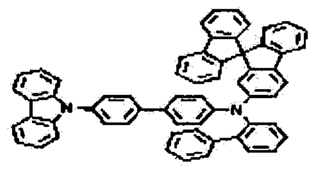

4-24

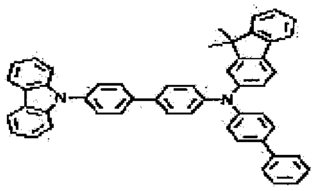

4-25

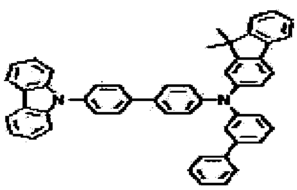

4-26

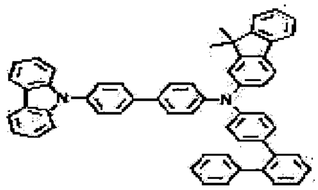

4-27

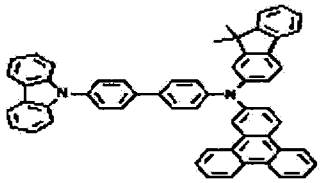

4-28

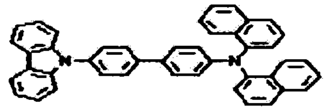

4-29

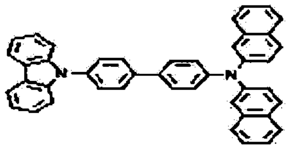

4-30

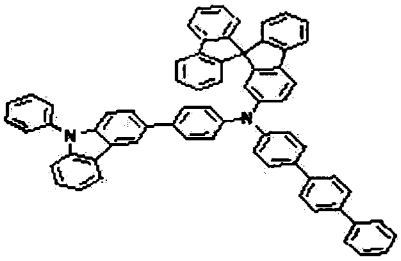

5-1

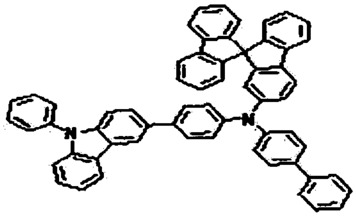

5-2

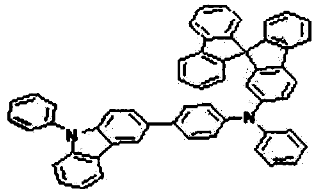

5-3

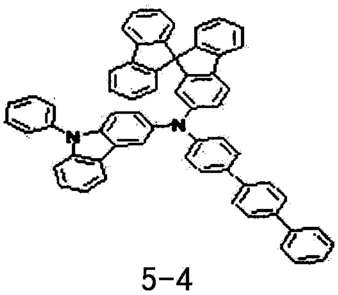

5-4

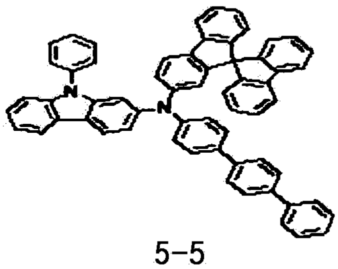

5-5

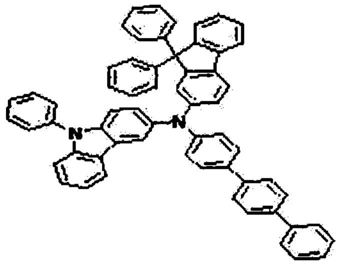

5-6

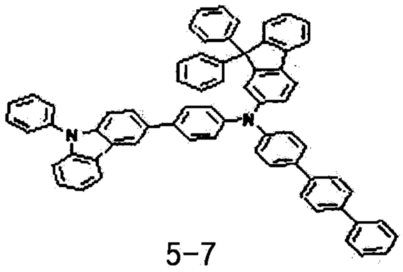

5-7

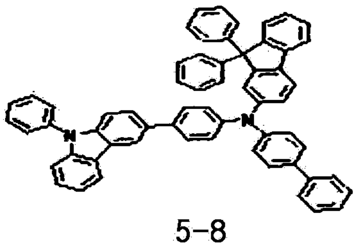

5-8

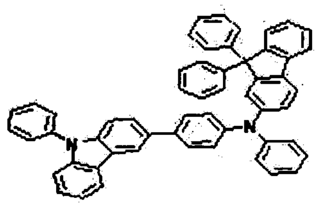

5-9

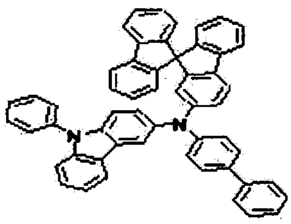

5-10

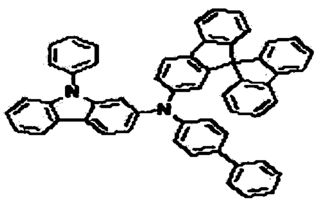

5-11

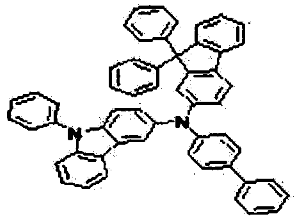

5-12

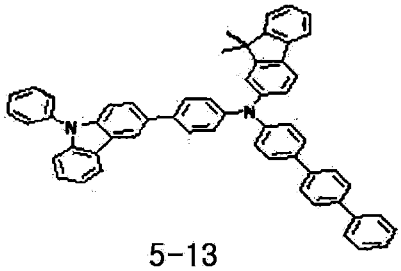

5-13

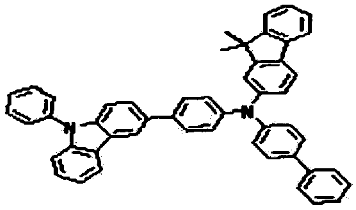

5-14

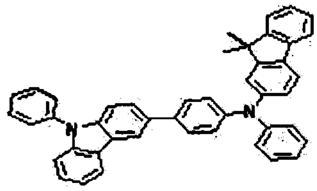

5-15

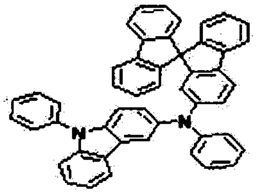

5-16

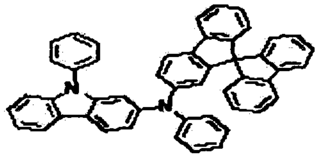

5-17

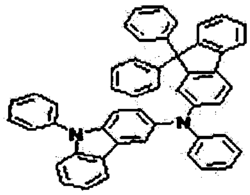

5-18

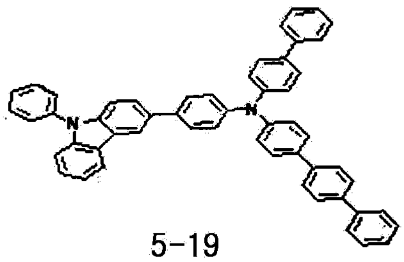

5-19

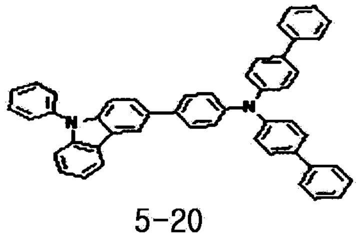

5-20

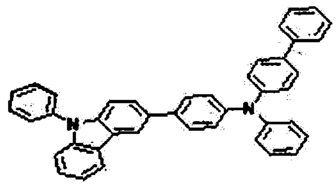

5-21

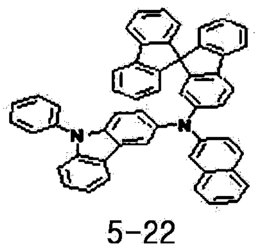

5-22

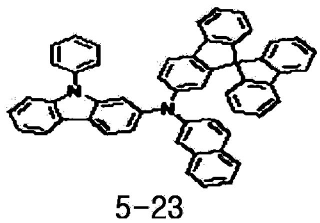

5-23

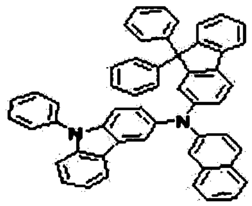

5-24

When the first layer 326a includes the second compound represented by one or more of the above chemical compounds, the organic electric element 320 may have a high efficiency or a long lifetime.

The third chemical compound is one or more of the following chemical compounds.

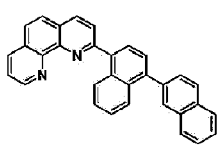

E01

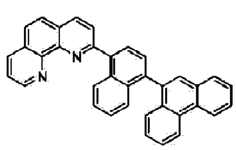

E02

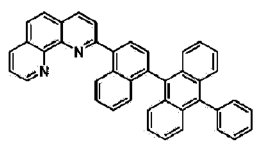

E03

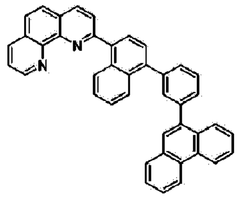

E04

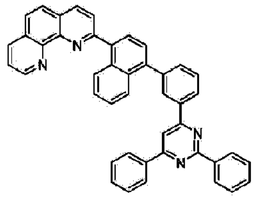

E05

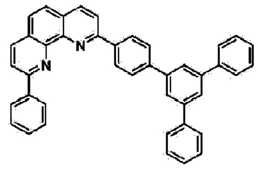

E06

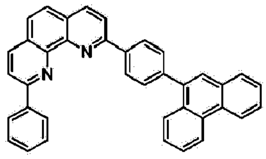

E07

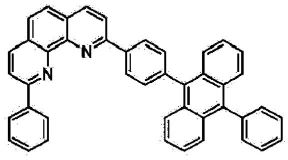

E08

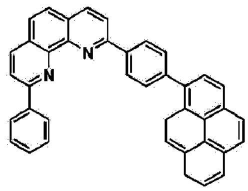

E09

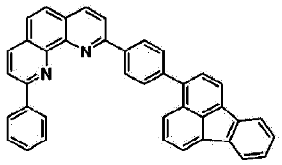

E10

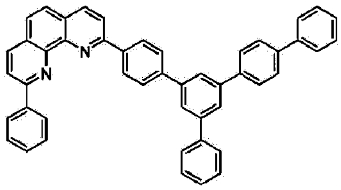

E11

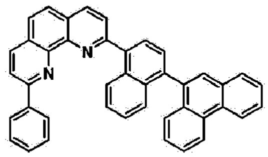

E12

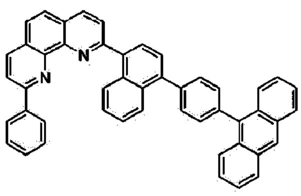

E13

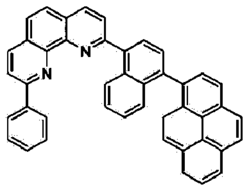

E14

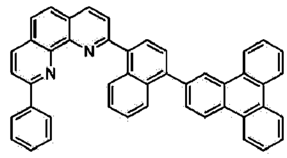

E15

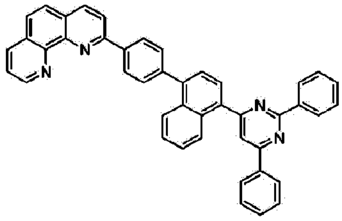

E16

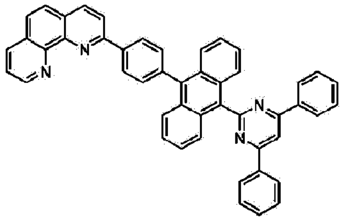

E17

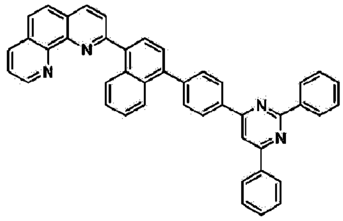

E18

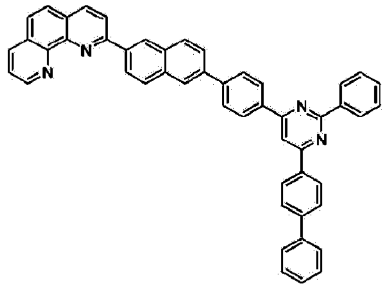
E19

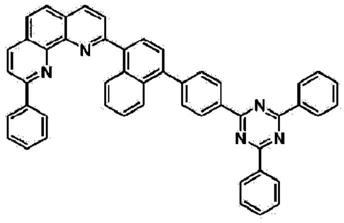
E20

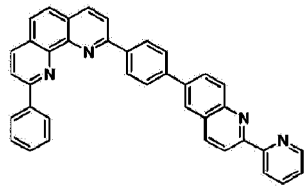
E21

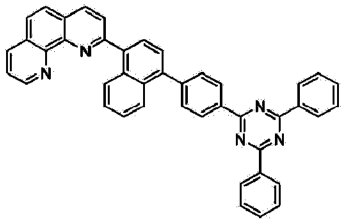
E22

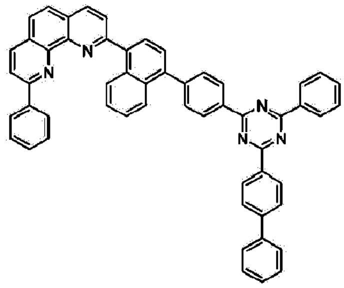
E23

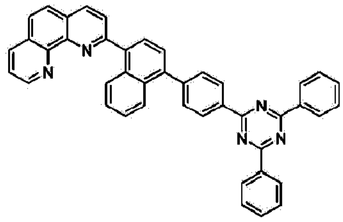
E24

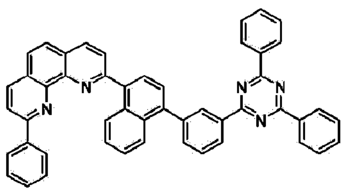
E25

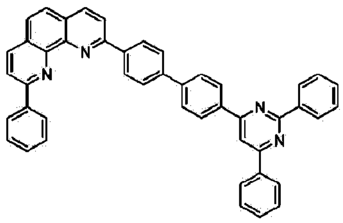
E26

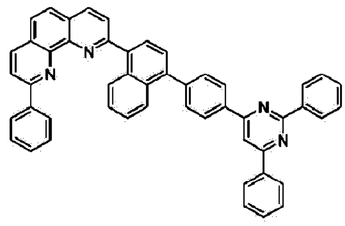
E27

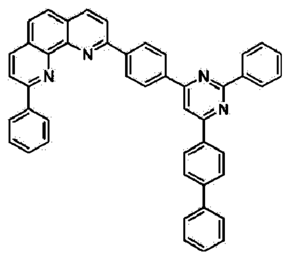
E28

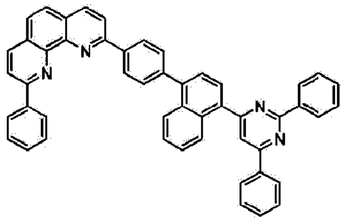
E29

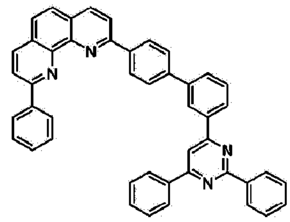
E30

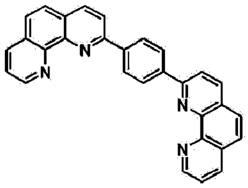

E31

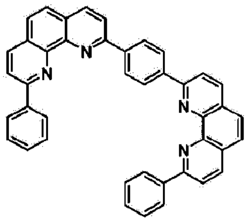

E32

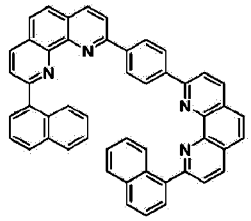

E33

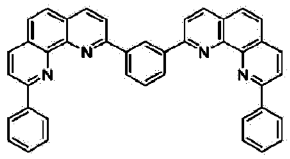

E34

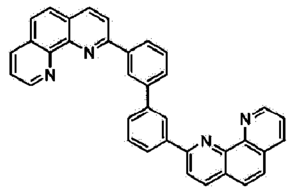

E35

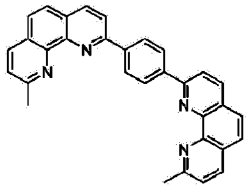

E36

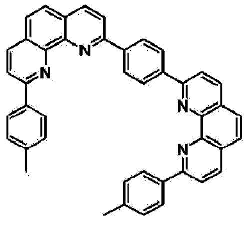

E37

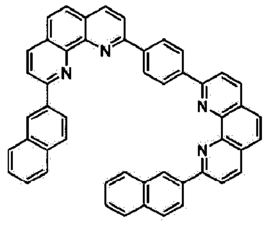

E38

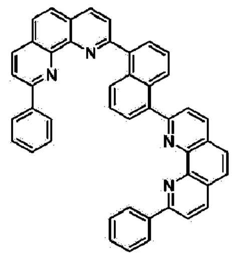

E39

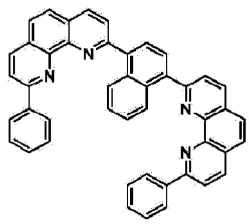

E40

When the first layer 326a includes the third compound represented by one or more of the above chemical compounds, the organic electric element 320 may have a high efficiency or a long lifetime.

The organic electric element 320 satisfies the following general formula 1.

[general formula 1]

$$L_3\text{-}L_1 \leq 2.1\ \text{eV}$$

In general formula 1, $L_3$ is the LUMO (Lowest Unoccupied Molecular Orbital) energy level of the third compound.

$L_1$ is the LUMO energy level of the first compound.

The upper limit of $L_3$-$L_1$ defined in general formula 1 may be 2.0 eV or less, or, more preferably, 1.8 eV or less.

The organic electric device 320 includes a first layer including a first compound satisfying the general formula 1 so that it may have a high efficiency or a long lifetime.

The organic electric element 320 satisfies the following general formula 2.

[general formula 2]

$$L_3\text{-}H_2 \leq 2.8 \text{ eV}$$

In general formula 2, $L_3$ is the LUMO (Lowest Unoccupied Molecular Orbital) energy level of the third compound.

Hz is the HOMO (Highest Occupied Molecular Orbital) energy level of the second compound.

The upper limit of $L_3$-$H_2$ defined in general formula 2 may be 2.6 eV or less, or, more preferably, 2.4 eV or less.

The organic electric device 320 includes the first and the second layers including the second and the third compounds satisfying the general formula 2 so that it may have a high efficiency or a long lifetime.

The organic electric element 320 satisfies the following general formula 3.

[general formula 3]

$$0.32\text{eV} \leq L_1\text{-}H_2 \leq 0.8 \text{ eV}$$

In general formula 3, $L_1$ is the LUMO (Lowest Unoccupied Molecular Orbital) energy level of the first compound.

Hz is the HOMO (Highest Occupied Molecular Orbital) energy level of the second compound.

The lower limit of $L_1$-$H_2$ defined in general formula 3 may be 0.32 eV or more, more preferably 0.34 eV or more, even more preferably 0.38 eV or more.

The upper limit of $L_1$-$H_2$ defined in general formula 3 may be 0.8 eV or less, preferably 0.65 eV or less, even more preferably 0.50 eV or less.

When the organic electric device 320 comprises a first layer including the first and the second compounds satisfying the general formula 3, it may have a high efficiency or a long lifetime.

The first compound included in the first layer 326a may be a dopant, and the second compound may be a host compound. Since the first layer 326a includes the above-described first compound as the dopant and the above-described second compound as the host, the first layer 326a has excellent hole transport properties so that the organic electric element may have an excellent efficiency and a long lifetime.

The first compound may be doped at the ratio of 10% to 50% by weight into the first layer 326a. When the first compound satisfies the above ratio, the first layer has excellent hole transport properties so that the organic electric element may have excellent efficiency and lifespan.

The thickness of the first layer 326a is not particularly limited, but may be, for example, 50 Å to 500 Å.

The thickness of the second layer 326b is not particularly limited, but may be, for example, 50 Å to 500Å.

The hole injection layer 327 may include a fourth compound and a fifth compound.

Details of the fourth compound are the same as those described for the first compound described above, unless otherwise specified. Accordingly, the fourth compound may be represented by one or more of chemical formulas 1 and 2. In addition, the fourth compound may be represented by one or more of Formula 5 and Formula 6, or may be represented by one or more of Formula 7 and Formula 8. That is, what has been described for the first compound is also applicable to the fourth compound.

However, the specific fourth compound included in the organic electric element 320 according to the embodiments may be different from the first compound or may be the same as the first compound.

Details of the fifth compound are the same as those described for the second compound described above, unless otherwise specified. Therefore, the fifth compound may be represented by chemical formula 3 described above. That is, what has been described for the second compound is also applicable to the fifth compound.

However, the specific fifth compound included in the organic electric element 320 according to embodiments of the present invention may be different from the second compound or may be the same as the second compound.

Since the organic electric element 320 includes a hole injection layer 327 including a fourth compound and a fifth compound, it may have high efficiency or a long lifetime.

In addition, the fourth compound included in the hole injection layer 327 may be a dopant, and the fifth compound

may be a host compound. The hole injection layer 327 includes the above-described fourth compound as the dopant, and the fifth compound as the host, so that the hole injection layer 327 has excellent hole injection characteristics and that the organic electric element may have excellent efficiency and a long lifetime.

The fourth compound may be doped at a ratio of 10% to 50% by weight into the hole injection layer 327. When the fourth compound is doped to satisfy the above ratio, the hole injection layer 327 has excellent hole injection characteristics, so that the organic electric element may have excellent efficiency and a long lifetime.

The thickness of the hole injection layer 327 is not particularly limited, but may be, for example, 50 Å to 500 Å.

Other embodiments of the present invention may provide a display panel 110.

The display panel 110 includes a sub-pixel 111 including the above-described organic electric element 220.

In the display panel 110 according to the present embodiment, since the organic electrical element 220 is the same as the organic electrical element 320 according to the above-described embodiments, a description thereof will be omitted.

In addition, since the display panel 110 and the sub-pixel 111 according to the embodiments have been described above, a description thereof will be omitted.

Other embodiments of the present invention 100 may provide a display device.

The display device 100 includes the above-described display panel 110 and a driving circuit for driving the above-described display panel 110.

In the display device 100 according to the present embodiments, the display panel 110 is the same as the display panel 110 according to the above-described embodiments, so a description thereof will be omitted.

In addition, since the driving circuit for driving the display panel according to embodiments has been described above, a description thereof will be omitted.

Hereinafter, examples of manufacturing an organic electric element according to the embodiments will be specifically described with reference to the embodiment, but the embodiments are not limited to the following examples.

## Manufacturing evaluation of organic electric element

### Comparative Example 1

After washing a glass substrate coated with ITO (indium tin oxide) to a thickness of 1,000 Å, the substrate is washed with a solvent such as isopropyl alcohol, acetone or methanol and dried. On this prepared ITO transparent electrode, NPD(N, N'-Di(1-naphthyl)-N,N'-diphenyl-(1,1'-biphenyl)-4,4'-diamine) is used as the fifth compound, F4-TCNQ (2,3,5,6-tetrafluoro-tetracyanoquinodimethane) was doped with 10% as the fourth compound and thermally vacuum-deposited to form a hole injection layer of 10nm. A first hole transport layer (HTL1) was formed by thermal vacuum deposition of a hole transport material (NPD) of 100 nm.

Subsequently, a second hole transport layer (HTL2) was formed by thermal vacuum deposition of a hole transport material (TCTA, Tris(4-carbazoyl-9-ylphenyl) amine) to a thickness of 100 nm. After that, ADN(9,10-di(naphtha-2-yl)anthracene) and 1,6-Bis (diphenylamine)pyrene were used as host and dopant materials, respectively, doped with 3%, and thermally vacuum-deposited to a thickness of 20 nm to form a first light emitting layer.

Subsequently, a first electron transport layer was formed by thermal vacuum deposition of an electron transport material (TmPyPB, 1,3,5-Tri (m-pyridin-3-ylphenyl) benzene) to a thickness of 10 nm, and Bphen(Bathophenanthroline) as the third compound was used, and Li was doped with 2% to form a second layer (n-type charge generation layer) by thermal vacuum deposition to a thickness of 20 nm.

Subsequently, NPD(N,N'-Di(1-naphthyl)-N,N'-diphenyl- (1,1'-biphenyl)-4,4'-diamine) is used as the second compound and F4-TCNQ(2,3,5,6-tetrafluoro-tetracyanoquinodimethane) was doped with 10% as the first compound and thermally vacuum-deposited to form a first layer(p-type charge generation layer) of 10 nm.

Subsequently, NPD(N,N'-Di(1-naphthyl)-N,N'-diphenyl- (1,1'-biphenyl)-4,4'-diamine) as a hole transport material was vacuum-deposited to a thickness of 20nm and then CBP (4,4'-Bis (N-carbazolyl)-1,1'-biphenyl) is used as a host and Ir(ppy)3 (tris(2-phenylpyridine)Iridium (III) was doped with 10% as a dopant. Thermal vacuum deposition was performed to form a second light emitting layer of 20 nm.

Subsequently, a second electron transport layer was formed by thermal vacuum deposition using Alq3 as an electron transport material, and then thermal vacuum deposition was performed using LiF as an electron injection material to form an electron injection layer. Subsequently, a cathode was formed by depositing Al to a thickness of 200 nm, thereby fabricating an organic electric element.

### Reference Embodiments 1 to 15 and 22 to 25, Inventive Embodiments 16 to 21 and 25 to 30 and Comparative Examples 2 to 8

The further organic electric elements were manufactured in the same manner as in Comparative Example 1,

except that the first compound, the second compound, the fourth compound, and the fifth compound were used in the types and ratios shown in Tables 1 and 2 below. Tables 3 and 4 show the performances of the manufactured organic electric elements.

[Table 1]

| | first chemical compound | second chemical compound | third chemical compound | fourth chemical compound | fifth chemical compound | $L_3$-$L_1$ (eV) | $L_3$-$H_1$ (eV) | $L_1$-$H_2$ (eV) |
|---|---|---|---|---|---|---|---|---|
| **Comparative Example 1** | F4-TCNQ(10%) | NPD | Bphen | F4-TCNQ(10%) | NPD | 2.20 | 2.50 | 0.30 |
| **Comparative Example 2** | F4-TCNQ(10%) | 4-4 | Bphen | F4-TCNQ(10%) | 4-4 | 2.20 | 2.21 | 0.01 |
| **Comparative Example 3** | F4-TCNQ(10%) | 4-9 | Bphen | F4-TCNQ(10%) | 4-9 | 2.20 | 2.22 | 0.02 |
| **Comparative Example 4** | F4-TCNQ(10%) | 4-11 | Bphen | F4-TCNQ(10%) | 4-11 | 2.20 | 2.19 | -0.01 |
| **Comparative Example 5** | F4-TCNQ(10%) | 5-2 | Bphen | F4-TCNQ(10%) | 5-2 | 2.20 | 2.20 | 0 |
| **Comparative Example 6** | F4-TCNQ(10%) | 5-8 | Bphen | F4-TCNQ(10%) | 5-8 | 2.20 | 2.20 | 0 |
| **Reference Embodiment1** | A15(10%) | NPD | Bphen | A15(10%) | NPD | 1.74 | 2.50 | 0.76 |
| **Reference Embodiment2** | A15(10%) | 4-4 | Bphen | A15(10%) | 4-4 | 1.74 | 2.21 | 0.47 |
| **Reference Embodiment3** | A15(10%) | 4-9 | Bphen | A15(10%) | 4-9 | 1.74 | 2.22 | 0.48 |
| **Reference Embodiment4** | A15(10%) | 4-11 | Bphen | A15(10%) | 4-11 | 1.74 | 2.19 | 0.45 |
| **Reference Embodiment5** | A15(10%) | 5-2 | Bphen | A15(10%) | 5-2 | 1.74 | 2.20 | 0.46 |
| **Reference Embodiment6** | A15(10%) | 5-8 | Bphen | A15(10%) | 5-8 | 1.74 | 2.20 | 0.46 |
| **Reference Embodiment7** | A38(10%) | NPD | Bphen | A38(10%) | NPD | 1.80 | 2.50 | 0.70 |
| **Reference Embodiment8** | A38(10%) | 4-4 | Bphen | A38(10%) | 4-4 | 1.80 | 2.21 | 0.41 |

(continued)

| | first chemical compound | second chemical compound | third chemical compound | fourth chemical compound | fifth chemical compound | $L_3$-$L_1$ (eV) | $L_3$-$H_1$ (eV) | $L_1$-$H_2$ (eV) |
|---|---|---|---|---|---|---|---|---|
| **Reference Embodiment9** | A38(10%) | 4-9 | Bphen | A38(10%) | 4-9 | 1.80 | 2.22 | 0.42 |
| **Reference Embodiment10** | A38(10%) | 4-11 | Bphen | A38(10%) | 4-11 | 1.80 | 2.19 | 0.39 |
| **Reference Embodiment11** | A38(10%) | 5-2 | Bphen | A38(10%) | 5-2 | 1.80 | 2.20 | 0.40 |
| **Reference Embodiment12** | A38(10%) | 5-8 | Bphen | A38(10%) | 5-8 | 1.80 | 2.20 | 0.40 |

[Table 2]

| | first chemical compound | second chemical compound | third chemical compound | fourth chemical compound | fifth chemical compound | $L_3$-$L_1$ (eV) | $L_3$-$H_1$ (eV) | $L_1$-$H_2$ (eV) |
|---|---|---|---|---|---|---|---|---|
| **Comparative Example 1** | F4-TCNQ (10%) | NPD | Bphen | F4-TCNQ (10%) | NPD | 2.20 | 2.50 | 0.30 |
| **Comparative Example 7** | F4-TCNQ (20%) | NPD | Bphen | F4-TCNQ (20%) | NPD | 2.20 | 2.50 | 0.30 |
| **Comparative Example 8** | F4-TCNQ (30%) | NPD | Bphen | F4-TCNQ (30%) | NPD | 2.20 | 2.50 | 0.30 |
| **Reference Embodiment 1** | A15 (10%) | NPD | Bphen | A15 (10%) | NPD | 1.74 | 2.50 | 0.76 |
| **Reference Embodiment 13** | A15 (20%) | NPD | Bphen | A15 (20%) | NPD | 1.74 | 2.50 | 0.76 |
| **Reference Embodiment 14** | A15 (30%) | NPD | Bphen | A15 (30%) | NPD | 1.74 | 2.50 | 0.76 |
| **Reference Embodiment 15** | A15 (10%) | NPD | E05 | A15 (10%) | NPD | 1.68 | 2.44 | 0.76 |
| **Reference Embodiment 4** | A15 (10%) | 4-11 | Bphen | A15 (10%) | 4-11 | 1.74 | 2.19 | 0.45 |
| **Embodiment 16** | A15 (10%) | 4-11 | E05 | A15 (10%) | 4-11 | 1.68 | 2.19 | 0.45 |
| **Embodiment 17** | A15 (20%) | 4-11 | E05 | A15 (20%) | 4-11 | 1.68 | 2.19 | 0.45 |
| **Embodiment 18** | A15 (30%) | 4-11 | E05 | A15 (30%) | 4-11 | 1.68 | 2.19 | 0.45 |
| **Embodiment 19** | A15 (10%) | 5-8 | E27 | A15 (10%) | 5-8 | 1.62 | 2.20 | 0.40 |
| **Embodiment 20** | A15 (20%) | 5-8 | E27 | A15 (20%) | 5-8 | 1.62 | 2.20 | 0.40 |
| **Embodiment 21** | A15 (30%) | 5-8 | E27 | A15 (30%) | 5-8 | 1.62 | 2.20 | 0.40 |
| **Reference Embodiment 7** | A38 (10%) | NPD | Bphen | A38 (10%) | NPD | 1.80 | 2.50 | 0.70 |
| **Reference Embodiment 22** | A38 (20%) | NPD | Bphen | A38 (20%) | NPD | 1.80 | 2.50 | 0.70 |
| **Reference Embodiment 23** | A38 (30%) | NPD | Bphen | A38 (30%) | NPD | 1.80 | 2.50 | 0.70 |

(continued)

| | first chemical compound | second chemical compound | third chemical compound | fourth chemical compound | fifth chemical compound | $L_3$-$L_1$ (eV) | $L_3$-$H_1$ (eV) | $L_1$-$H_2$ (eV) |
|---|---|---|---|---|---|---|---|---|
| **Reference Embodiment 24** | A38 (10%) | NPD | E05 | A38 (10%) | NPD | 1.74 | 2.44 | 0.70 |
| **Reference Embodiment 10** | A38 (10%) | 4-11 | Bphen | A38 (10%) | 4-11 | 1.80 | 2.19 | 0.39 |
| **Embodiment 25** | A38 (10%) | 4-11 | E05 | A38 (10%) | 4-11 | 1.74 | 2.19 | 0.39 |
| **Embodiment 26** | A38 (20%) | 4-11 | E05 | A38 (20%) | 4-11 | 1.74 | 2.19 | 0.39 |
| **Embodiment 27** | A38 (30%) | 4-11 | E05 | A38 (30%) | 4-11 | 1.74 | 2.19 | 0.39 |
| **Embodiment 28** | A38 (10%) | 5-8 | E27 | A38 (10%) | 5-8 | 1.68 | 2.20 | 0.40 |
| **Embodiment 29** | A38 (20%) | 5-8 | E27 | A38 (20%) | 5-8 | 1.68 | 2.20 | 0.40 |
| **Embodiment 30** | A38 (30%) | 5-8 | E27 | A38 (30%) | 5-8 | 1.68 | 2.20 | 0.40 |

In Tables 1 and 2, A15 and A38 are the A15 and A38 chemical compounds described as being selectable as the first chemical compound, and 4-4, 4-9, 4-11, 5-2 and 5-8 are the 4-4, 4-9, 4-11, 5-2 and 5-8 chemical compounds described as being selectable as the second chemical compounds, and E05 and E27 are the E05 and E27 chemical compounds described as being selectable as the third chemical compounds. F4-TCNQ is as follows.

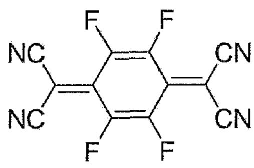

F4-TCNQ

[Table 3]

| | driving voltage (V) | efficiency (cd/A) | color coordinate (CIE x, y) | | lifespan (T95, hr) |
|---|---|---|---|---|---|
| **Comparative Example 1** | 10.7 | 55.6 | 0.315 | 0.336 | 327 |
| **Comparative Example 2** | 10.2 | 57.2 | 0.32 | 0.334 | 315 |
| **Comparative Example 3** | 10.5 | 56.8 | 0.318 | 0.329 | 346 |
| **Comparative Example 4** | 9.8 | 57.5 | 0.322 | 0.336 | 351 |
| **Comparative Example 5** | 10.2 | 56.9 | 0.325 | 0.333 | 338 |
| **Comparative Example 6** | 10.1 | 57.6 | 0.321 | 0.34 | 340 |
| **Reference Embodiment1** | 9.6 | 59.5 | 0.324 | 0.339 | 426 |
| **Reference Embodiment2** | 9.1 | 60 | 0.32 | 0.347 | 521 |
| **Reference Embodiment3** | 8.8 | 64.5 | 0.315 | 0.338 | 538 |
| **Reference Embodiment4** | 8.3 | 62.2 | 0.322 | 0.331 | 526 |
| **Reference Embodiment5** | 8.2 | 61.8 | 0.322 | 0.342 | 510 |
| **Reference Embodiment6** | 8.4 | 64.4 | 0.321 | 0.341 | 542 |
| **Reference Embodiment7** | 9.5 | 59.7 | 0.321 | 0.34 | 461 |
| **Reference Embodiment8** | 8.9 | 60.2 | 0.321 | 0.342 | 518 |
| **Reference Embodiment9** | 8.6 | 64.9 | 0.32 | 0.34 | 532 |
| **Reference Embodiment10** | 8.2 | 62.7 | 0.322 | 0.341 | 527 |
| **Reference Embodiment11** | 8.2 | 62.2 | 0.322 | 0.343 | 515 |
| **Reference Embodiment12** | 8.3 | 65 | 0.321 | 0.34 | 539 |

[Table 4]

| | driving voltage (V) | efficiency (cd/A) | color coordinate (CIE x, y) | | lifespan (T95, hr) |
|---|---|---|---|---|---|
| **Comparative Example 1** | 10.7 | 55.6 | 0.315 | 0.336 | 327 |
| **Comparative Example 7** | 10.1 | 55.7 | 0.32 | 0.338 | 279 |
| **Comparative Example 8** | 9.8 | 54.7 | 0.324 | 0.351 | 217 |
| **Reference Embodiment 1** | 9.6 | 59.5 | 0.324 | 0.339 | 426 |

(continued)

| | driving voltage | efficiency | color coordinate | | lifespan |
|---|---|---|---|---|---|
| | (V) | (cd/A) | (CIE x, y) | | (T95, hr) |
| **Reference Embodiment 13** | 9.6 | 59.8 | 0.319 | 0.335 | 415 |
| **Reference Embodiment 14** | 9.5 | 58.4 | 0.32 | 0.34 | 432 |
| **Reference Embodiment 15** | 9 | 60.3 | 0.323 | 0.337 | 453 |
| **Reference Embodiment 4** | 8.3 | 62.2 | 0.322 | 0.331 | 526 |
| **Embodiment 16** | 8.3 | 62.2 | 0.322 | 0.331 | 526 |
| **Embodiment 17** | 7.8 | 62.4 | 0.322 | 0.331 | 515 |
| **Embodiment 18** | 7.6 | 62.1 | 0.322 | 0.331 | 473 |
| **Embodiment 19** | 8.4 | 64.4 | 0.321 | 0.345 | 542 |
| **Embodiment 20** | 8 | 64.2 | 0.321 | 0.341 | 537 |
| **Embodiment 21** | 7.8 | 63.9 | 0.321 | 0.347 | 488 |
| **Reference Embodiment 7** | 9.5 | 59.7 | 0.321 | 0.34 | 461 |
| **Reference Embodiment 22** | 9.1 | 62.3 | 0.325 | 0.336 | 327 |
| **Reference Embodiment 23** | 9 | 62.6 | 0.322 | 0.334 | 330 |
| **Reference Embodiment 24** | 8.9 | 63 | 0.321 | 0.331 | 341 |
| **Reference Embodiment 10** | 8.2 | 62.7 | 0.322 | 0.342 | 527 |
| **Embodiment 25** | 8.2 | 62.7 | 0.322 | 0.342 | 527 |
| **Embodiment 26** | 7.7 | 62.5 | 0.322 | 0.341 | 516 |
| **Embodiment 27** | 7.4 | 62.5 | 0.322 | 0.341 | 480 |
| **Embodiment 28** | 8.2 | 65 | 0.321 | 0.34 | 539 |
| **Embodiment 29** | 7.6 | 65.2 | 0.321 | 0.342 | 534 |
| **Embodiment 30** | 7.3 | 64.8 | 0.321 | 0.344 | 501 |

As can be seen from the results of Tables 3 and 4, the organic electric elements according to the Inventive Embodiments which comprise a charge generating layer with a first layer including the first compound and the second compound and a second layer including the third compound have excellent efficiency and lifespan compared to the organic electric elements of the Comparative Examples.

In the case of Reference Embodiments 1 and 7 including a first layer including a first compound represented by at least one of chemical formula 1 and chemical formula 2, efficiency and lifespan is improved compared to the organic electric elements of the Comparative Embodiments.

In addition, compared to the Reference Embodiments 1 and 7, it can be seen that the organic electric elements of the Embodiments including a first layer that further comprises the second compound represented by chemical formula 3 (e.g. Reference Embodiment 4 and Embodiment 10) have a better efficiency and a longer lifespan than the organic electric elements of Reference Embodiments 1 and 7. In addition, it can be seen that the organic electric elements of the Embodiments comprising a second layer that contains the third compound represented by chemical formula 4 (e.g. Reference Embodiment 15 and Reference Embodiment 24) have a better efficiency or a longer lifespan than the organic electric elements of Reference Embodiments 1 and 7. In addition, it can be seen that the organic electric elements of the Embodiments comprising a first layer that further contains a second compound represented by chemical formula 3 and a second layer that contains a third compound represented by chemical formula 4 (e.g. Inventive Embodiments 16-21 and Inventive Embodiments 25-30) have a better efficiency and a longer lifetime than the organic electric elements of Reference Embodiments 1 and 7.

Accordingly, it can be seen that the feature which demands that the first layer contains a first compound represented by one or more of chemical formulas 1 and 2 and a second compound represented by chemical formula 3, and the feature which demands that the second layer contains a third compound represented by chemical formula 4 provide synergistic effects and assist with providing an improved organic electric element.

Further, in the Comparative Examples 1, 7, and 8, neither efficiency nor lifespan increased when the doping ratio of the p-type doping material was increased. In the Inventive Embodiments (i.e. Embodiments 15-21 and 24-30), however, when the doping ratio of the first chemical compound that is the p-type doping material was increased, it can be seen that the organic electric element is improved in terms of the driving voltage, efficiency, or lifespan.

## Claims

**1.** An organic electric element (220, 320) comprising:

a first electrode (221, 321);
a second electrode (223, 323); and
an organic layer (222, 322) positioned between the first electrode (221, 321) and the second electrode (223, 323), wherein the organic layer (222, 322) comprises a first stack (324) comprising a first emitting layer (324a), a second stack (325) comprising a second emitting layer (325a), and a charge generating layer (326) positioned between the first stack (324) and the second stack (325),
the charge generating layer (326) comprises a first layer (326a) and a second layer (326b),
the first layer (326a) comprises a first compound represented by one or more of the following chemical formula 1 and chemical formula 2 and a second compound, and
the second layer (326b) comprises a third compound,
wherein chemical formula 1 and chemical formula 2 are as follows:

[chemical formula 1]

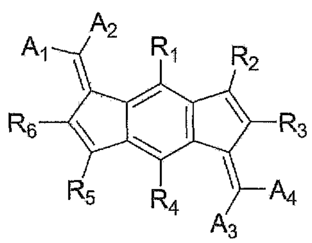

[chemical formula 2]

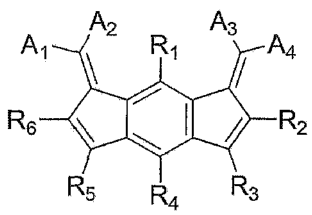

wherein in chemical formula 1 and chemical formula 2,
$R_1$ to $R_6$, which are same or different, are each independently one selected from the group consisting of a hydrogen; a deuterium; a tritium; a halogen; a cyano group; a nitro group; a $C_6$-$C_{60}$ aryl group; a fluorenyl group; a $C_2$-$C_{60}$ hetero ring group containing at least one hetero atom from O, N, S, Si and P; a fused ring group of a $C_3$-$C_{60}$ aliphatic ring and a $C_6$-$C_{60}$ aromatic ring; a $C_1$-$C_{50}$ alkyl group; a $C_2$-$C_{20}$ alkenyl group; a $C_2$-$C_{20}$ alkynyl group; a $C_1$-$C_{30}$ alkoxy group; a $C_6$-$C_{30}$ aryloxy group; a $C_3$-$C_{60}$ alkylsilyl group; a $C_{18}$-$C_{60}$ arylsilyl group; and a $C_8$-$C_{60}$ alkylarylsilyl group, and one or more of $R_1$ to $R_6$ is the cyano group,
$A_1$ to $A_4$, which may be the same or different, are each independently one selected from the group consisting of a hydrogen; a deuterium; a tritium; a halogen; a cyano group; a nitro group; a $C_6$-$C_{60}$ aryl group; a fluorenyl group; a $C_2$-$C_{60}$ hetero ring group containing at least one hetero atom from O, N, S, Si and P; a fused ring group of a $C_3$-$C_{60}$ aliphatic ring and a $C_6$-$C_{60}$ aromatic ring; a $C_1$-$C_{50}$ alkyl group; a $C_2$-$C_{20}$ alkenyl group; a $C_2$-$C_{20}$ alkynyl group; a $C_1$-$C_{30}$ alkoxy group; a $C_6$-$C_{30}$ aryloxy group; a $C_3$-$C_{60}$ alkylsilyl group; a $C_{18}$-$C_{60}$ arylsilyl group; and a $C_8$-$C_{60}$ alkylarylsilyl group,
and wherein in $R_1$ to $R_6$ and $A_1$ to $A_4$ of chemical formula 1 and chemical formula 2, the aryl group, the fluorenyl group, the hetero ring group, the fused ring group, the allcyl group, the alkenyl group, the alkynyl group, the

alkoxy group, the aryloxy group, the alkylsilyl group, the arylsilyl group and the alkylarylsilyl group may each be further substituted with at least one substituent selected from the group consisting of a deuterium; a nitro group; a cyano group; a halogen; an amino group; a $C_1$-$C_{20}$ alkoxyl group; a $C_1$-$C_{20}$ alkyl group; a $C_2$ - $C_{20}$ alkenyl group; a $C_2$-$C_{20}$ alkynyl group; a $C_6$-$C_{20}$ aryl group; a $C_6$-$C_{20}$ aryl group substituted with the deuterium; a fluorenyl group; a $C_2$-$C_{20}$ hetero ring group; a $C_3$-$C_{60}$ alkylsilyl group; a $C_{18}$-$C_{60}$ arylsilyl group; and a $C_8$-$C_{60}$ alkylarylsilyl group,

wherein the second chemical compound is represented by one or more of the following chemical formula 9 and formula 10:

[chemical formula 9]

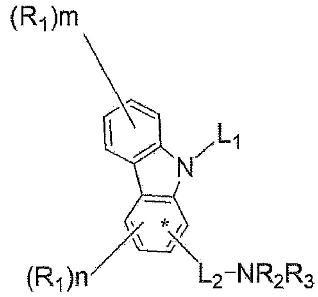

[chemical formula 10]

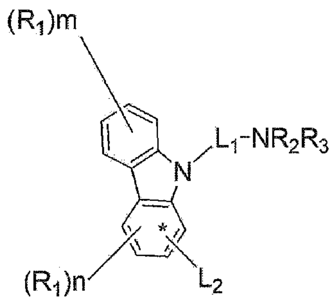

wherein in chemical formula 9 and chemical formula 10,

m, n and $R_1$ to $R_3$ are the same as m, n and $R_1$ in chemical formula 3,

$L_1$ is one selected from the group consisting of a $C_6$-$C_{60}$ aryl group; a fluorenyl group; a $C_2$-$C_{60}$ hetero ring group containing at least one hetero atom from O, N, S, Si and P; a fused ring group of a $C_3$-$C_{60}$ aliphatic ring and a $C_6$-$C_{60}$ aromatic ring,

$L_2$ is one selected from the group consisting of a $C_6$-$C_{60}$ arylene group; a fluorylene group; a $C_2$-$C_{60}$ divalent hetero ring group containing at least one heteroatom from O, N, S, Si and P; a divalent fused ring group of a $C_3$-$C_{60}$ aliphatic ring and a $C_6$-$C_{60}$ aromatic ring; a $C_1$-$C_{50}$ alkylene group; a $C_2$-$C_{20}$ alkenylene group; and a $C_2$-$C_{20}$ alkynylene group,

and wherein in chemical formula 10,

m, n and $R_1$ to $R_3$ are the same as m, n and $R_1$ in chemical formula 3,

$L_1$ is one selected from the group consisting of a $C_6$-$C_{60}$ arylene group; a fluorylene group; a $C_2$-$C_{60}$ divalent hetero ring group containing at least one heteroatom from O, N, S, Si and P; a divalent fused ring group of a $C_3$-$C_{60}$ aliphatic ring and a $C_6$-$C_{60}$ aromatic ring; a $C_1$-$C_{50}$ alkylene group; a $C_2$-$C_{20}$ alkenylene group; and a $C_2$-$C_{20}$ allcynylene group,

$L_2$ is one selected from the group consisting of a $C_6$-$C_{60}$ aryl group; a fluorenyl group; a $C_2$-$C_{60}$ hetero ring group containing at least one hetero atom from O, N, S, Si and P; a fused ring group of a $C_3$-$C_{60}$ aliphatic ring and a $C_6$-$C_{60}$ aromatic ring, and

wherein in $R_1$ to $R_3$, $L_1$ and $L_2$ of chemical formula 9 and chemical formula 10, the aryl group, the fluorenyl group, the hetero ring group, the fused ring group, the allcyl group, the alkenyl group, the alkynyl group, the alkoxy group, the aryloxy group, the alkylsilyl group, the arylsilyl group, the alkylarylsilyl group, the arylene

group, the fluorylene group, and the divalent fused ring group may each be further substituted with at least one substituent selected from the group consisting of a deuterium; a nitro group; a cyano group; a halogen; an amino group; a $C_1$-$C_{20}$ alkoxyl group; a $C_1$-$C_{20}$ allcyl group; a $C_2$ - $C_{20}$ alkenyl group; a $C_2$-$C_{20}$ alkynyl group; a $C_6$-$C_{20}$ aryl group; a $C_6$-$C_{20}$ aryl group substituted with the deuterium; a fluorenyl group; a $C_2$-$C_{20}$ hetero ring group; a $C_3$-$C_{60}$ alkylsilyl group; a $C_{18}$-$C_{60}$ arylsilyl group; and a $C_8$-$C_{60}$ alkylarylsilyl group,
and wherein the third chemical compound is one or more of the following chemical compounds:

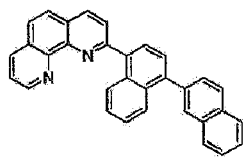
E01

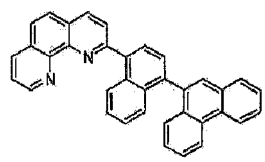
E02

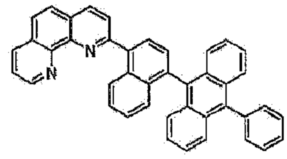
E03

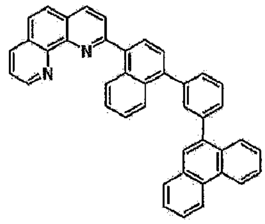
E04

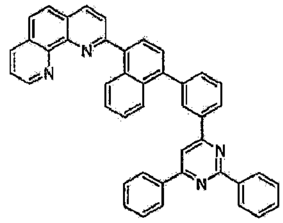
E05

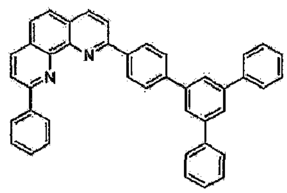
E06

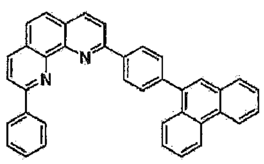
E07

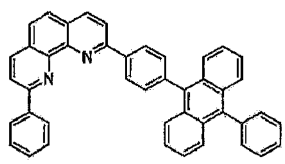
E08

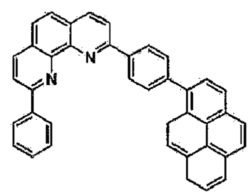
E09

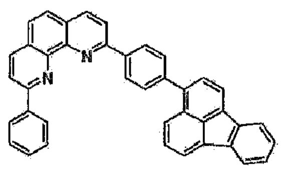
E10

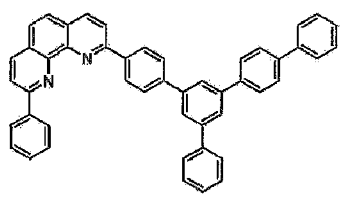
E11

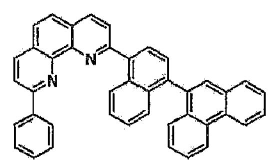
E12

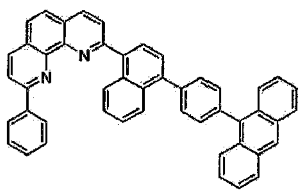
E13

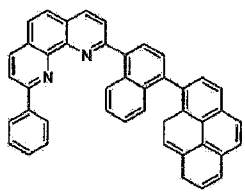
E14

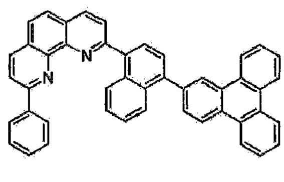
E15

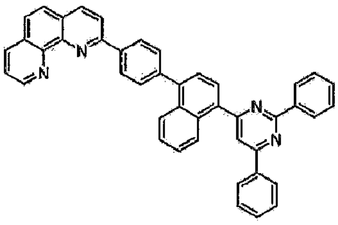
E16

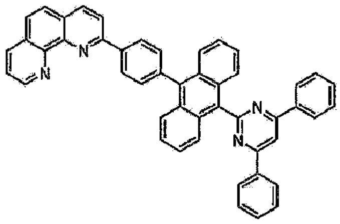
E17

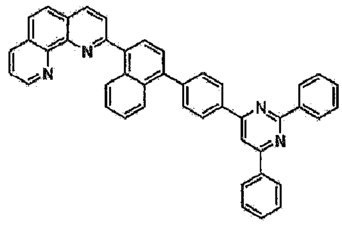
E18

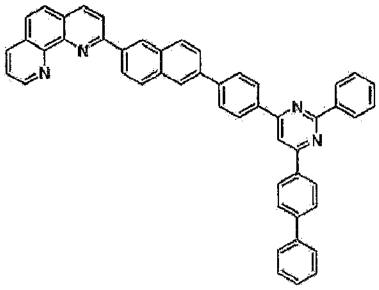
E19

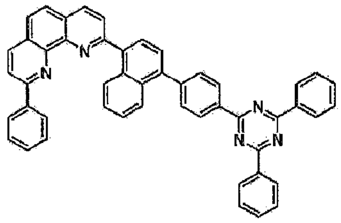
E20

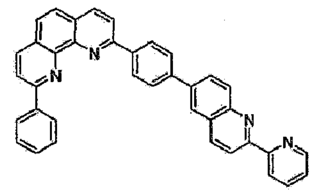
E21

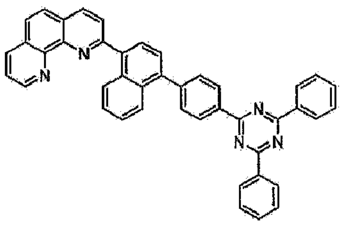
E22

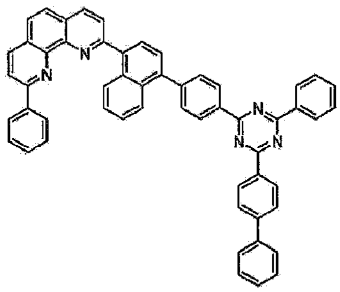
E23

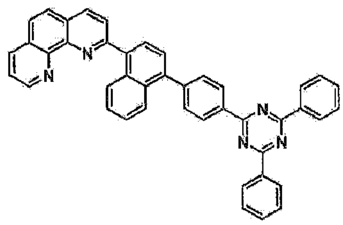
E24

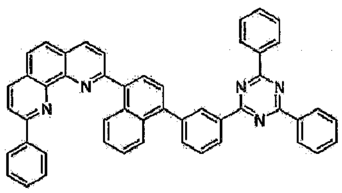
E25

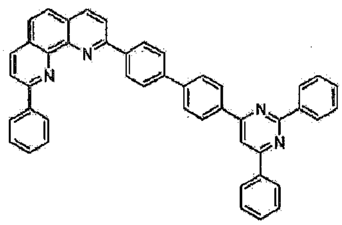
E26

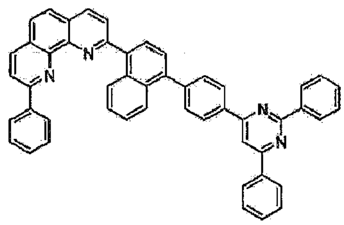
E27

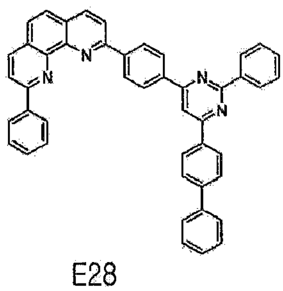
E28

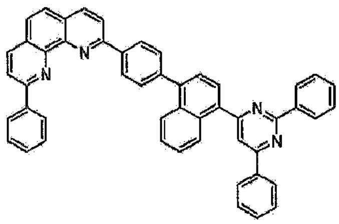
E29

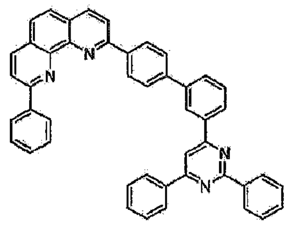
E30

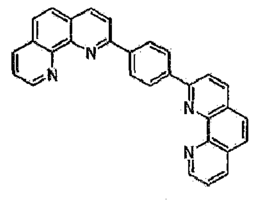
E31

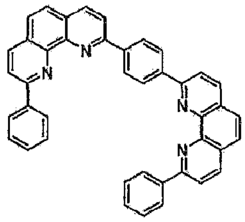
E32

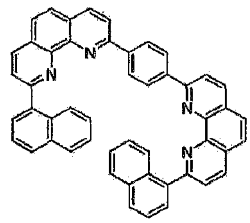
E33

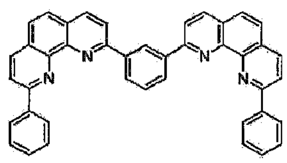
E34

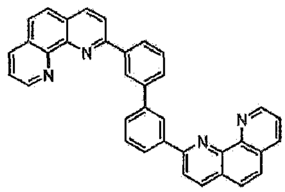
E35

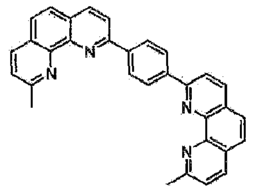
E36

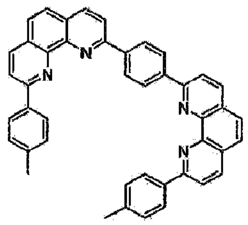
E37

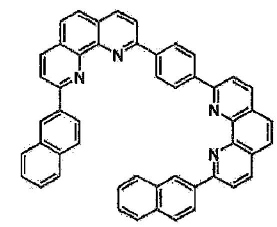
E38

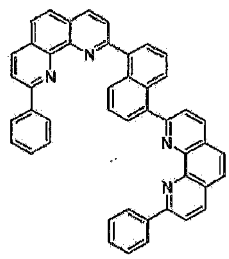
E39

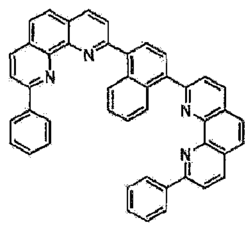
E40

**2.** The organic electric element (220, 320) according to claim 1, wherein the first chemical compound is represented by one or more of the following chemical formula 5 and chemical formula 6:

[chemical formula 5]

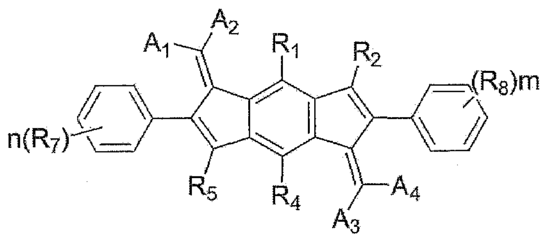

[chemical formula 6]

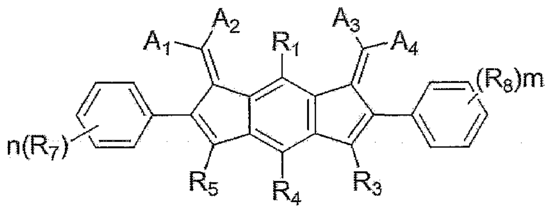

wherein in chemical formula 5 and chemical formula 6,
n and m are each independently an integer from 0 to 5,
$R_7$ to $R_8$, which may be the same or different, are each independently one selected from the group consisting of a deuterium; a tritium; a halogen; a cyano group; a $C_1$-$C_{50}$ alkyl group; and a $C_1$-$C_{30}$ alkoxy group, and wherein in $R_7$ and $R_8$ of chemical formula 5 and chemical formula 6, the alkyl group and the alkoxy group may each be further substituted with at least one substituent selected from the group consisting of a deuterium and a halogen.

**3.** The organic electric element (220, 320) according to claim 1, wherein the first chemical compound is represented by one or more of the following chemical formula 7 and formula 8:

[chemical formula 7]

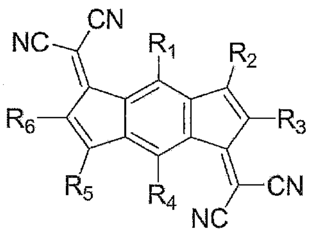

[chemical formula 8]

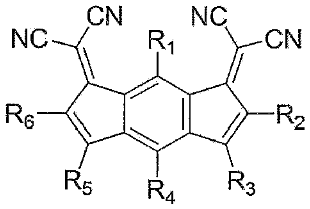

wherein in chemical formula 7 and chemical formula 8,
$R_1$ to $R_6$ are the same as $R_1$ to $R_6$ in chemical formulas 1 and 2.

**4.** The organic electric element (220, 320) according to one of the preceding claims, wherein the first chemical compound is one or more of the following chemical compounds:

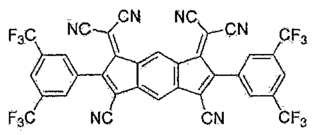

A01

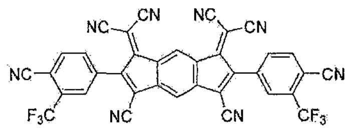

A02

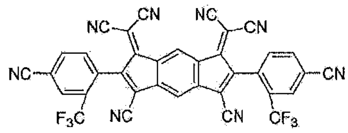

A03

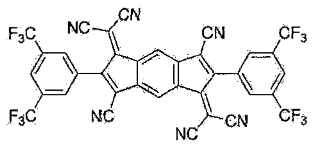

A04

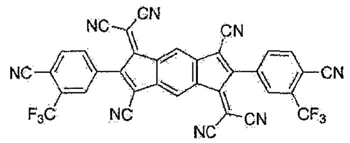

A05

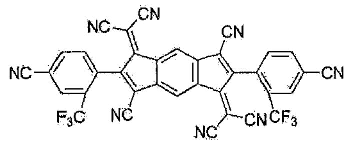

A06

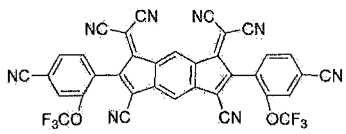

A07

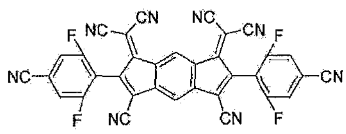

A08

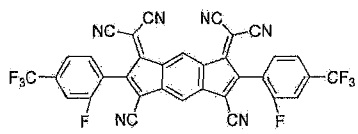

A09

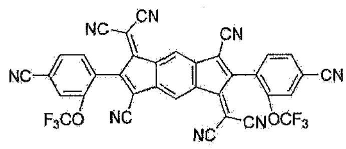

A10

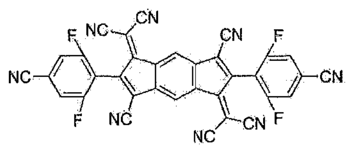

A11

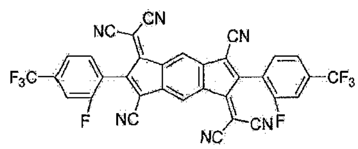

A12

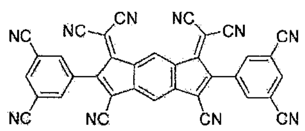

A13

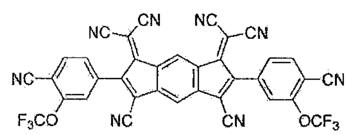

A14

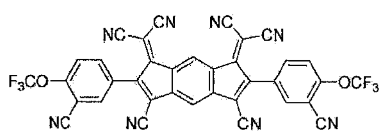

A15

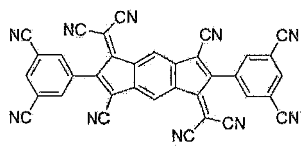

A16

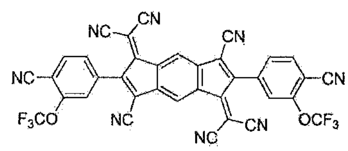

A17

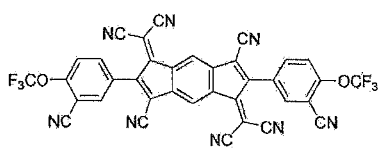

A18

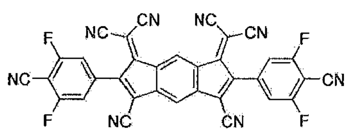

A19

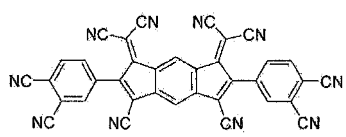

A20

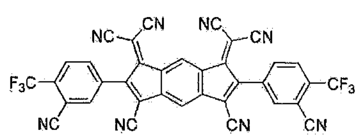

A21

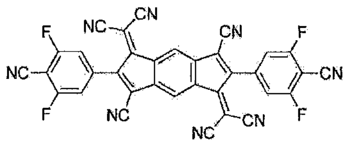

A22

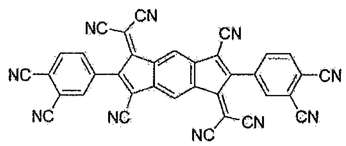

A23

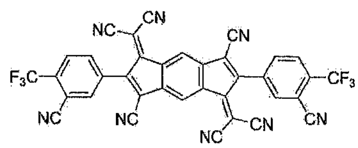

A24

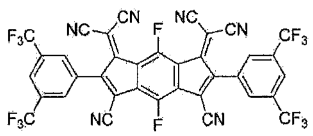

A25

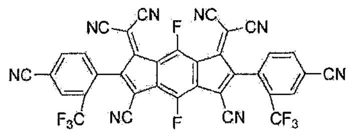

A26

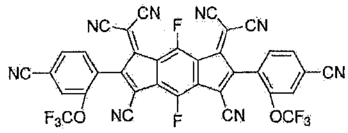

A27

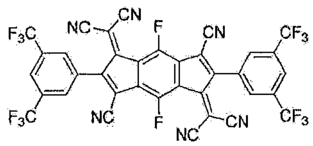

A28

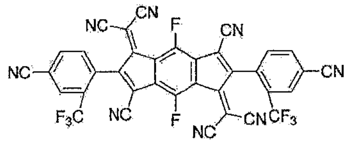

A29

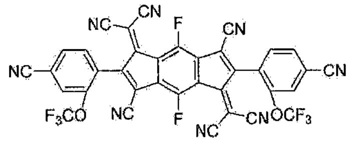

A30

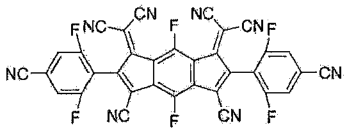

A31

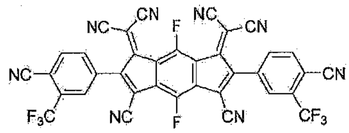

A32

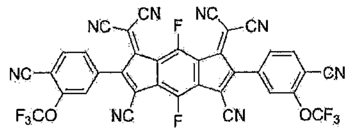

A33

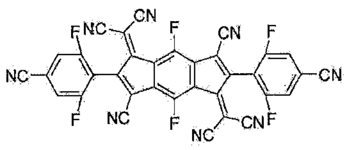

A34

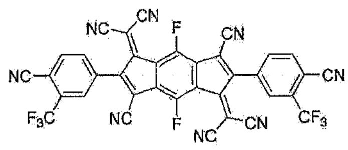

A35

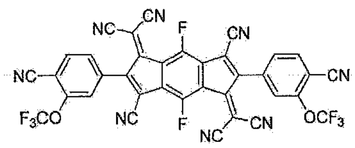

A36

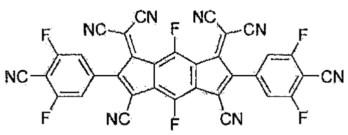

A37

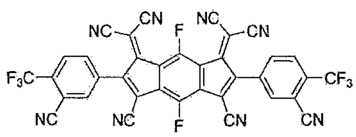

A38

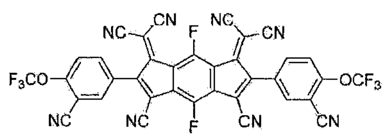

A39

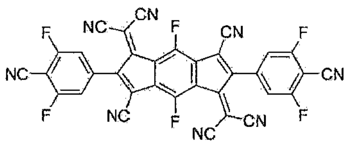

A40

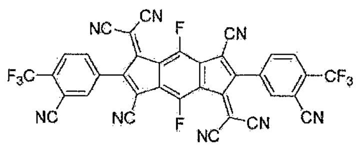

A41

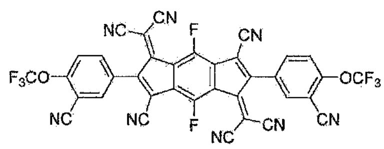

A42

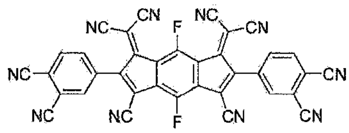
A43

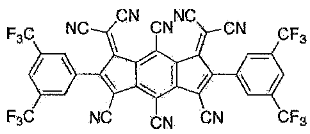
A44

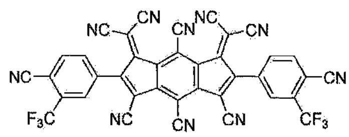
A45

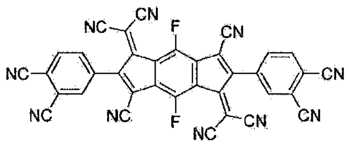
A46

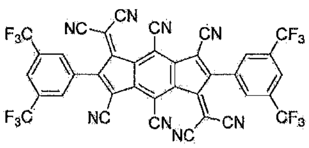
A47

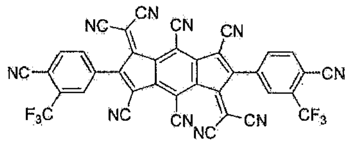
A48

5. The organic electric element (220, 320) according to one of the preceding claims, wherein the second chemical compound is one or more of the following chemical compounds:

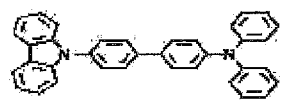
4-1

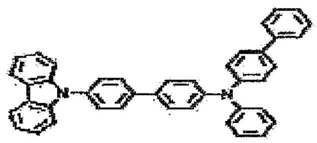
4-2

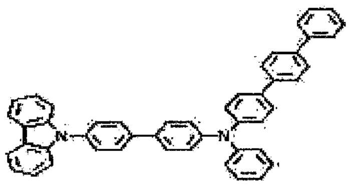
4-3

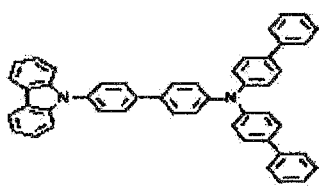
4-4

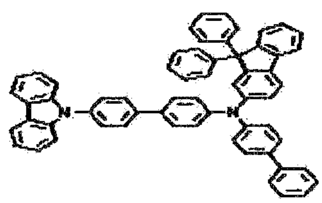
4-5

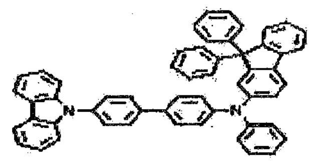
4-6

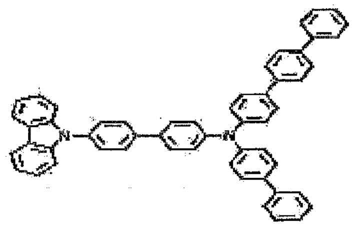
4-7

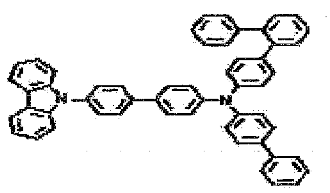
4-8

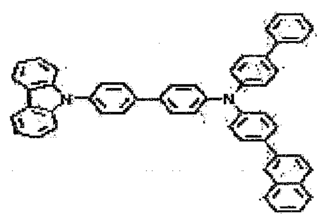
4-9

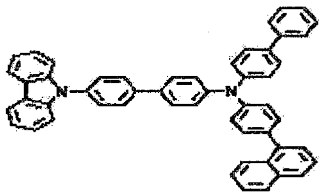

4-10

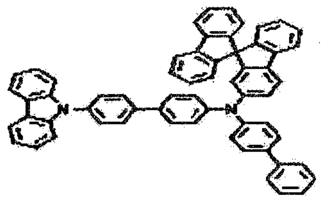

4-11

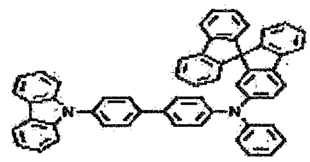

4-12

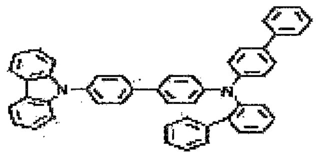

4-13

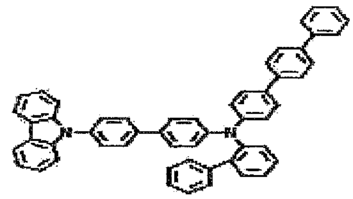

4-14

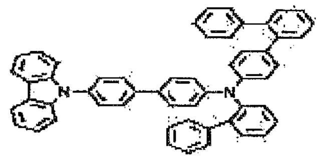

4-15

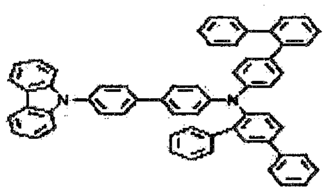

4-16

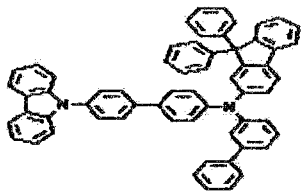

4-17

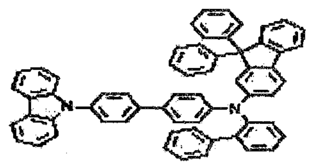

4-18

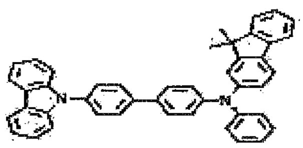

4-19

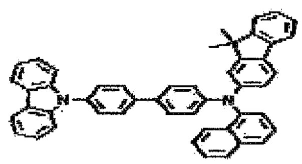

4-20

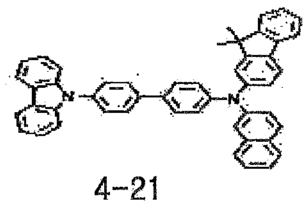

4-21

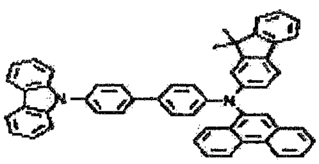

4-22

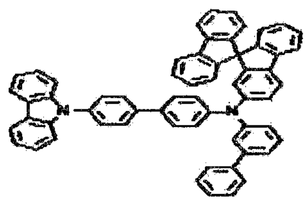

4-23

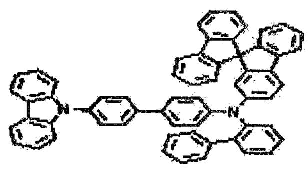

4-24

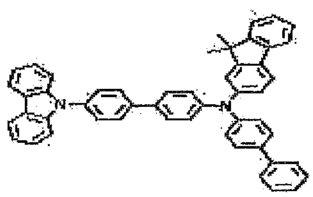

4-25

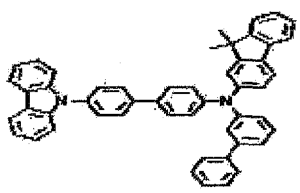

4-26

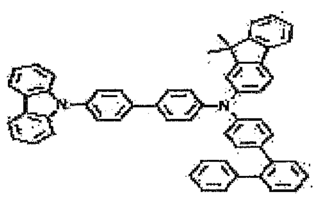

4-27

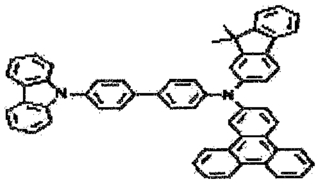

4-28

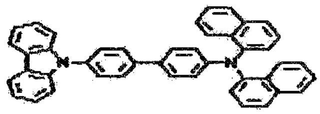

4-29

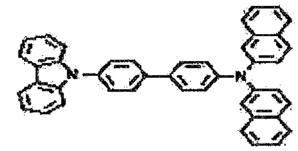

4-30

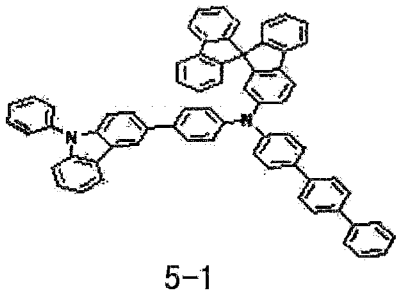

5-1

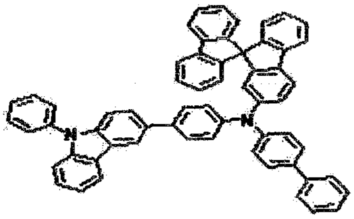

5-2

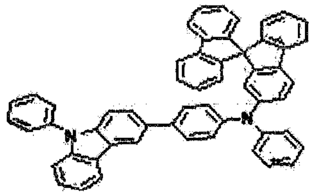

5-3

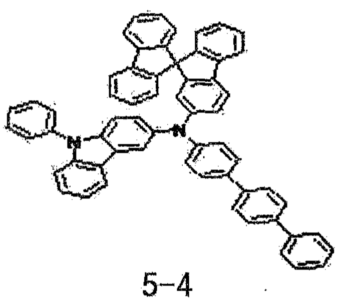

5-4

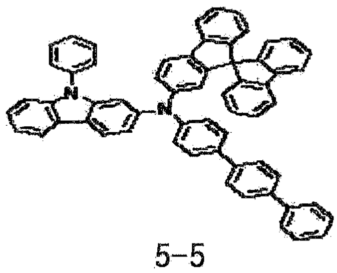

5-5

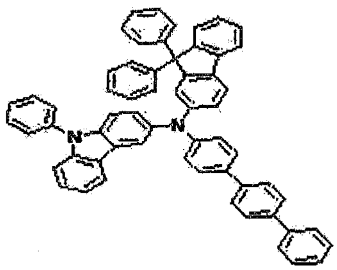

5-6

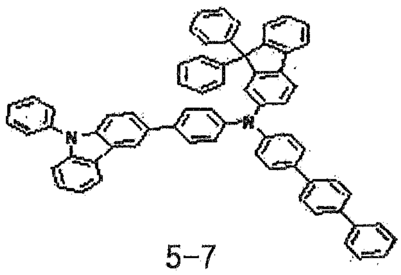

5-7

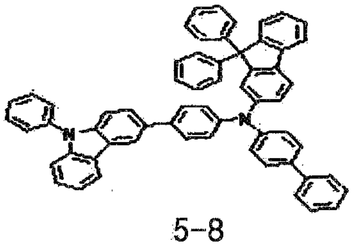

5-8

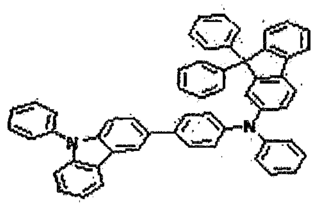

5-9

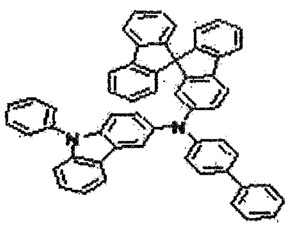

5-10

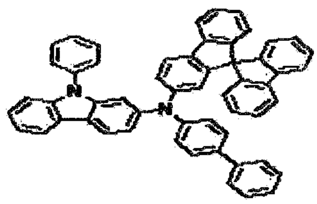

5-11

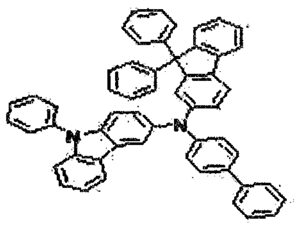

5-12

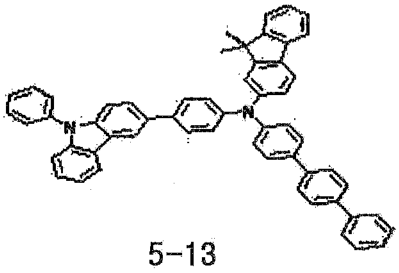
5-13

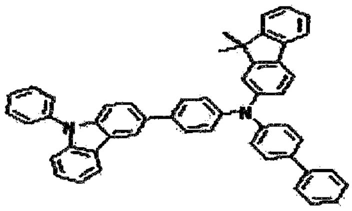
5-14

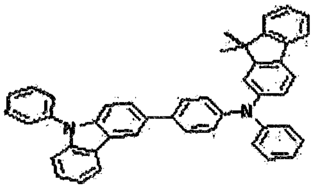
5-15

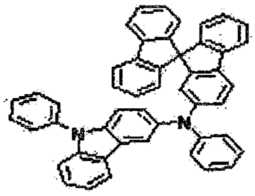
5-16

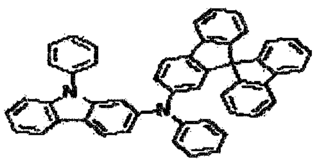
5-17

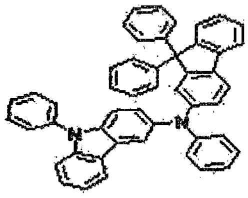
5-18

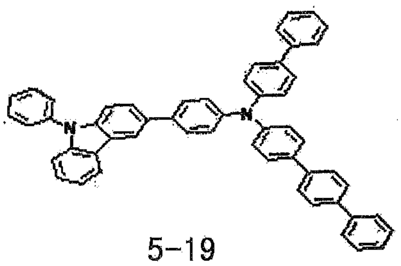
5-19

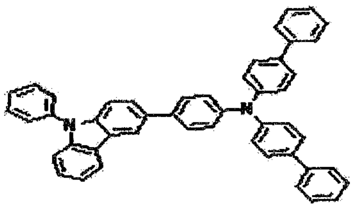
5-20

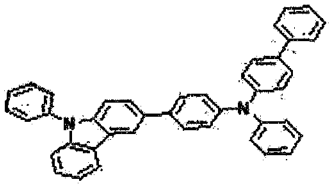
5-21

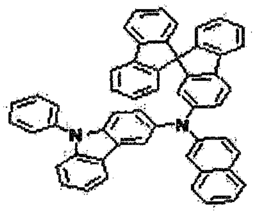
5-22

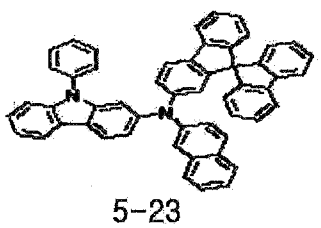
5-23

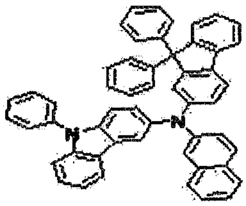
5-24

6. The organic electric element (220, 320) according to one of the preceding claims, wherein the first electrode (221, 321) is an anode electrode, the second electrode (223, 323) is a cathode electrode, and the first layer (326a) is positioned between the second layer (326b) and the second electrode (223, 323).

7. The organic electric element (220, 320) according to one of the preceding claims, further comprising a hole injection layer (327) located between the first electrode (221, 321) and the first light emitting layer (324a), wherein the hole injection layer (327) preferably comprises a fourth compound represented by one or more of chemical formula 1 and chemical formula 2 and a fifth compound represented by chemical formula 3.

8. The organic electric element (220, 320) according to one of the preceding claims, wherein the fourth compound is the same compound as the first compound, and the fifth compound is the same organic compound as the second compound.

9. The organic electric element (220, 320) according to one of the preceding claims, wherein the following general formula 1 is satisfied:

[general formula 1] $L_3\text{-}L_1 \leq 2.1$ eV

wherein in general formula 1,
$L_3$ is the LUMO (Lowest Unoccupied Molecular Orbital) energy level of the third compound, and
$L_1$ is the LUMO energy level of the first compound.

**10.** The organic electric element (220, 320) according to one of the preceding claims, wherein the following general formula 2 is satisfied:

[general formula 2] $L_3\text{-}H_2 \leq 2.8$ eV

wherein in general formula 2,
$L_3$ is the LUMO (Lowest Unoccupied Molecular Orbital) energy level of the third compound, and
$H_2$ is the HOMO (Highest Occupied Molecular Orbital) energy level of the second compound.

**11.** The organic electric element (220, 320) according to one of the preceding claims, wherein the following general formula 3 is satisfied:

[general formula 3] $0.32\text{eV} \leq L_1\text{-}H_2 \leq 0.8$ eV

wherein in general formula 3,
$L_1$ is the LUMO (Lowest Unoccupied Molecular Orbital) energy level of the first compound, and
$H_2$ is the HOMO (Highest Occupied Molecular Orbital) energy level of the second compound.

**12.** A display panel (110) comprising a subpixel (111) comprising the organic electric element (220, 320) of one of the preceding claims.

**13.** A display device (100) comprising;

the display panel (110) of claim 12; and
a driving circuit for driving the display panel (110).

**Patentansprüche**

**1.** Organisches elektrisches Element (220, 320), das umfasst:

eine erste Elektrode (221, 321);
eine zweite Elektrode (223, 323); und
eine organische Schicht (222, 322), die zwischen der ersten Elektrode (221, 321) und der zweiten Elektrode (223, 323) positioniert ist,
wobei die organische Schicht (222, 322) einen ersten Stapel (324) mit einer ersten Emissionsschicht (324a), einen zweiten Stapel (325) mit einer zweiten Emissionsschicht (325a) und eine Ladungserzeugungsschicht (326), die zwischen dem ersten Stapel (324) und dem zweiten Stapel (325) positioniert ist, umfasst,
die Ladungserzeugungsschicht (326) eine erste Schicht (326a) und eine zweite Schicht (326b) umfasst,
die erste Schicht (326a) eine erste Verbindung, die durch die folgende chemische Formel 1 und/oder die folgende chemische Formel 2 dargestellt ist, und eine zweite Verbindung umfasst, und
die zweite Schicht (326b) eine dritte Verbindung umfasst,
wobei die chemische Formel 1 und chemische Formel 2 wie folgt sind:

[Chemische Formel 1]

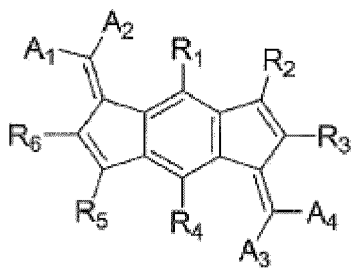

[Chemische Formel 2]

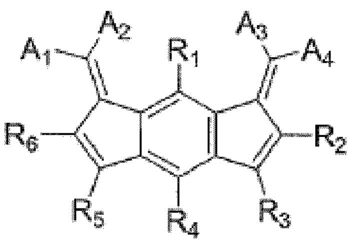

wobei in der chemischen Formel 1 und in der chemischen Formel 2

$R_1$ bis $R_6$, die gleich oder verschieden sind, jeweils unabhängig eines sind, das aus der Gruppe ausgewählt ist, die aus Wasserstoff; Deuterium; Tritium; einem Halogen; einer Cyanogruppe; einer Nitrogruppe; einer $C_6$-$C_{60}$-Arylgruppe, einer Fluorenylgruppe; einer $C_2$-$C_{60}$-Heteroringgruppe, die mindestens ein Heteroatom aus O, N, S, Si und P enthält; einer fusionierten Ringgruppe eines aliphatischen $C_3$-$C_{60}$-Rings und eines aromatischen $C_6$-$C_{60}$-Rings; einer $C_1$-$C_{50}$-Alkylgruppe; einer $C_2$-$C_{20}$-Alkenylgruppe; einer $C_2$-$C_{20}$-Alkynylgruppe; einer $C_1$-$C_{30}$-Alkoxygruppe; einer $C_6$-$C_{30}$-Aryloxygruppe; einer $C_3$-$C_{60}$-Alkylsilylgruppe; einer $C_{18}$-$C_{60}$-Arylsilylgruppe, und einer $C_8$-$C_{60}$-Alkylarylsilylgruppe besteht, und eines oder mehrere von $R_1$ bis $R_6$ die Cyanogruppe sind,

$A_1$ bis $A_4$, die gleich oder verschieden sein können, jeweils unabhängig eines sind, das aus der Gruppe ausgewählt ist, die aus Wasserstoff; Deuterium; Tritium; einem Halogen; einer Cyanogruppe; einer Nitrogruppe; einer $C_6$-$C_{60}$-Arylgruppe, einer Fluorenylgruppe; einer $C_2$-$C_{60}$-Heteroringgruppe, die mindestens ein Heteroatom aus O, N, S, Si und P enthält; einer fusionierten Ringgruppe eines aliphatischen $C_3$-$C_{60}$-Rings und eines aromatischen $C_6$-$C_{60}$-Rings; einer $C_1$-$C_{50}$-Alkylgruppe; einer $C_2$-$C_{20}$-Alkenylgruppe; einer $C_2$-$C_{20}$-Alkynylgruppe; einer $C_1$-$C_{30}$-Alkoxygruppe; einer $C_6$-$C_{30}$-Aryloxygruppe; einer $C_3$-$C_{60}$-Alkylsilylgruppe; einer $C_{18}$-$C_{60}$-Arylsilylgruppe, und einer $C_8$-$C_{60}$-Alkylarylsilylgruppe besteht,

und wobei in $R_1$ bis $R_6$ und $A_1$ bis $A_4$ der chemischen Formel 1 und der chemischen Formel 2 die Arylgruppe, die Fluorenylgruppe, die Heteroringgruppe, die fusionierte Ringgruppe, die Alkylgruppe, die Alkenylgruppe, die Alkynylgruppe, die Alkoxygruppe, die Aryloxygruppe, die Alkylsilylgruppe, die Arylsilylgruppe und die Alkylarylsilylgruppe jeweils ferner mit mindestens einem Substituenten substituiert sein können, der aus der Gruppe ausgewählt ist, die aus Deuterium; einer Nitrogruppe; einer Cyanogruppe; einem Halogen; einer Aminogruppe; einer $C_1$-$C_{20}$-Alkoxylgruppe; einer $C_1$-$C_{20}$-Alkylgruppe, einer $C_2$-$C_{20}$-Alkenylgruppe; einer $C_2$-$C_{20}$-Alkynylgruppe; einer $C_6$-$C_{20}$-Arylgruppe; einer $C_6$-$C_{20}$-Arylgruppe, die mit dem Deuterium substituiert ist; einer Fluorenylgruppe; einer $C_2$-$C_{20}$-Heteroringgruppe; einer $C_3$-$C_{60}$-Alkylsilylgruppe; einer $C_{18}$-$C_{60}$-Arylsilylgruppe, und einer $C_8$-$C_{60}$-Alkylarylsilylgruppe besteht,

wobei die zweite chemische Verbindung durch die folgende chemische Formel 9 und/oder die folgende chemische Formel 10 dargestellt ist:

[Chemische Formel 9]

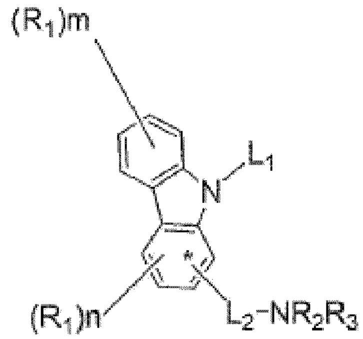

[Chemische Formel 10]

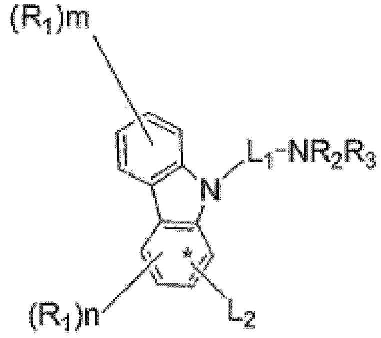

wobei in der chemischen Formel 9 und in der chemischen Formel 10

m, n und $R_1$ bis $R_3$ gleich wie m, n und $R_1$ in der chemischen Formel 3 sind,

$L_1$ eines ist, das aus der Gruppe ausgewählt ist, die aus einer $C_6$-$C_{60}$-Arylgruppe; einer Fluorenylgruppe; einer $C_2$-$C_{60}$-Heteroringgruppe, die mindestens ein Heteroatom aus O, N, S, Si und P enthält; einer fusionierten Ringgruppe eines aliphatischen $C_3$-$C_{60}$-Rings und eines aromatischen $C_6$-$C_{60}$-Rings besteht,

$L_2$ eines ist, das aus der Gruppe ausgewählt ist, die aus einer $C_6$-$C_{60}$-Arylengruppe; einer Fluorylengruppe; einer zweiwertigen $C_2$-$C_{60}$-Heteroringgruppe, die mindestens ein Heteroatom aus O, N, S, Si und P enthält; einer zweiwertigen fusionierten Ringgruppe eines aliphatischen $C_3$-$C_{60}$-Rings und eines aromatischen $C_6$-$C_{60}$-Rings; einer $C_1$-$C_{50}$-Alkylengruppe; einer $C_2$-$C_{20}$-Alkenylengruppe; und einer $C_2$-$C_{20}$-Alkynylengruppe besteht,

und wobei in der chemischen Formel 10

m, n und $R_1$ bis $R_3$ gleich wie m, n und $R_1$ in der chemischen Formel 3 sind,

$L_1$ eines ist, das aus der Gruppe ausgewählt ist, die aus einer $C_6$-$C_{60}$-Arylengruppe; einer Fluorylengruppe; einer zweiwertigen $C_2$-$C_{60}$-Heteroringgruppe, die mindestens ein Heteroatom aus O, N, S, Si und P enthält; einer zweiwertigen fusionierten Ringgruppe eines aliphatischen $C_3$-$C_{60}$-Rings und eines aromatischen $C_6$-$C_{60}$-Rings; einer $C_1$-$C_{50}$-Alkylengruppe; einer $C_2$-$C_{20}$-Alkenylengruppe; und einer $C_2$-$C_{20}$-Alkynylengruppe besteht,

$L_2$ eines ist, das aus der Gruppe ausgewählt ist, die aus einer aus einer $C_6$-$C_{60}$-Arylgruppe; einer Fluorenylgruppe; einer $C_2$-$C_{60}$-Heteroringgruppe, die mindestens ein Heteroatom aus O, N, S, Si und P enthält; einer fusionierten Ringgruppe eines aliphatischen $C_3$-$C_{60}$-Rings und eines aromatischen $C_6$-$C_{60}$-Rings besteht, und wobei in $R_1$ bis $R_3$, $L_1$ und $L_2$ der chemischen Formel 9 und der chemischen Formel 10 die Arylgruppe, die Fluorenylgruppe, die Heteroringgruppe, die fusionierte Ringgruppe, die Alkylgruppe, die Alkenylgruppe, die Alkynylgruppe, die Alkoxygruppe, die Aryloxygruppe, die Alkylsilylgruppe, die Arylsilylgruppe, die Alkylarylsilylgruppe, die Arylengruppe, die Fluorylengruppe und die zweiwertige fusionierte Ringgruppe jeweils ferner mit mindestens einem Substituenten substituiert sein können, der aus der Gruppe ausgewählt ist, die aus einem Deuterium; einer Nitrogruppe; einer Cyanogruppe; einem Halogen; einer Aminogruppe; einer $C_1$-$C_{20}$-Alkoxylgruppe; einer $C_1$-$C_{20}$-Alkylgruppe; einer $C_2$-$C_{20}$-Alkenylgruppe; einer $C_2$-$C_{20}$-Alkynylgruppe; einer $C_6$-$C_{20}$-Arylgruppe; einer $C_6$-$C_{20}$-Arylgruppe, die mit dem Deuterium substituiert ist; einer Fluorenylgruppe; einer $C_2$-$C_{20}$-Heteroringgruppe; einer $C_3$-$C_{60}$-Alkylsilylgruppe; einer $C_{18}$-$C_{60}$-Arylsilylgruppe, und einer $C_8$-$C_{60}$-Alkylarylsilylgruppe besteht,

und wobei die dritte chemische Verbindung eine oder mehrere der folgenden chemischen Verbindungen ist:

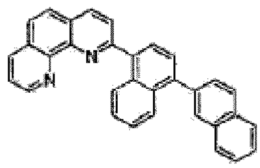

E01

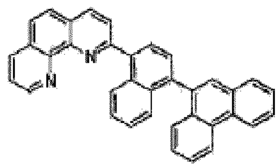

E02

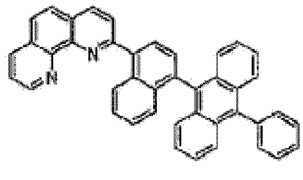

E03

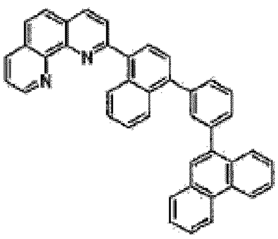

E04

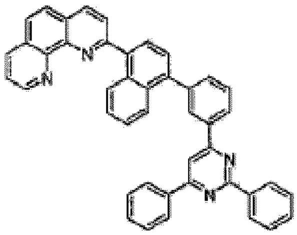

E05

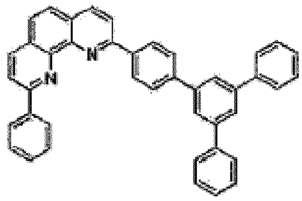

E06

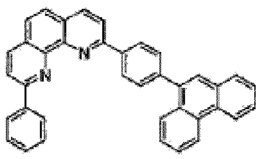

E07

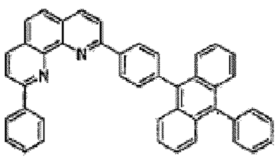

E08

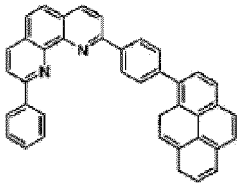

E09

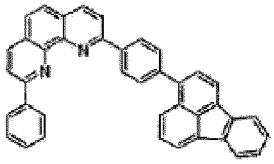

E10

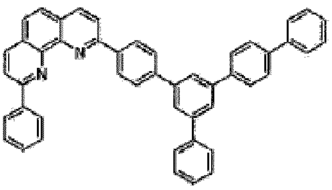

E11

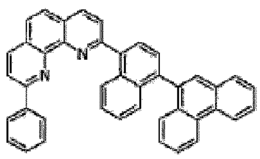

E12

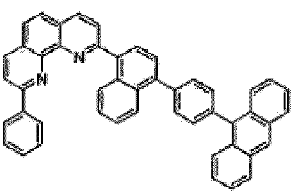

E13

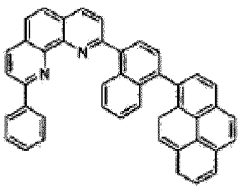

E14

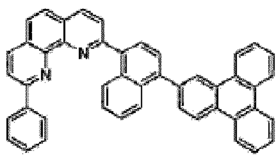

E15

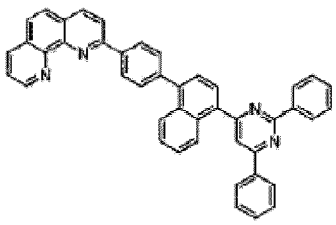

E16

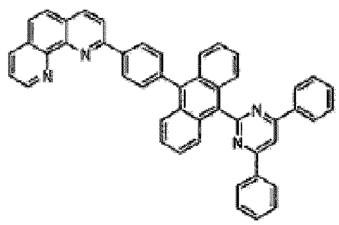

E17

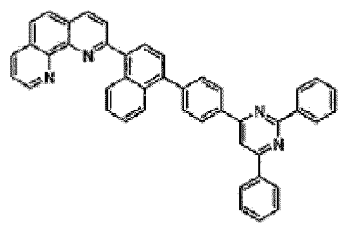

E18

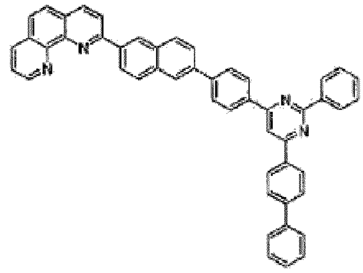

E19

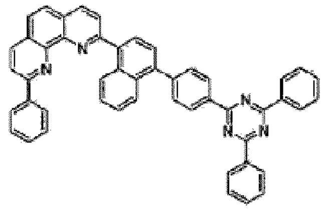

E20

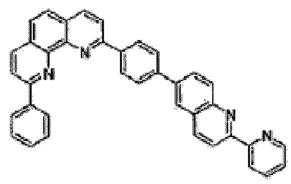

E21

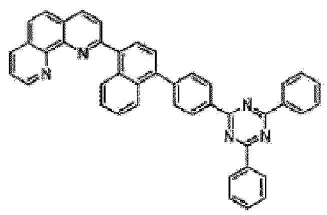

E22

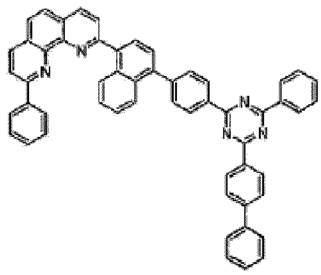

E23

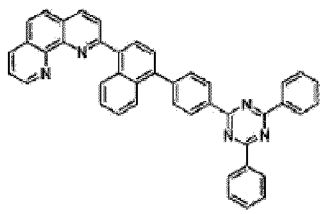

E24

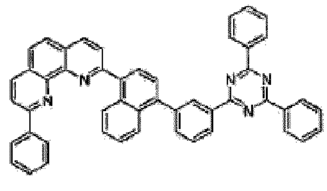

E25

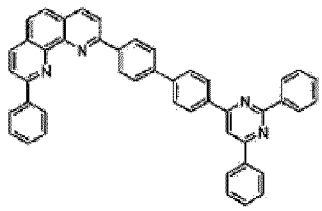

E26

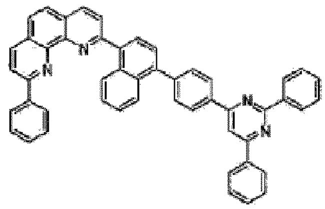

E27

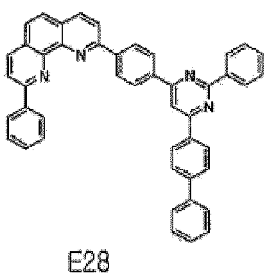

E28

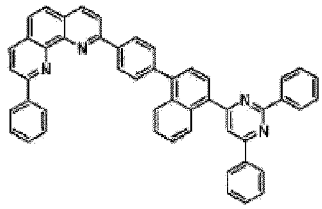

E29

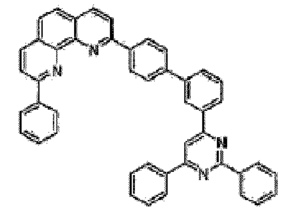

E30

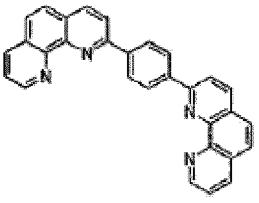

E31

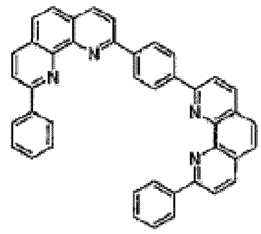

E32

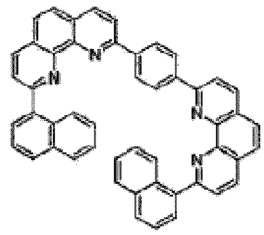

E33

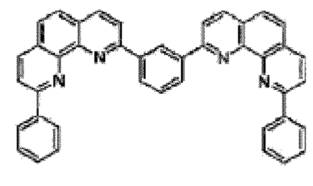

E34

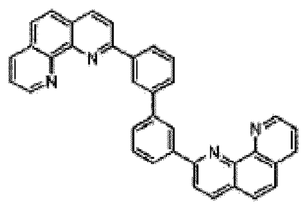

E35

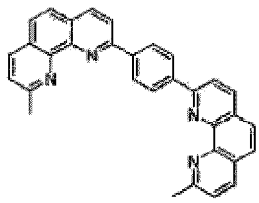

E36

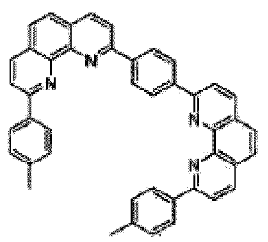

E37

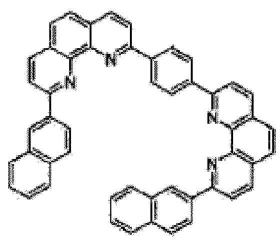

E38

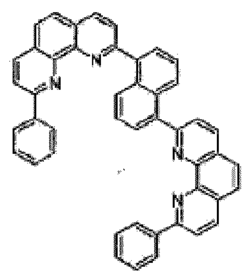

E39

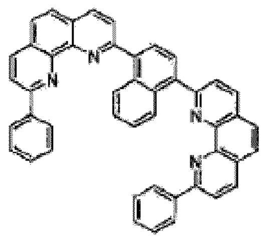

E40

**2.** Organisches elektrisches Element (220, 320) nach Anspruch 1, wobei die erste chemische Verbindung durch die folgende chemische Formel 5 und/oder die folgende chemische Formel 6 dargestellt ist:

[Chemische Formel 5]

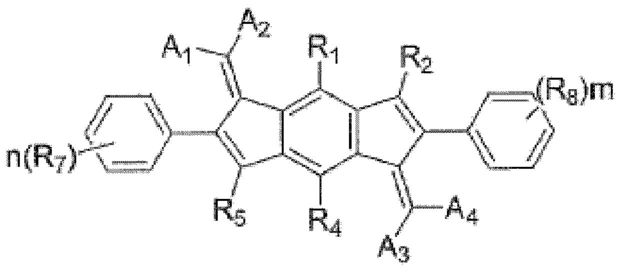

[Chemische Formel 6]

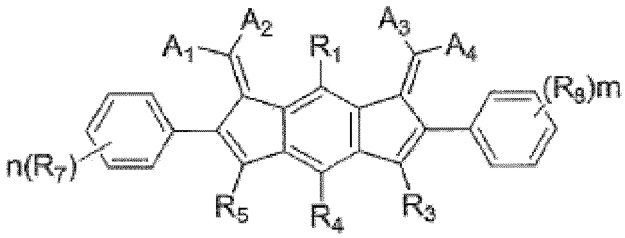

wobei in der chemischen Formel 5 und in der chemischen Formel 6 n und m jeweils unabhängig eine ganz Zahl von 0 bis 5 sind,

$R_7$ bis $R_8$, die gleich oder verschieden sein können, jeweils unabhängig eines sind, das aus der Gruppe ausgewählt ist, die aus Deuterium; Tritium; einem Halogen; einer Cyanogruppe; einer $C_1$-$C_{50}$-Alkylgruppe; und einer $C_1$-$C_{30}$-Alkoxygruppe besteht, und

wobei in $R_7$ und $R_8$ der chemischen Formel 5 und in der chemischen Formel 6 die Alkylgruppe und die Alkoxygruppe jeweils ferner mit mindestens einem Substituenten substituiert sein können, der aus der Gruppe ausgewählt ist, die aus Deuterium und einem Halogen besteht.

**3.** Organisches elektrisches Element (220, 320) nach Anspruch 1, wobei die erste chemische Verbindung durch die folgende chemische Formel 7 und/oder die Formel 8 dargestellt ist:

[Chemische Formel 7]

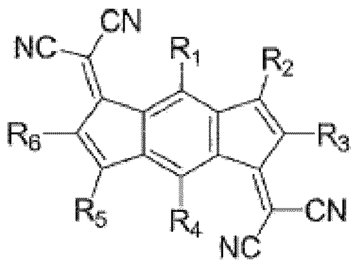

[Chemische Formel 8]

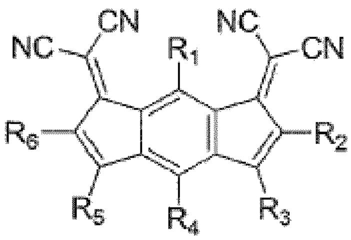

wobei in der chemischen Formel 7 und in der chemischen Formel 8 $R_1$ bis $R_6$ gleich wie $R_1$ bis $R_6$ in den chemischen Formeln 1 und 2 sind.

**4.** Organisches elektrisches Element (220, 320) nach einem der vorhergehenden Ansprüche, wobei die erste chemische Verbindung eine oder mehrere der folgenden chemischen Verbindungen ist:

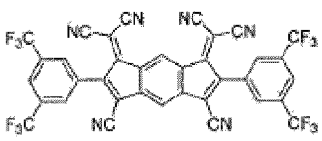
A01

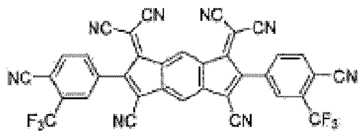
A02

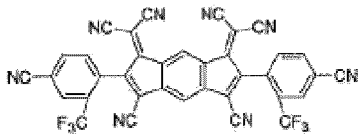
A03

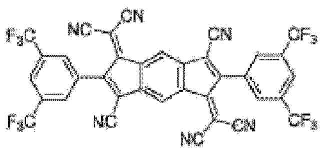
A04

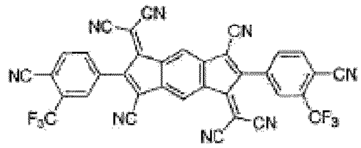
A05

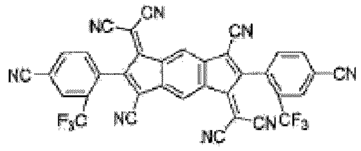
A06

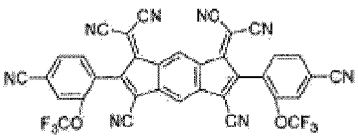
A07

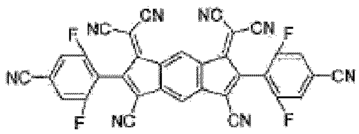
A08

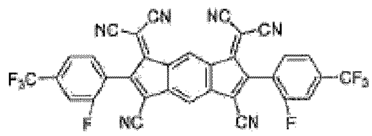
A09

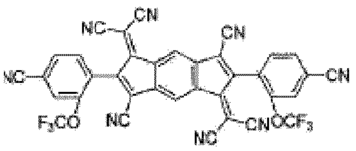
A10

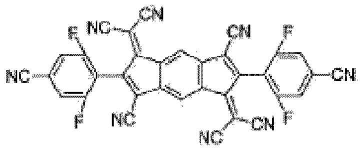
A11

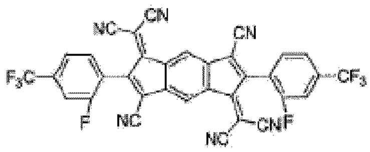
A12

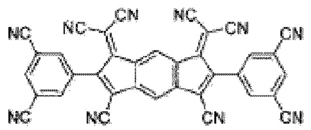
A13

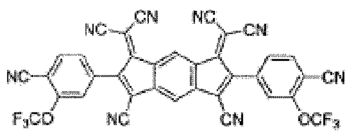
A14

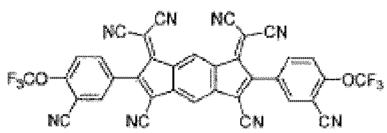
A15

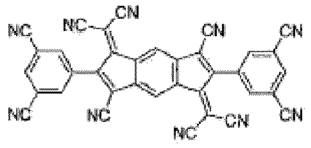
A16

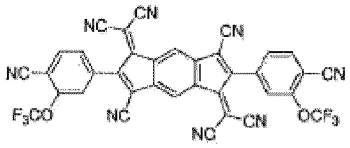
A17

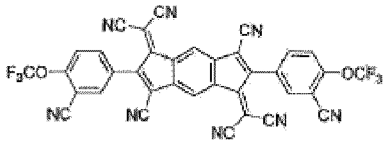
A18

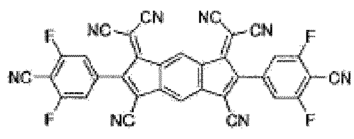

A19

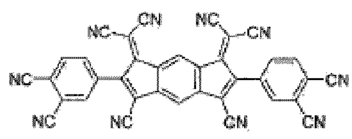

A20

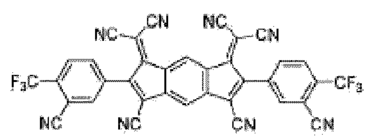

A21

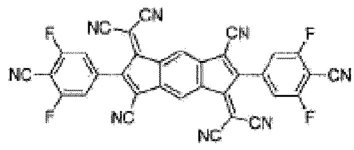

A22

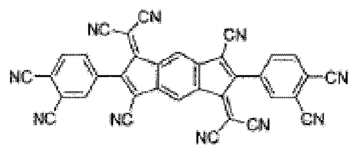

A23

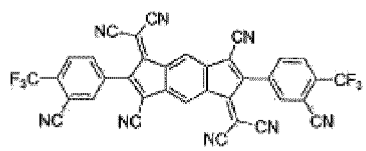

A24

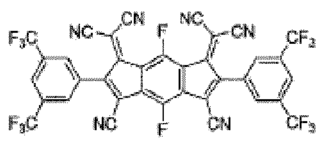

A25

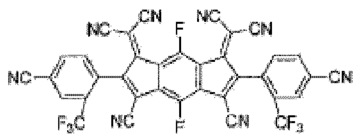

A26

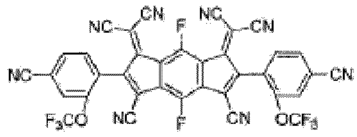

A27

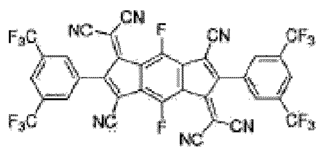

A28

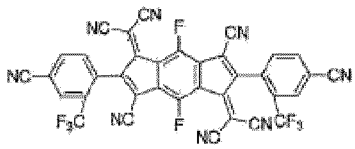

A29

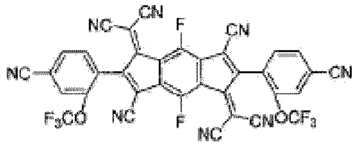

A30

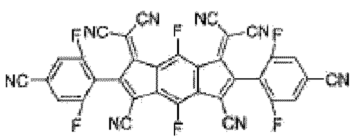

A31

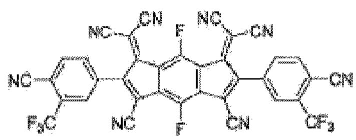

A32

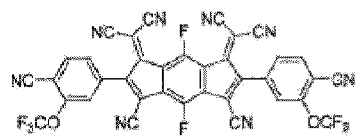

A33

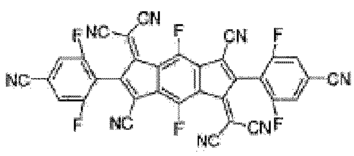

A34

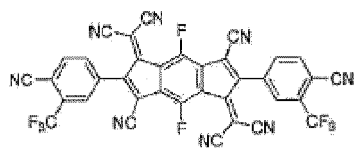

A35

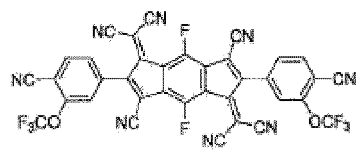

A36

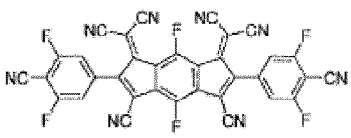

A37

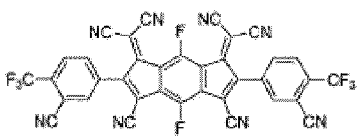

A38

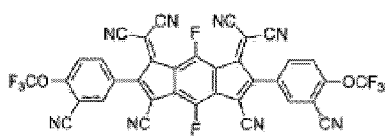

A39

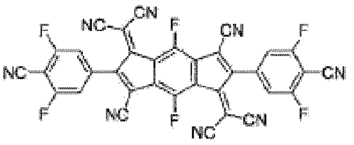

**A40**

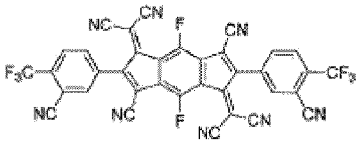

**A41**

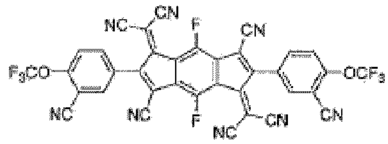

**A42**

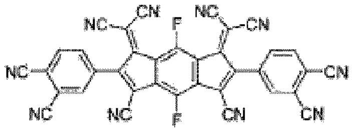

**A43**

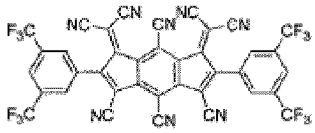

**A44**

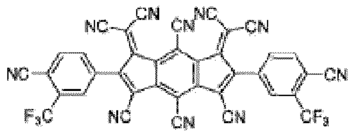

**A45**

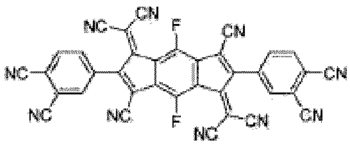

**A46**

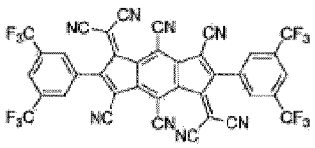

**A47**

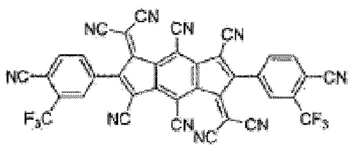

**A48**

**5.** Organisches elektrisches Element (220, 320) nach einem der vorhergehenden Ansprüche, wobei die zweite chemische Verbindung eine oder mehrere der folgenden chemischen Verbindungen ist:

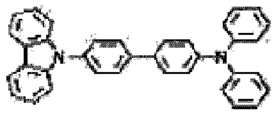

4-1

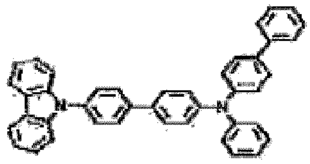

4-2

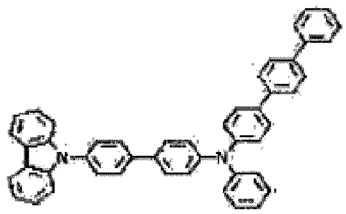

4-3

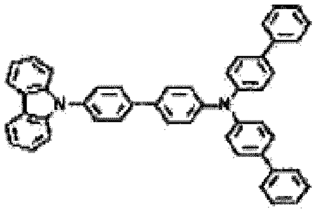

4-4

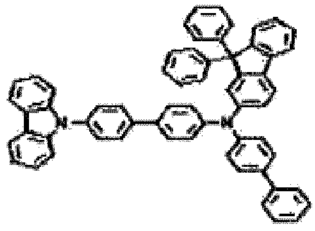

4-5

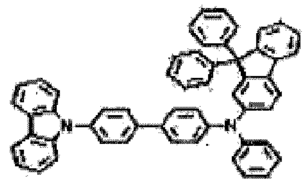

4-6

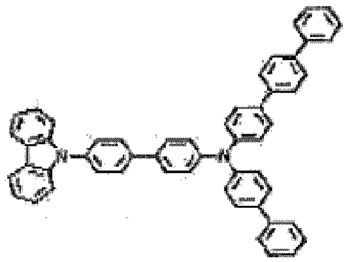
4-7

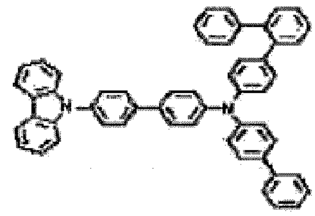
4-8

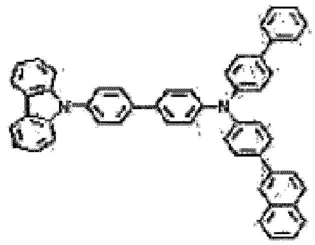
4-9

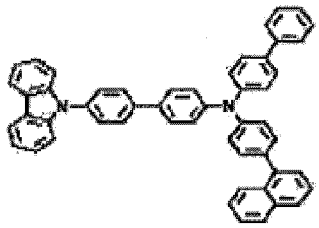
4-10

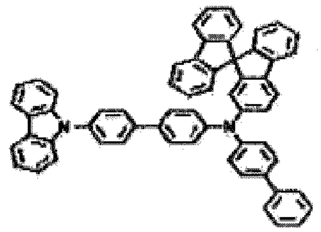
4-11

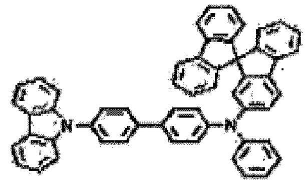
4-12

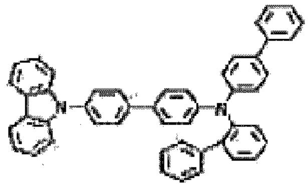
4-13

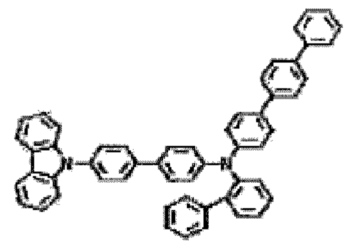
4-14

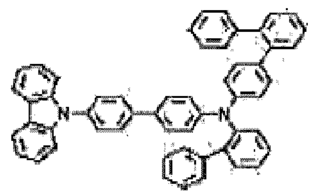
4-15

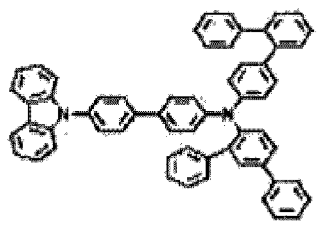
4-16

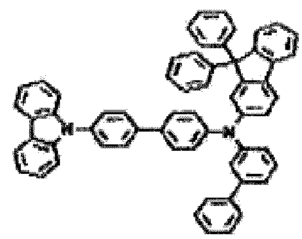
4-17

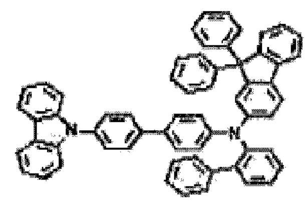
4-18

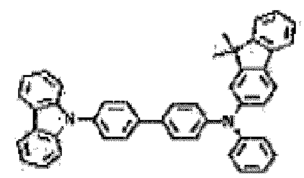
4-19

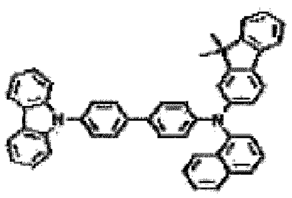
4-20

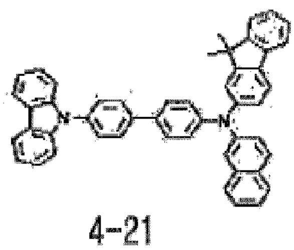
4-21

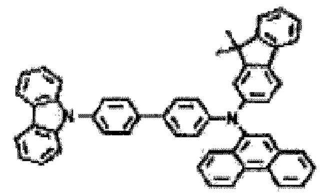
4-22

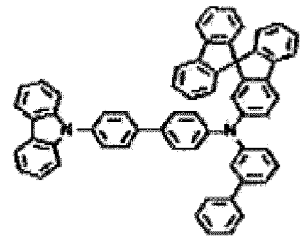
4-23

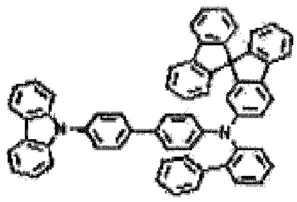
4-24

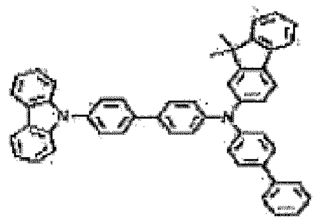
4-25

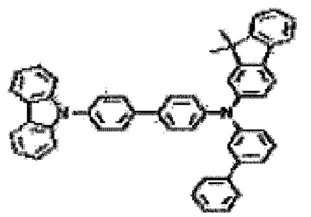
4-26

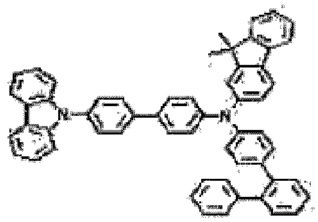
4-27

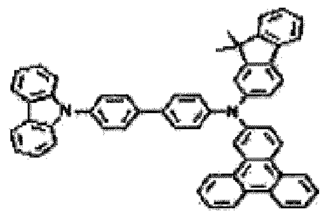
4-28

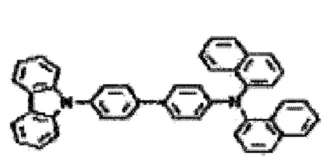
4-29

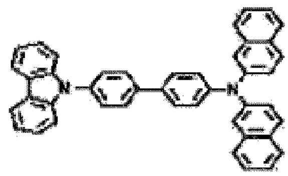
4-30

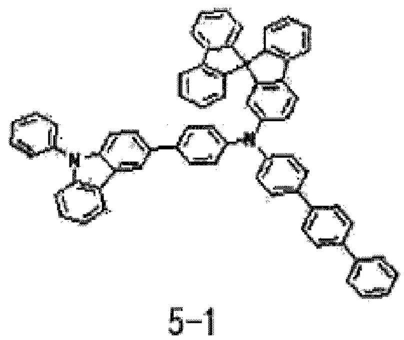
5-1

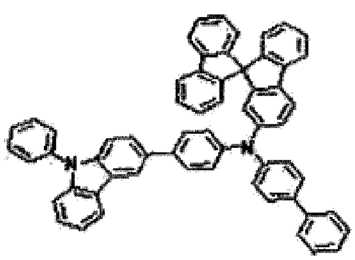
5-2

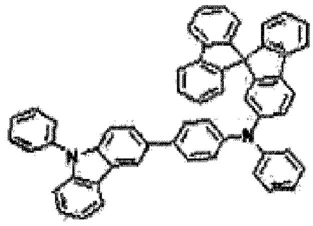
5-3

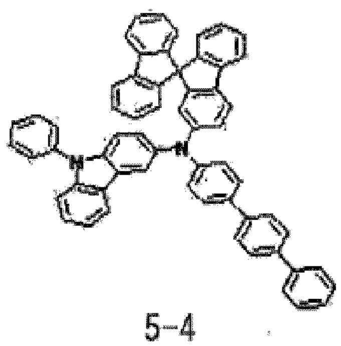
5-4

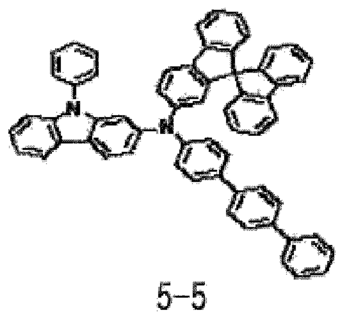
5-5

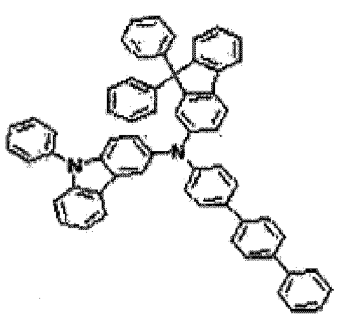
5-6

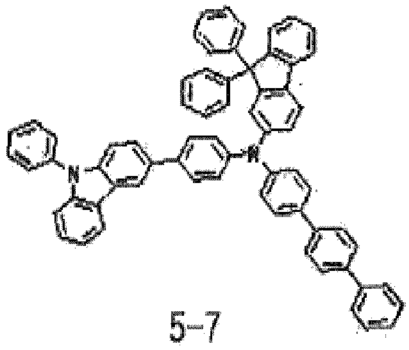

5-7

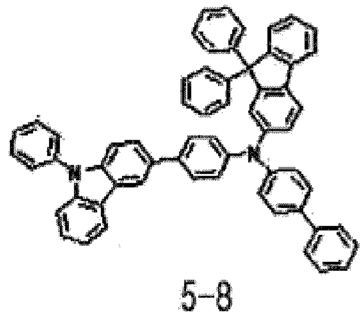

5-8

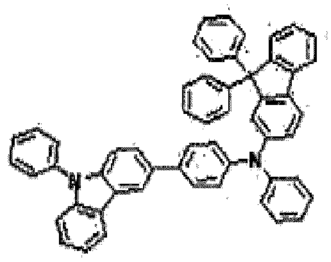

5-9

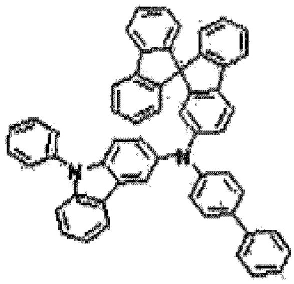

5-10

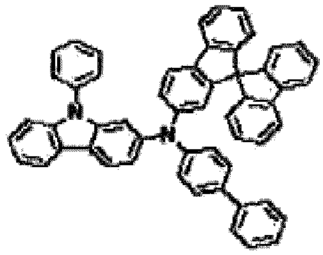

5-11

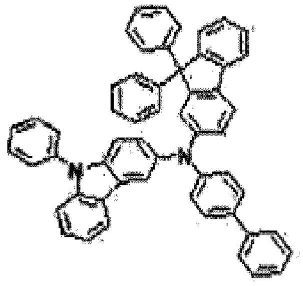

5-12

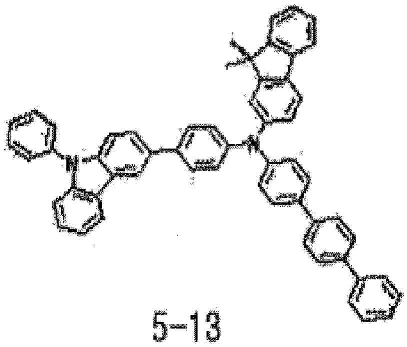

5-13

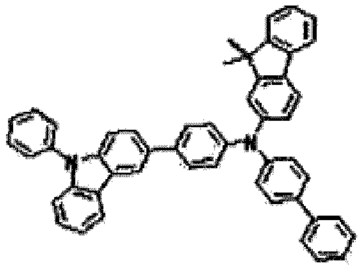

5-14

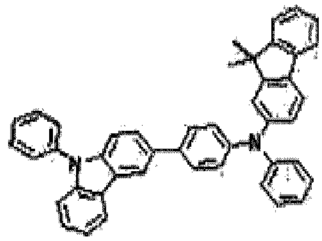

5-15

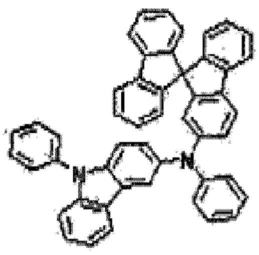

5-16

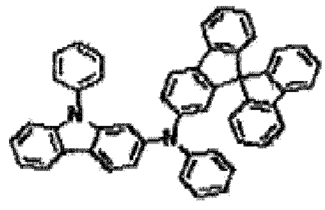

5-17

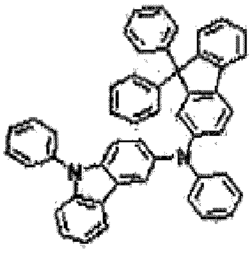

5-18

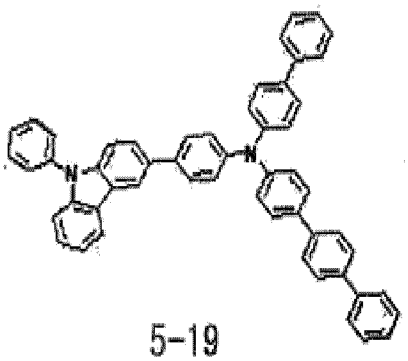

5-19

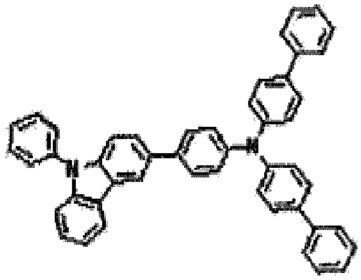

5-20

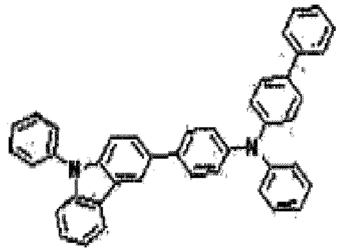

5-21

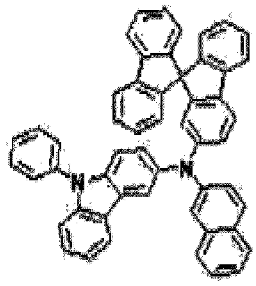

5-22

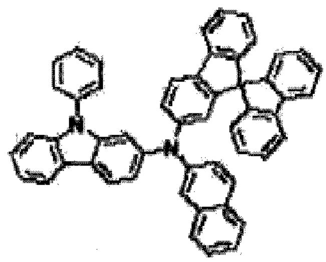

5-23

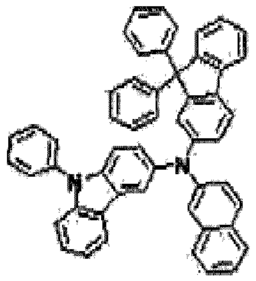

5-24

**6.** Organisches elektrisches Element (220, 320) nach einem der vorhergehenden Ansprüche, wobei die erste Elektrode (221, 321) eine Anodenelektrode ist, die zweite Elektrode (223, 323) eine Kathodenelektrode ist und die erste Schicht (326a) zwischen der zweiten Schicht (326b) und der zweiten Elektrode (223, 323) positioniert ist.

**7.** Organisches elektrisches Element (220, 320) nach einem der vorhergehenden Ansprüche, das ferner eine Lochinjektionsschicht (327) umfasst, die zwischen der ersten Elektrode (221, 321) und der ersten Lichtemissionsschicht (324a) angeordnet ist, wobei die Lochinjektionsschicht (327) vorzugsweise eine vierte Verbindung, die durch die chemische Formel 1 und/oder die chemische Formel 2 dargestellt ist, und eine fünfte Verbindung, die durch die chemische Formel 3 dargestellt ist, umfasst.

**8.** Organisches elektrisches Element (220, 320) nach einem der vorhergehenden Ansprüche, wobei die vierte Verbindung dieselbe Verbindung wie die erste Verbindung ist und die fünfte Verbindung dieselbe organische Verbindung wie die zweite Verbindung ist.

**9.** Organisches elektrisches Element (220, 320) nach einem der vorhergehenden Ansprüche, wobei die folgende allgemeine Formel 1 erfüllt ist:

[Allgemeine Formel 1] $L_3\text{-}L_1 \leq 2{,}1$ eV,

wobei in der allgemeinen Formel 1
$L_3$ das LUMO-Energieniveau (Energieniveau des niedrigsten unbesetzten Molekülorbitals) der dritten Verbindung ist, und
$L_1$ das LUMO-Energieniveau der ersten Verbindung ist.

**10.** Organisches elektrisches Element (220, 320) nach einem der vorhergehenden Ansprüche, wobei die folgende allgemeine Formel 2 erfüllt ist:

[Allgemeine Formel 2] $L_3\text{-}H_2 \leq 2{,}8$ eV,

wobei in der allgemeinen Formel 2
$L_3$ das LUMO-Energieniveau (Energieniveau des niedrigsten unbesetzten Molekülorbitals) der dritten Verbin-

dung ist, und
$H_2$ das HOMO-Energieniveau (Energieniveau des höchsten besetzten Molekülorbitals) der zweiten Verbindung ist.

**11.** Organisches elektrisches Element (220, 320) nach einem der vorhergehenden Ansprüche, wobei die folgende allgemeine Formel 3 erfüllt ist:

[Allgemeine Formel 3] $0,32\ eV \leq L_1\text{-}H_2 \leq 0,8\ eV$,

wobei in der allgemeinen Formel 3
$L_1$ das LUMO-Energieniveau (Energieniveau des niedrigsten unbesetzten Molekülorbitals) der ersten Verbindung ist, und
$H_2$ das HOMO-Energieniveau (Energieniveau des höchsten besetzten Molekülorbitals) der zweiten Verbindung ist.

**12.** Anzeigefeld (110) mit einem Unterpixel (111) mit dem organischen elektrischen Element (220, 320) nach einem der vorhergehenden Ansprüche.

**13.** Anzeigevorrichtung (100), die umfasst:

das Anzeigefeld (110) nach Anspruch 12; und
eine Ansteuerschaltung zum Ansteuern des Anzeigefeldes (110).

## Revendications

**1.** Élément électrique organique (220, 320) comportant :

une première électrode (221, 321) ;
une seconde électrode (223, 323) ; et
une couche organique (222, 322) positionnée entre la première électrode (221, 321) et la seconde électrode (223, 323),
dans lequel la couche organique (222, 322) comporte un premier empilement (324) comportant une première couche d'émission (324a), un second empilement (325) comportant une seconde couche d'émission (325a), et une couche de génération de charges (326) positionnée entre le premier empilement (324) et le second empilement (325),
la couche de génération de charges (326) comporte une première couche (326a) et une seconde couche (326b),
la première couche (326a) comporte un premier composé représenté par une ou plusieurs des formules chimiques 1 et 2 suivantes et un deuxième composé, et
la seconde couche (326b) comporte un troisième composé,
dans lequel la formule chimique 1 et la formule chimique 2 sont les suivantes :

[Formule chimique 1]

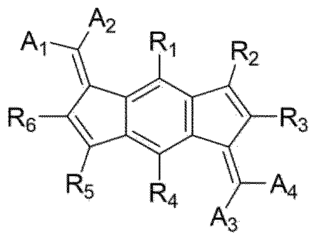

[Formule chimique 2]

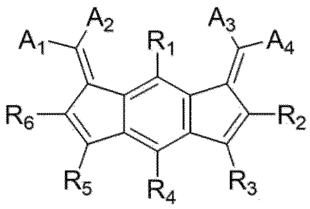

dans lequel dans la formule chimique 1 et la formule chimique 2,

$R_1$ à $R_6$, qui sont identiques ou différents, sont choisis chacun indépendamment les uns des autres parmi le groupe constitué d'un hydrogène ; d'un deutérium ; d'un tritium ; d'un halogène ; d'un groupe cyano ; d'un groupe nitro ; d'un groupe aryle en $C_6$ à $C_{60}$ ; d'un groupe fluorényle ; d'un groupe hétérocyclique en $C_2$ à $C_{60}$ contenant au moins un hétéroatome parmi O, N, S, Si et P ; d'un groupe cyclique condensé d'un cycle aliphatique en $C_3$ à $C_{60}$ et d'un cycle aromatique en $C_6$ en $C_{60}$ ; d'un groupe alkyle en $C_1$ à $C_{50}$ ; d'un groupe alcényle en $C_2$ à $C_{20}$ ; d'un groupe alcynyle en $C_2$ à $C_{20}$ ; d'un groupe alcoxy en $C_1$ à $C_{30}$ ; d'un groupe aryloxy en $C_6$ à $C_{30}$ ; d'un groupe alkylsilyle en $C_3$ à $C_{60}$ ; d'un groupe arylsilyle en $C_{18}$ à $C_{60}$ ; et d'un groupe alkylarylsilyle en $C_8$ à $C_{60}$ , et un ou plusieurs éléments parmi $R_1$ à $R_6$ sont le groupe cyano,

$A_1$ à $A_4$, qui peuvent être identiques ou différents, sont chacun choisis indépendamment les uns des autres parmi le groupe constitué d'un hydrogène ; d'un deutérium ; d'un tritium ; d'un halogène ; d'un groupe cyano ; d'un groupe nitro ; d'un groupe aryle en $C_6$ à $C_{60}$ ; d'un groupe fluorényle ; d'un groupe hétérocyclique en $C_2$ à $C_{60}$ contenant au moins un hétéroatome parmi O, N, S, Si et P ; d'un groupe cyclique condensé d'un cycle aliphatique en $C_3$ à $C_{60}$ et d'un cycle aromatique en $C_6$ à $C_{60}$ ; d'un groupe alkyle en $C_1$ à $C_{50}$ ; d'un groupe alcényle en $C_2$ à $C_{20}$ ; d'un groupe alcynyle en $C_2$ à $C_{20}$ ; d'un groupe alcoxy en $C_1$ à $C_{30}$ ; d'un groupe aryloxy en $C_6$ à $C_{30}$, d'un groupe alkylsilyle en $C_3$ à $C_{60}$ ; d'un groupe arylsilyle en $C_{18}$ à $C_{60}$ ; et d'un groupe alkylarylsilyle en $C_8$ à $C_{60}$ ;

et dans lequel dans $R_1$ à $R_6$ et $A_1$ à $A_4$ de formule chimique 1 et de formule chimique 2, le groupe aryle, le groupe fluorényle, le groupe hétérocyclique, le groupe cyclique condensé, le groupe alkyle, le groupe alcényle, le groupe alcynyle, le groupe alcoxy, le groupe aryloxy, le groupe alkylsilyle, le groupe arylsilyle et le groupe alkylarylsilyle peuvent en outre être chacun substitués par au moins un substituant choisi parmi le groupe constitué d'un deutérium ; d'un groupe nitro ; d'un groupe cyano ; d'un halogène ; d'un groupe amino; d'un groupe alcoxyle en $C_1$ à $C_{20}$ ; d'un groupe alkyle en $C_1$ à $C_{20}$ ; d'un groupe alcényle en $C_2$ à $C_{20}$ ; d'un groupe alcynyle en $C_2$ à $C_{20}$ ; d'un groupe aryle en $C_6$ à $C_{20}$ ; d'un groupe aryle en $C_6$ à $C_{20}$ substitué par le deutérium ; d'un groupe fluorényle ; d'un groupe hétérocyclique en $C_2$ à $C_{20}$ ; d'un groupe alkylsilyle en $C_3$ à $C_{60}$ ; d'un groupe arylsilyle en $C_{18}$ à $C_{60}$ ; et d'un groupe alkylarylsilyle en $C_8$ à $C_{60}$,

dans lequel le deuxième composé chimique est représenté par une ou plusieurs des formules chimiques 9 et 10 suivantes :

[Formule chimique 9]

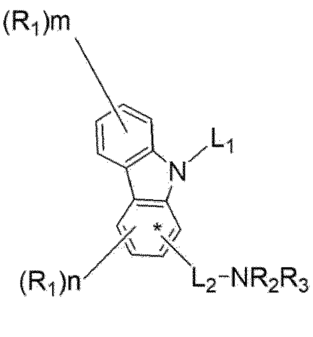

[Formule chimique 10]

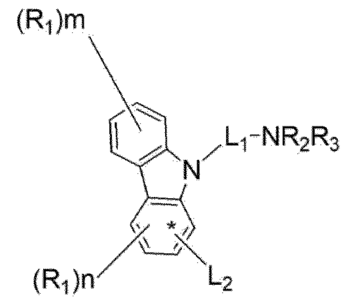

dans lequel, dans la formule chimique 9 et la formule chimique 10,
m, n et $R_1$ à $R_3$ sont identiques à m, n et $R_1$ dans la formule chimique 3,
$L_1$ est choisi parmi le groupe constitué d'un groupe aryle en $C_6$ à $C_{60}$ ; d'un groupe fluorényle ; d'un groupe hétérocyclique en $C_2$ à $C_{60}$ contenant au moins un hétéroatome parmi O, N, S, Si et P ; d'un groupe cyclique condensé d'un cycle aliphatique en $C_3$ à $C_{60}$ et d'un cycle aromatique en $C_6$ à $C_{60}$,
$L_2$ est choisi parmi le groupe constitué d'un groupe arylène en $C_6$ à $C_{60}$ ; d'un groupe fluorylène ; d'un groupe hétérocyclique divalent en $C_2$ à $C_{60}$ contenant au moins un hétéroatome parmi O, N, S, Si et P ; d'un groupe cyclique condensé divalent d'un cycle aliphatique en $C_3$ à $C_{60}$ et d'un cycle aromatique en $C_6$ à $C_{60}$ ; d'un groupe alkylène en $C_1$ à $C_{50}$ ; d'un groupe alcénylène en $C_2$ à $C_{20}$ ; et d'un groupe alcynylène en $C_2$ à $C_{20}$,
et dans lequel, dans la formule chimique 10,
m, n et $R_1$ à $R_3$ sont identiques à m, n et $R_1$ dans la formule chimique 3,
$L_1$ est choisi parmi le groupe constitué d'un groupe arylène en $C_6$ à $C_{60}$ ; d'un groupe fluorylène ; d'un groupe hétérocyclique divalent en $C_2$ à $C_{60}$ contenant au moins un hétéroatome parmi O, N, S, Si et P ; d'un groupe cyclique condensé divalent d'un cycle aliphatique en $C_3$ à $C_{60}$ et d'un cycle aromatique en $C_6$ à $C_{60}$ ; d'un groupe alkylène en $C_1$ à $C_{50}$ ; d'un groupe alcénylène en $C_2$ à $C_{20}$ ; et d'un groupe alcynylène en $C_2$ à $C_{20}$,
$L_2$ est choisi parmi le groupe constitué d'un groupe aryle en $C_6$ à $C_{60}$ ; d'un groupe fluorényle ; d'un groupe hétérocyclique en $C_2$ à $C_{60}$ contenant au moins un hétéroatome parmi O, N, S, Si et P ; d'un groupe cyclique condensé d'un cycle aliphatique en $C_3$ à $C_{60}$ et d'un cycle aromatique en $C_6$ à $C_{60}$, et
dans lequel dans $R_1$ à $R_3$, $L_1$ et $L_2$ de formule chimique 9 et de formule chimique 10, le groupe aryle, le groupe fluorényle, le groupe hétérocyclique, le groupe cyclique condensé, le groupe alkyle, le groupe alcényle, le groupe alcynyle, le groupe alcoxy, le groupe aryloxy, le groupe alkylsilyle, le groupe arylsilyle, le groupe alkylarylsilyle, le groupe arylène, le groupe fluorylène et le groupe cyclique condensé divalent peuvent en outre être chacun substitués par au moins un substituant choisi parmi le groupe constitué d'un deutérium ; d'un groupe nitro ; d'un groupe cyano ; d'un halogène ; d'un groupe amino ; d'un groupe alcoxyle en $C_1$ à $C_{20}$ ; d'un groupe alkyle en $C_1$ à $C_{20}$ ; d'un groupe alcényle en $C_2$ à $C_{20}$ ; d'un groupe alcynyle en $C_2$ à $C_{20}$ ; d'un groupe aryle en $C_6$ à $C_{20}$ ; d'un groupe aryle en $C_6$ à $C_{20}$ substitué par le deutérium ; d'un groupe fluorényle ; d'un groupe hétérocyclique en $C_2$ à $C_{20}$ ; d'un groupe alkylsilyle en $C_3$ à $C_{60}$ ; d'un groupe arylsilyle en $C_{18}$ à $C_{60}$ ; et d'un groupe alkylarylsilyle en $C_8$ à $C_{60}$,
et dans lequel le troisième composé chimique est un ou plusieurs des composés chimiques suivants :

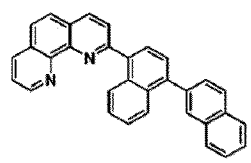

E01

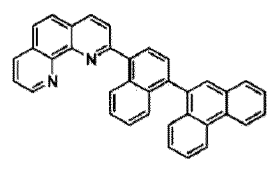

E02

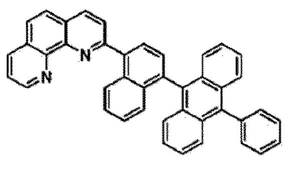

E03

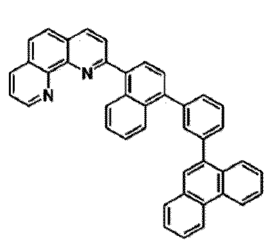

E04

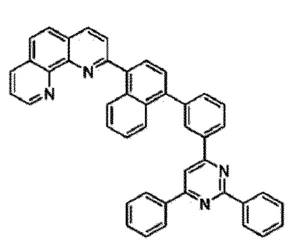

E05

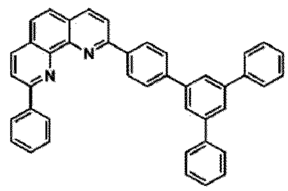

E06

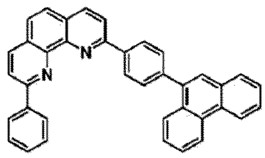

E07

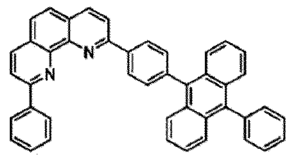

E08

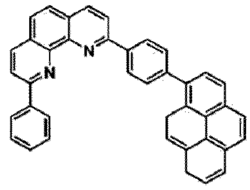

E09

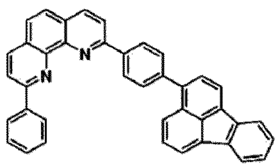

E10

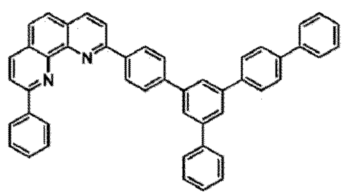

E11

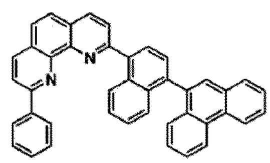

E12

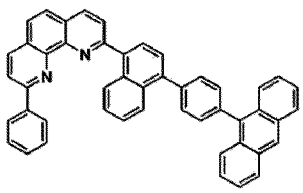

E13

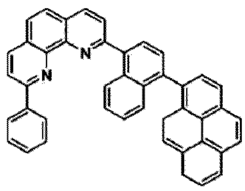

E14

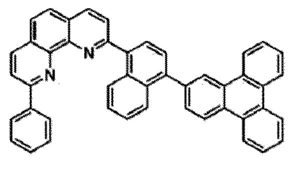

E15

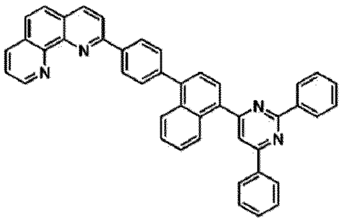

E16

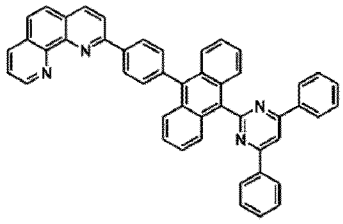

E17

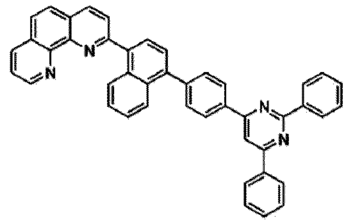

E18

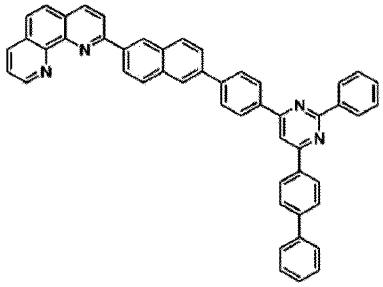
E19

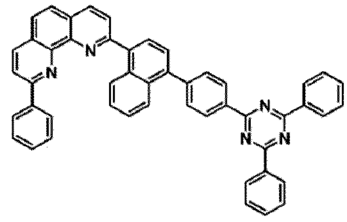
E20

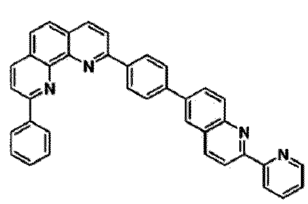
E21

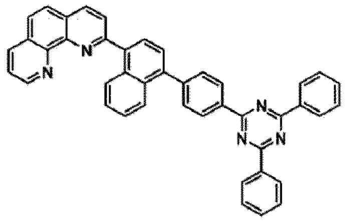
E22

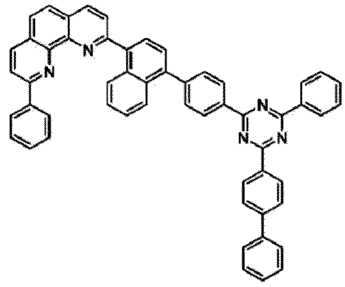
E23

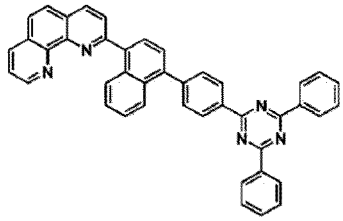
E24

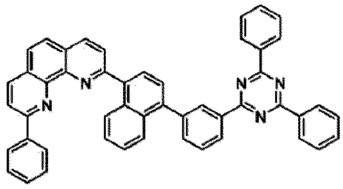
E25

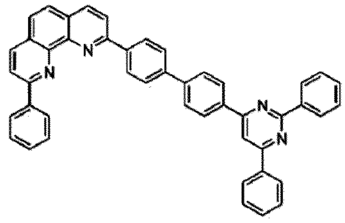
E26

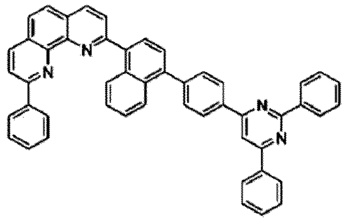
E27

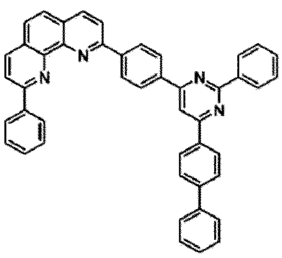
E28

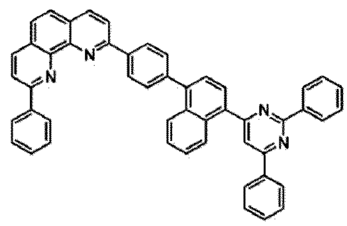
E29

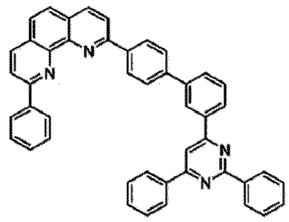
E30

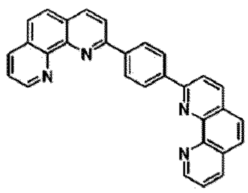
E31

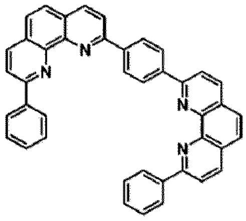
E32

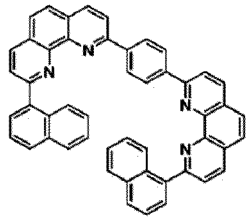
E33

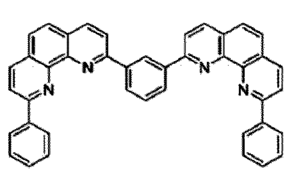

E34

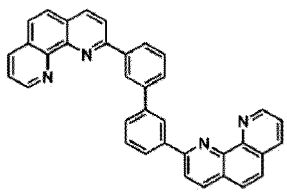

E35

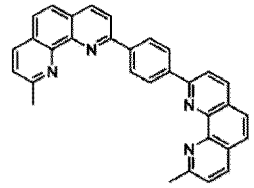

E36

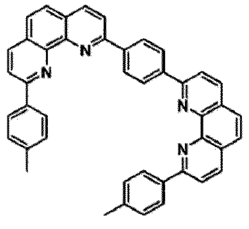

E37

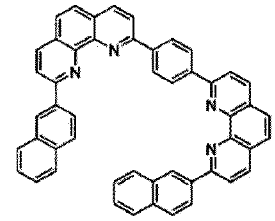

E38

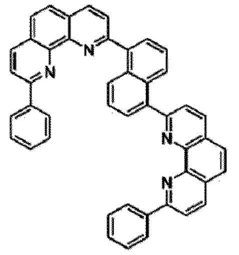

E39

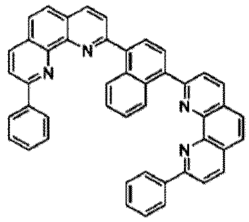

E40

**2.** Élément électrique organique (220, 320) selon la revendication 1, dans lequel le premier composé chimique est représenté par une ou plusieurs des formules chimiques 5 et 6 suivantes :

[Formule chimique 5]

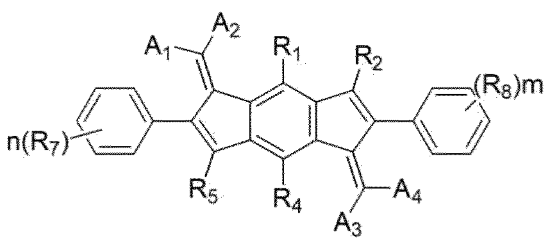

[Formule chimique 6]

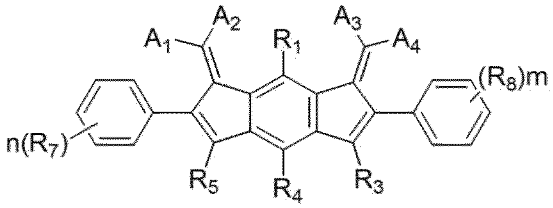

dans lequel, dans la formule chimique 5 et la formule chimique 6,
n et m sont chacun, indépendamment l'un de l'autre, un entier de 0 à 5,
$R_7$ à $R_8$, qui peuvent être identiques ou différents, sont chacun choisis indépendamment l'un de l'autre parmi le groupe constitué d'un deutérium ; d'un tritium ; d'un halogène ; d'un groupe cyano ; d'un groupe alkyle en $C_1$ à $C_{50}$ ; et d'un groupe alcoxy en $C_1$ à $C_{30}$, et
dans lequel, dans $R_7$ et $R_8$ de la formule chimique 5 et de la formule chimique 6, le groupe alkyle et le groupe alcoxy peuvent en outre être substitués chacun par au moins un substituant choisi parmi le groupe constitué d'un deutérium et d'un halogène.

**3.** Élément électrique organique (220, 320) selon la revendication 1, dans lequel le premier composé chimique est représenté par une ou plusieurs des formules chimiques 7 et 8 suivantes :

[Formule chimique 7]

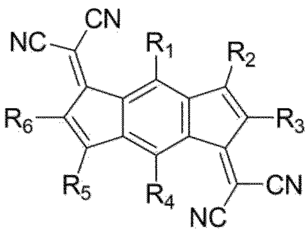

[Formule chimique 8]

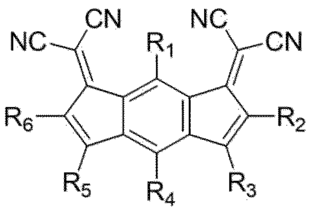

dans lequel, dans la formule chimique 7 et la formule chimique 8,
$R_1$ à $R_6$ sont identiques à $R_1$ à $R_6$ dans les formules chimiques 1 et 2.

**4.** Élément électrique organique (220, 320) selon l'une des revendications précédentes, dans lequel le premier composé chimique est un ou plusieurs des composés chimiques suivants :

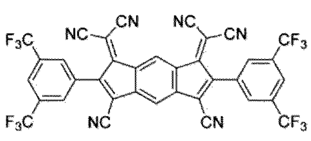

A01

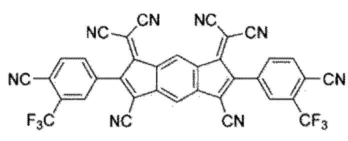

A02

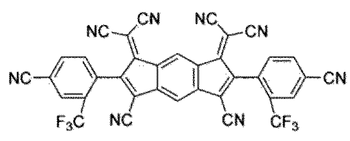

A03

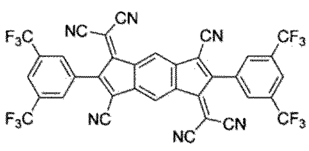

A04

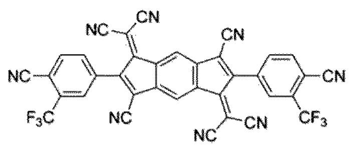

A05

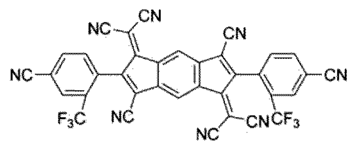

A06

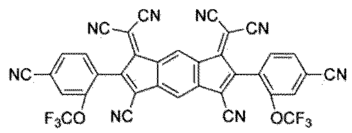

A07

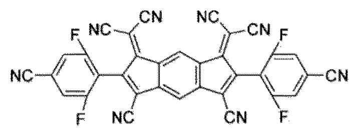

A08

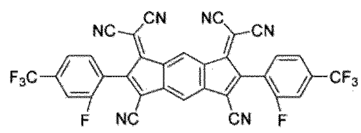

A09

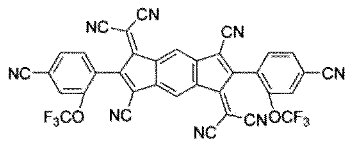

A10

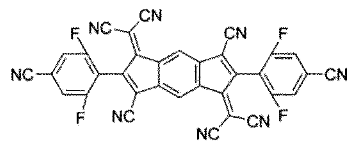

A11

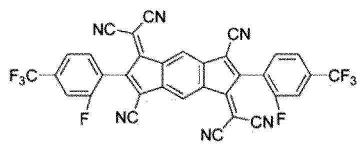

A12

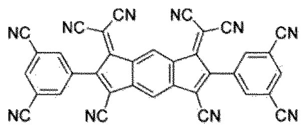

A13

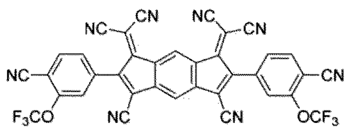

A14

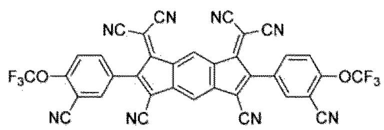

A15

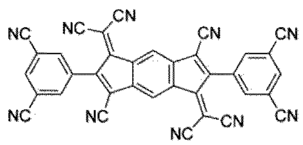

A16

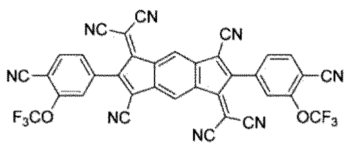

A17

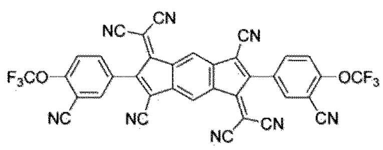

A18

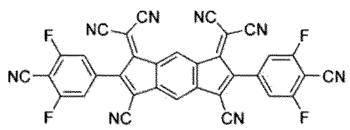

A19

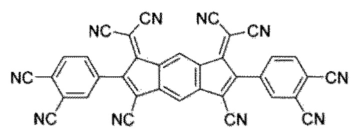

A20

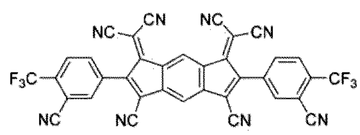

A21

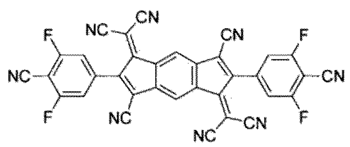

A22

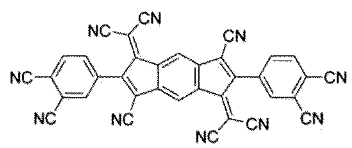

A23

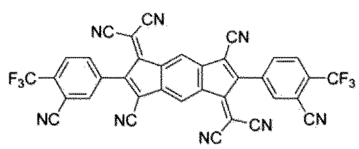

A24

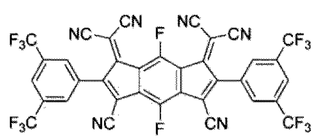

A25

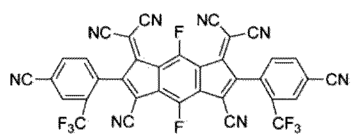

A26

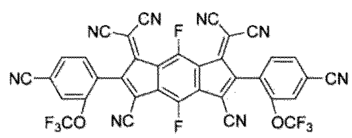

A27

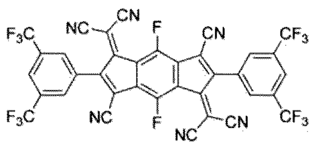
A28

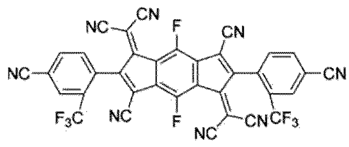
A29

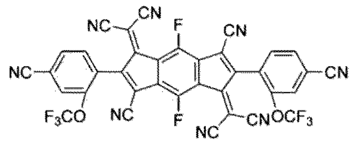
A30

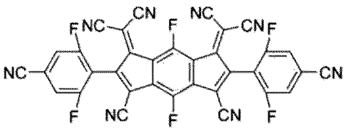
A31

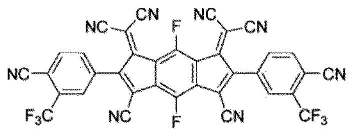
A32

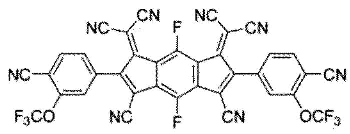
A33

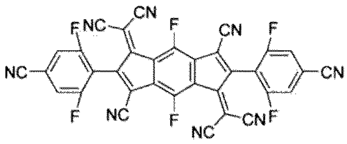
A34

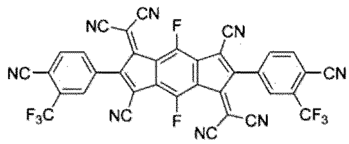
A35

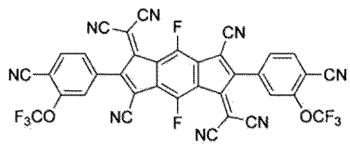
A36

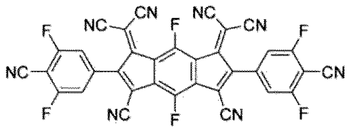
A37

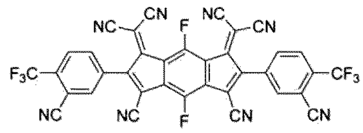
A38

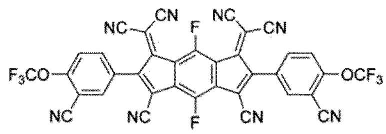
A39

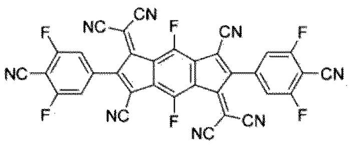
A40

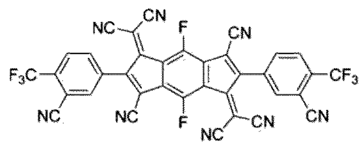
A41

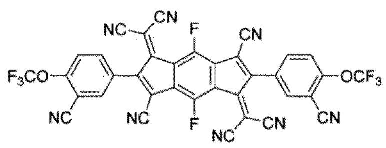
A42

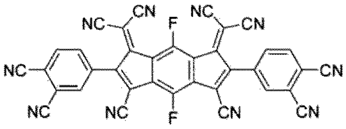
A43

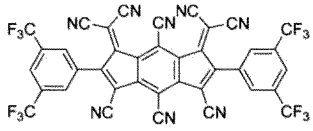
A44

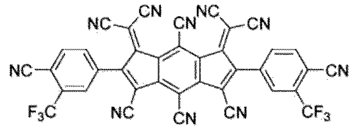
A45

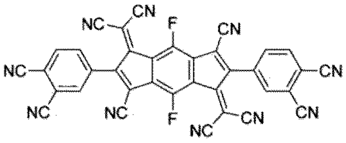
A46

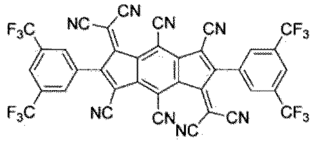
A47

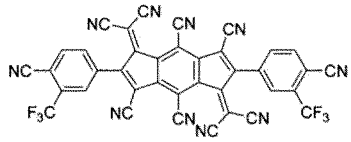
A48

**5.** Élément électrique organique (220, 320) selon l'une des revendications précédentes, dans lequel le deuxième composé chimique est un ou plusieurs des composés chimiques suivants :

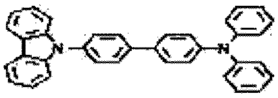

4-1

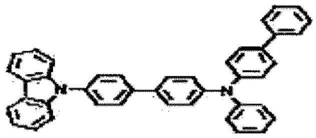

4-2

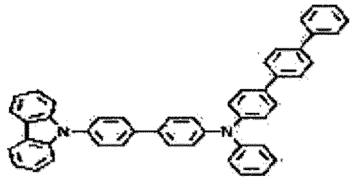

4-3

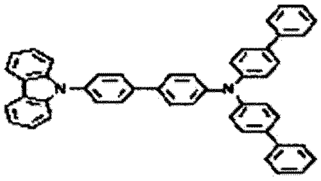

4-4

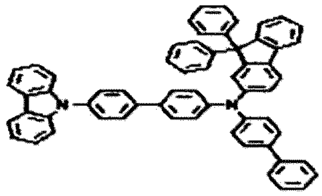

4-5

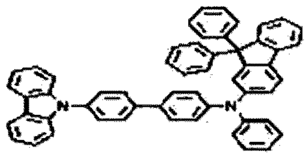

4-6

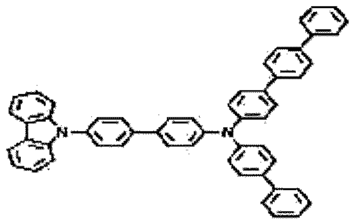

4-7

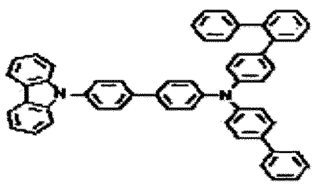

4-8

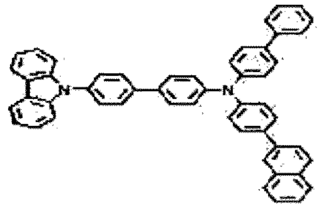

4-9

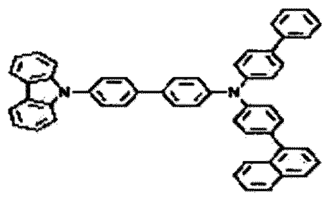

4-10

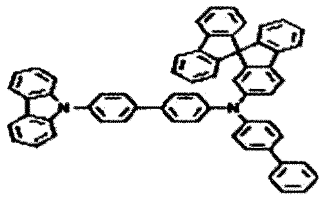

4-11

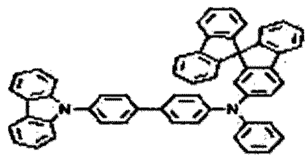

4-12

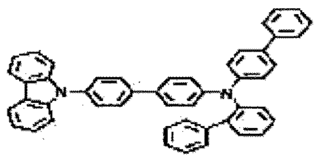

4-13

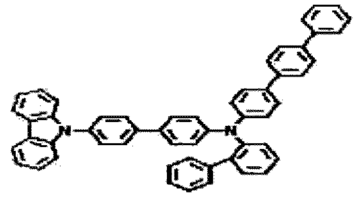

4-14

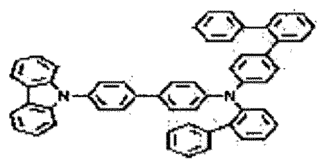

4-15

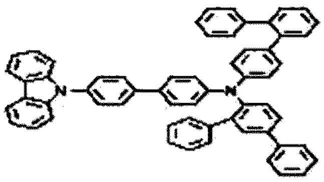

4-16

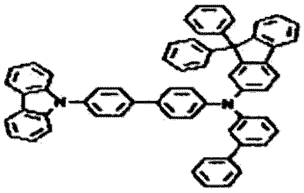

4-17

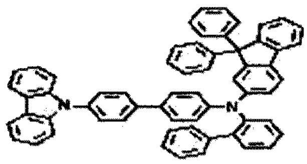

4-18

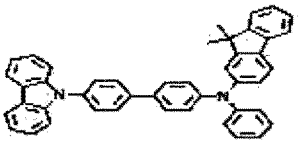
4-19

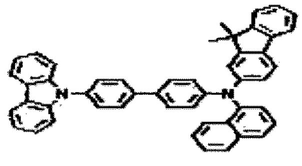
4-20

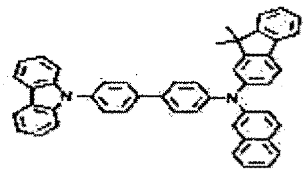
4-21

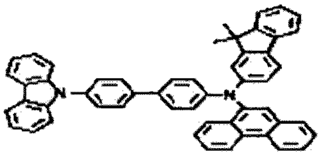
4-22

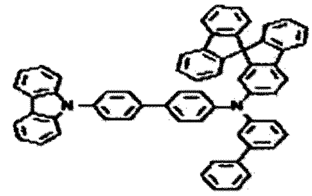
4-23

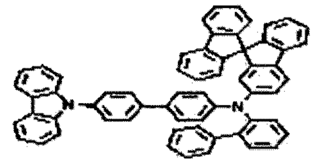
4-24

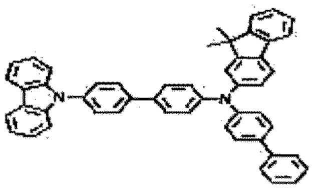
4-25

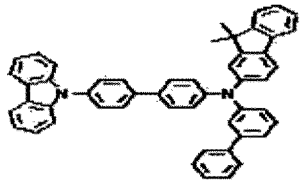
4-26

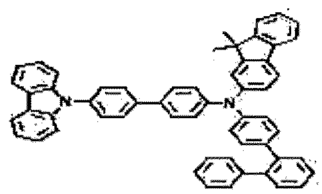
4-27

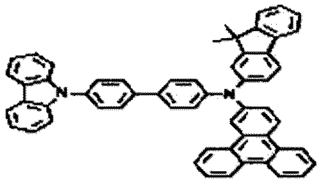
4-28

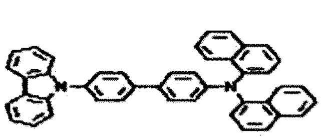
4-29

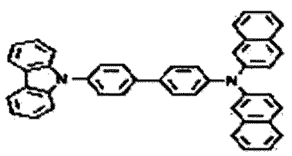
4-30

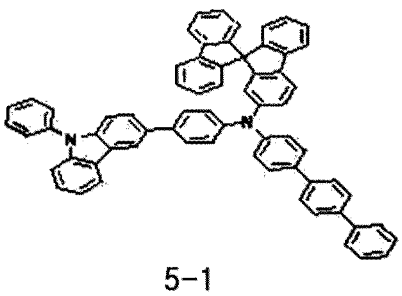
5-1

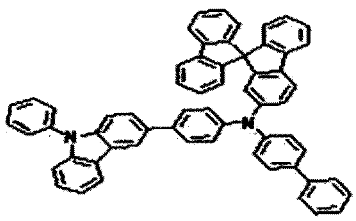
5-2

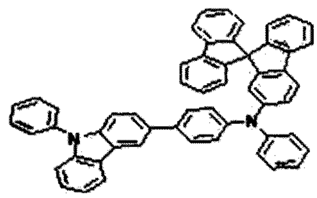
5-3

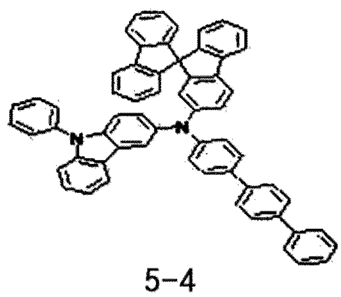
5-4

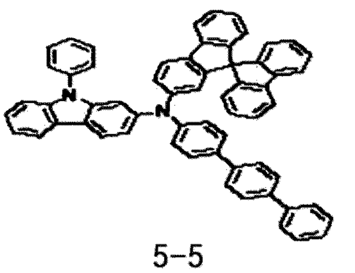
5-5

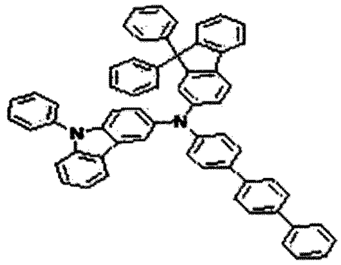
5-6

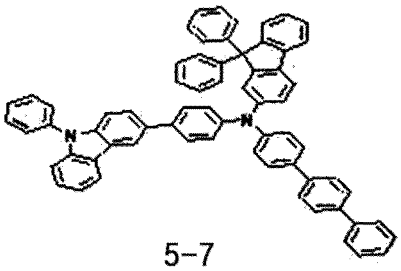

5-7

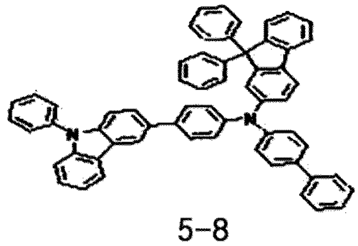

5-8

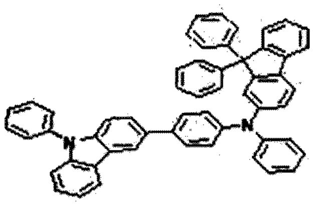

5-9

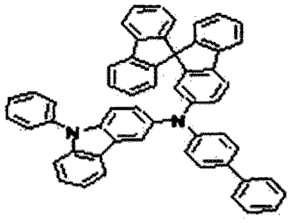

5-10

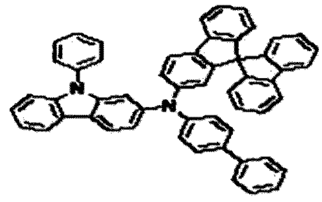

5-11

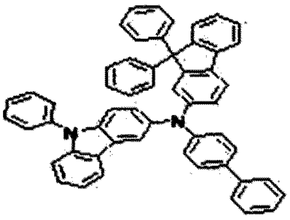

5-12

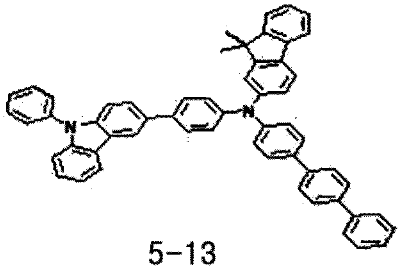

5-13

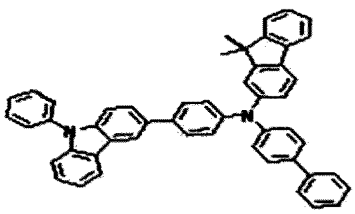

5-14

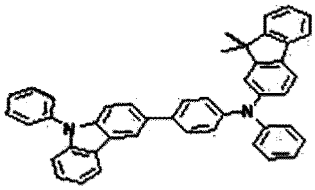

5-15

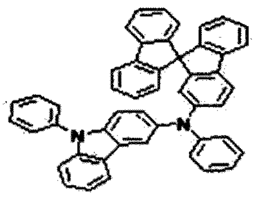

5-16

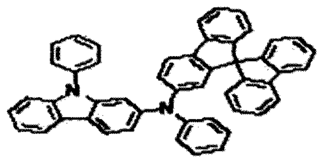

5-17

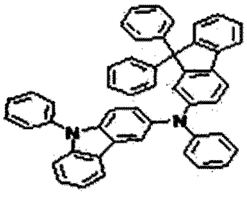

5-18

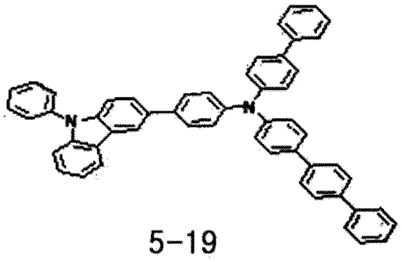

5-19

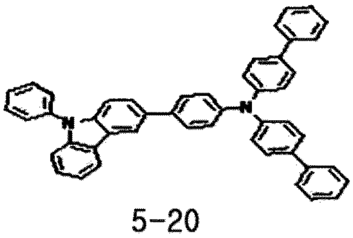

5-20

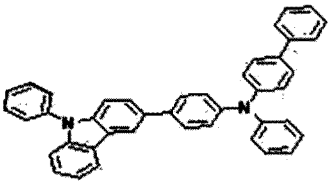

5-21

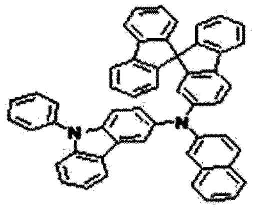

5-22

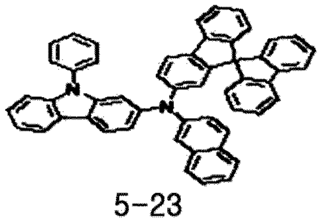

5-23

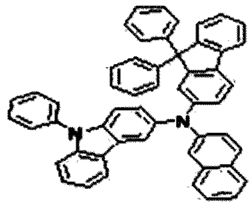

5-24

**6.** Élément électrique organique (220, 320) selon l'une des revendications précédentes, dans lequel la première électrode (221, 321) est une électrode d'anode, la seconde électrode (223, 323) est une électrode de cathode, et la première couche (326a) est positionnée entre la seconde couche (326b) et la seconde électrode (223, 323).

**7.** Élément électrique organique (220, 320) selon l'une des revendications précédentes, comportant en outre une couche d'injection de trous (327) située entre la première électrode (221, 321) et la première couche d'émission de lumière (324a), dans lequel la couche d'injection de trous (327) comporte de préférence un quatrième composé représenté par une ou plusieurs des formules chimiques 1 et 2 et un cinquième composé représenté par la formule chimique 3.

**8.** Élément électrique organique (220, 320) selon l'une des revendications précédentes, dans lequel le quatrième composé est le même composé que le premier composé, et le cinquième composé est le même composé organique que le deuxième composé.

**9.** Élément électrique organique (220, 320) selon l'une des revendications précédentes, dans lequel la formule générale 1 suivante est satisfaite :

[Formule générale 1] $L_3\text{-}L_1 \leq 2{,}1$ eV

dans lequel, dans la formule générale 1,
$L_3$ est le niveau d'énergie LUMO (la plus basse orbitale moléculaire inoccupée) du troisième composé, et
$L_1$ est le niveau d'énergie LUMO du premier composé.

**10.** Élément électrique organique (220, 320) selon l'une des revendications précédentes, dans lequel la formule générale 2 suivante est satisfaite :

[Formule générale 2] $L_3\text{-}H_2 \leq 2{,}8$ eV

dans lequel, dans la formule générale 2,
$L_3$ est le niveau d'énergie LUMO (la plus basse orbitale moléculaire inoccupée) du troisième composé, et
$H_2$ est le niveau d'énergie HOMO (la plus haute orbitale moléculaire occupée) du deuxième composé.

**11.** Élément électrique organique (220, 320) selon l'une des revendications précédentes, dans lequel la formule générale 3 suivante est satisfaite :

[Formule générale 3] $0{,}32\text{eV} \leq L_1\text{-}H_2 \leq 0{,}8$ eV

dans lequel, dans la formule générale 3,
$L_1$ est le niveau d'énergie LUMO (la plus basse orbite moléculaire inoccupée) du premier composé, et
$H_2$ est le niveau d'énergie HOMO (la plus haute orbitale moléculaire occupée) du deuxième composé.

**12.** Panneau d'affichage (110) comportant un sous-pixel (111) comportant l'élément électrique organique (220, 320) de l'une des revendications précédentes.

**13.** Dispositif d'affichage (100) comportant :

le panneau d'affichage (110) de la revendication 12 ; et
un circuit de commande pour commander le panneau d'affichage (110).

FIG. 1

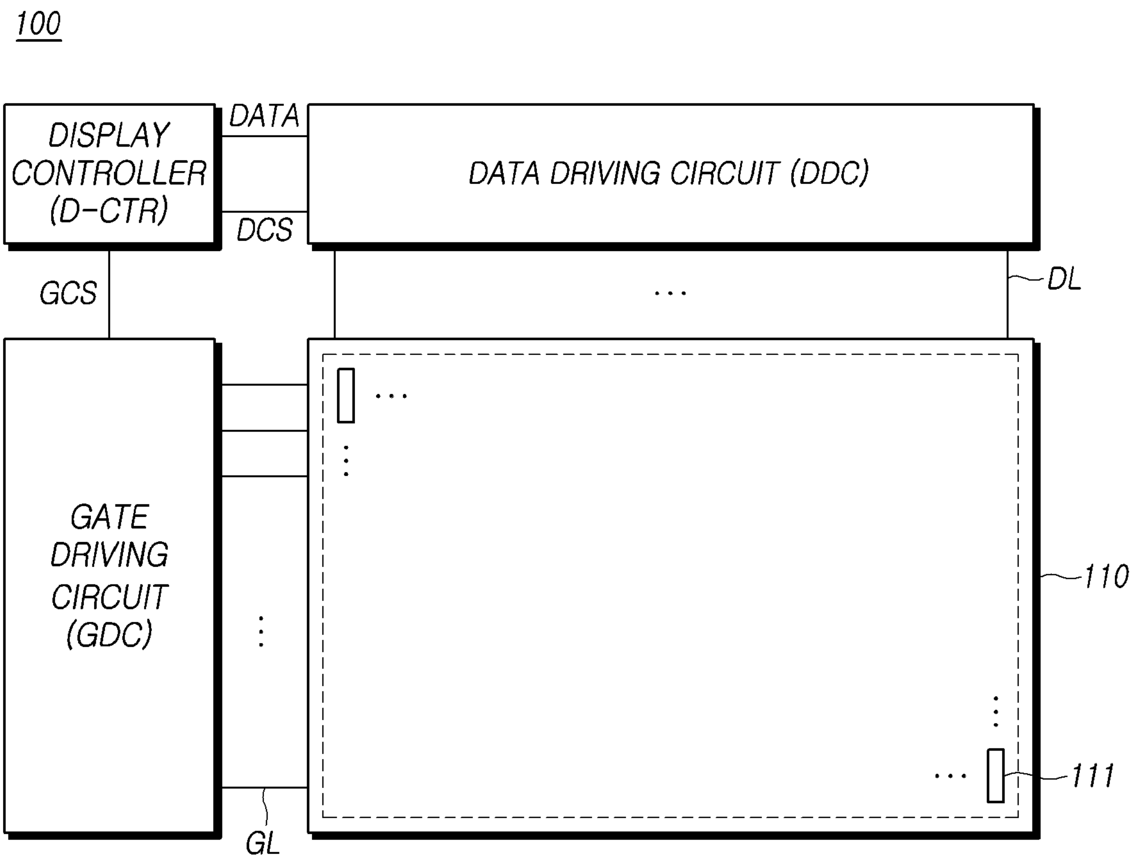
100
DISPLAY CONTROLLER (D-CTR)
DATA
DCS
DATA DRIVING CIRCUIT (DDC)
GCS
DL
GATE DRIVING CIRCUIT (GDC)
110
111
GL

FIG.2

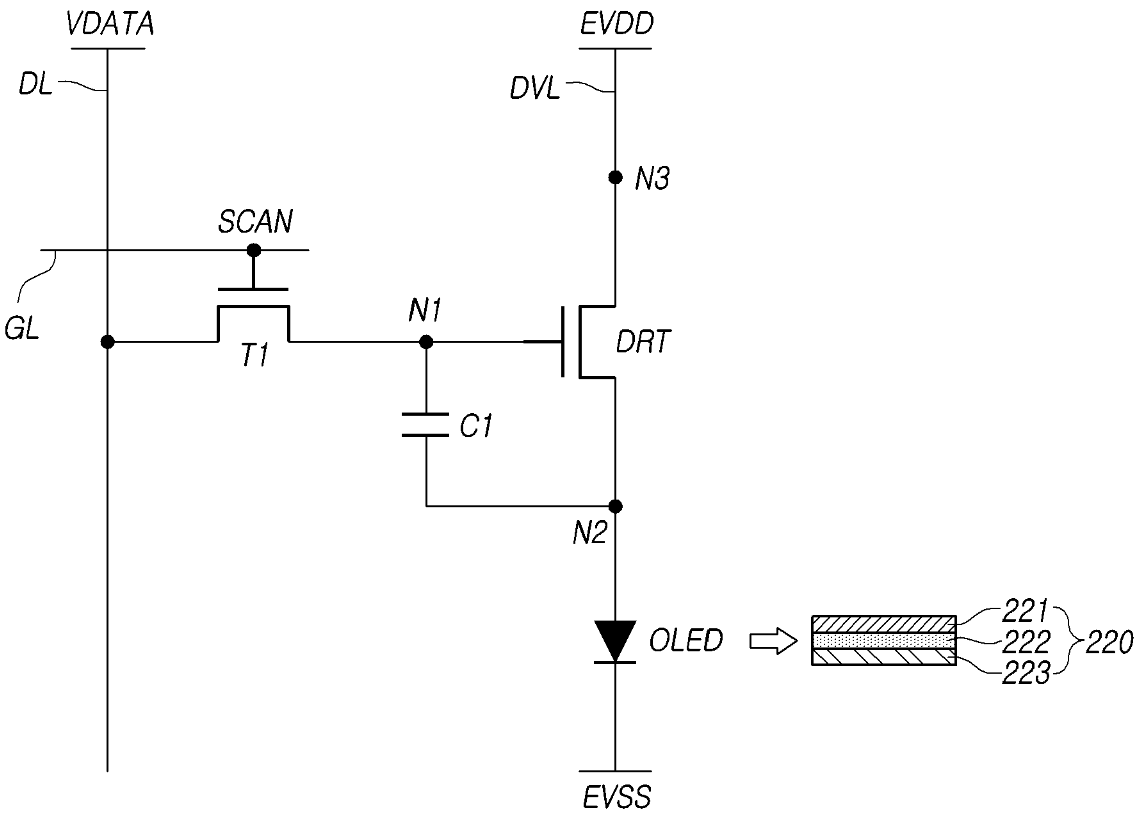
VDATA
DL
EVDD
DVL
N3
SCAN
GL
T1
N1
DRT
C1
N2
OLED
221
222
223
220
EVSS

FIG.3

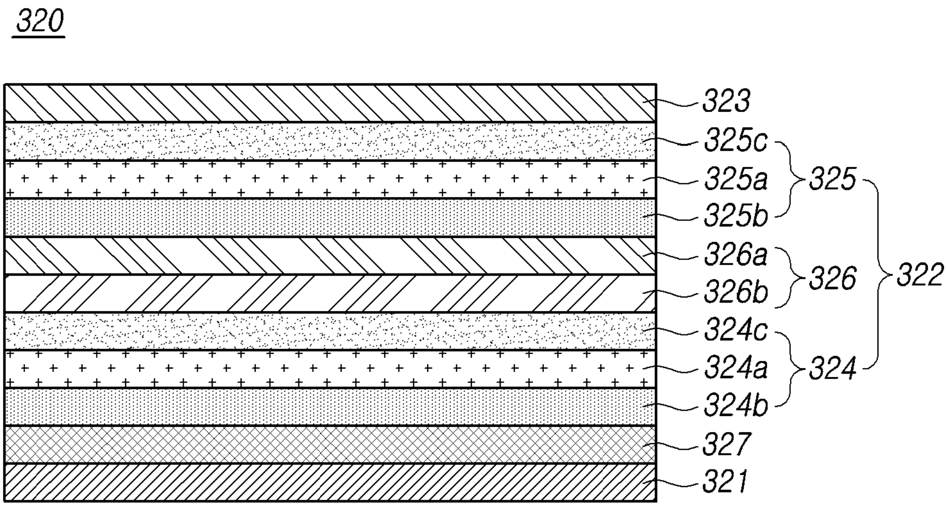
320
323
325c
325a
325b
325
326a
326b
326
322
324c
324a
324b
324
327
321

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 1020190180005
- US 2019207123 A1
- WO 2018221871 A1
- EP 3176844 A1
- EP 3333921 A1